# EUROPEAN PATENT APPLICATION

(11) **EP 4 800 928 A1**
(43) Date of publication of application: **02.09.2026**
(21) Application number: 24890510.1
(22) Date of filing: 31.10.2024
(51) Int. Cl.: H03M 13/13

(54) **CODING METHOD, DECODING METHOD AND APPARATUS**

(30) Priority: 15.11.2023 CN 202311535065
(71) Applicant: Huawei Technologies Co., Ltd., Shenzhen, Guangdong 518129 (CN)
(72) Inventor: QIN, Kangjian, Shenzhen, Guangdong 518129 (CN); ZHANG, Huazi, Shenzhen, Guangdong 518129 (CN); TONG, Jiajie, Shenzhen, Guangdong 518129 (CN); WANG, Xianbin, Shenzhen, Guangdong 518129 (CN); LIU, Ke, Shenzhen, Guangdong 518129 (CN); WANG, Jun, Shenzhen, Guangdong 518129 (CN)
(74) Representative: Maiwald GmbH
(86) International application number: PCT/CN2024/129050
(87) International publication number: WO 2025/103153

(57) **Abstract**

This application provides an encoding method, a decoding method, and an apparatus. The method includes: obtaining a first sequence, where the first sequence is a to-be-encoded bit sequence, and a length of the first sequence is K; determining, based on K, a mother code sequence corresponding to the first sequence; and performing polar encoding on a parity check bit and the first sequence based on the mother code sequence, where the parity check bit includes a first parity check bit and a second parity check bit. The parity check bit is determined in the following manner: determining, based on a first correspondence, a number formula (I) of first parity check bits corresponding to the first sequence, where the first correspondence includes a correspondence between K and the first parity check bit; determining, based on reliability and a row weight, formula (II) positions in the mother code sequence for placing the first sequence and the first parity check bits; determining a position for the second parity check bit in the mother code sequence; and determining the parity check bit based on the formula (III) positions, the position for the second parity check bit, a target parity check PC equation, and the first sequence.

## Description

### CROSS-REFERENCE TO RELATED APPLICATIONS

This application claims priority to Chinese Patent Application No. 202311535065.1, filed with the China National Intellectual Property Administration on November 15, 2023 and entitled "ENCODING METHOD, DECODING METHOD, AND APPARATUS", which is incorporated herein by reference in its entirety.

### TECHNICAL FIELD

This application relates to the field of wireless communication technologies, and in particular, to an encoding method, a decoding method, and an apparatus.

### BACKGROUND

Communication systems typically employ channel encoding to improve data transmission reliability and ensure communication quality. A transmitting device transmits a channel encoded signal to a receiving device over a channel. The receiving device performs corresponding channel decoding on the received signal to restore an original signal.

Polar codes (Polar Codes) are adopted as a control channel encoding method in 5th generation (5th generation, 5G) standards. Polar codes are an existing channel encoding scheme that can be rigorously proven to "achieve" the channel capacity, offering advantages of high performance and low complexity. Therefore, the polar codes have significant potential for development and application in the communication field by virtue of these advantages. However, with the rapid evolution of wireless communication systems (for example, new radio (new radio, NR) systems), these communication scenarios impose higher requirements on performance of polar codes.

### SUMMARY

This application provides an encoding method, a decoding method, and an apparatus, to provide a polar encoding and decoding scheme, to improve performance of polar codes.

According to a first aspect, an embodiment of this application provides an encoding method. The method may be performed by a first communication apparatus or a module (such as a chip, a chip system, or a circuit) used in the first communication apparatus. An example in which the first communication apparatus performs the method is used. The method includes: obtaining a first sequence, where the first sequence is a to-be-encoded bit sequence, and a length of the first sequence is K; determining, based on K, a mother code sequence corresponding to the first sequence; and performing polar encoding on a parity check bit and the first sequence based on the mother code sequence, where the parity check bit includes a first parity check bit and a second parity check bit. The parity check bit is determined in the following manner: determining, based on a first correspondence, a number ${n}_{PC}^{wm}$ of first parity check bits corresponding to the first sequence, where the first correspondence includes a correspondence between K and the first parity check bit; determining, based on reliability and a row weight, ( $K + {n}_{PC}^{wm}$) positions in the mother code sequence for placing the first sequence and the first parity check bits; determining a position for the second parity check bit in the mother code sequence; and determining the parity check bit based on the ( $K + {n}_{PC}^{wm}$) positions, the position for the second parity check bit, a target parity check PC equation, and the first sequence.

According to the foregoing method, when determining the parity check bit, the first communication apparatus may determine the number of first parity check bits based on the first correspondence, determine, from the mother code sequence, the ( $K + {n}_{PC}^{wm}$) positions for placing the first sequence and the first parity check bits, and determine the position for the second parity check bit in the mother code sequence, so that a parity check bit with a corresponding length can be flexibly generated, to improve polar code-based communication performance. In addition, the first communication apparatus determines the positions for an information bit in the first sequence and the first parity check bits from the mother code sequence based on the reliability and the row weight, so that a code spectrum can be further improved, and error correction performance can be improved.

In a possible design, the method further includes: The first communication apparatus determines the target PC equation based on a second correspondence, where the second correspondence includes a correspondence between K and an indication parameter of the target PC equation. According to the foregoing method, the first communication apparatus can flexibly generate the target PC equation corresponding to the length of the to-be-encoded bit sequence.

In a possible design, the first correspondence further includes a correspondence between a target transmission code length E and the first parity check bit, and E is a transmission code length after rate matching of an encoded sequence; and the second correspondence further includes a correspondence between E and the indication parameter of the target PC equation. According to the foregoing method, the first communication apparatus can flexibly generate the number of first parity check bits corresponding to the length of the to-be-encoded bit sequence and the transmission code length, and flexibly generate the target PC equation corresponding to the length of the to-be-encoded bit sequence and the transmission code length.

In a possible design, the number of first parity check bits corresponding to K and E is less than or equal to E-K, and/or a number of effective parity check bits corresponding to K and E is less than or equal to a specified threshold.

In a possible design, the first correspondence includes a correspondence among a plurality of message lengths, a plurality of transmission code lengths, and a number of first parity check bits, the plurality of message lengths include K, and the plurality of transmission code lengths include E. According to the foregoing method, the first communication apparatus can flexibly determine, from the first correspondence including the plurality of message lengths, the plurality of transmission code lengths, and the number of first parity check bits, the number of first parity check bits corresponding to the length of the to-be-encoded bit sequence and the transmission code length.

In a possible design, the second correspondence includes a correspondence among a plurality of message lengths, a plurality of transmission code lengths, and an indication parameter of a PC equation, the plurality of message lengths include K, and the plurality of transmission code lengths include E. According to the foregoing method, the first communication apparatus can flexibly determine, from the first correspondence including the plurality of message lengths, the plurality of transmission code lengths, and the indication parameter of the PC equation, the indication parameter of the target PC equation corresponding to the length of the to-be-encoded bit sequence and the transmission code length.

In a possible design, in the first correspondence, for a message length within a first length range, same message lengths correspond to a same number of first parity check bits; and in the second correspondence, for a message length within a first length range, same message lengths correspond to a same indication parameter of a PC equation. According to the foregoing method, because there are the same number of first parity check bits and the same indication parameter of the PC equation in the first correspondence and the second correspondence, a data volume for storing the first correspondence and the second correspondence can be reduced, and complexity of describing the first correspondence and the second correspondence can be reduced.

In a possible design, in the first correspondence, different message lengths within the first length range correspond to different numbers of first parity check bits; and/or in the second correspondence, different message lengths within the first length range correspond to different indication parameters of PC equations.

In a possible design, in the first correspondence, all message lengths within the first length range correspond to a same number of first parity check bits; and in the second correspondence, all message lengths within the first length range correspond to a same indication parameter of a PC equation.

In a possible design, in the first correspondence, for a message length within a second length range, when message lengths are the same and transmission code lengths are within different code length ranges, corresponding numbers of first parity check bits are different; and/or in the second correspondence, for a message length within a second length range, when message lengths are the same and transmission code lengths are within different code length ranges, corresponding indication parameters of PC equations are different.

In a possible design, in the first correspondence, for a message length within a second length range, when message lengths are the same and transmission code lengths are within a same code length range, corresponding numbers of first parity check bits are the same; and in the second correspondence, for a message length within a second length range, when message lengths are the same and transmission code lengths are within a same code length range, corresponding indication parameters of PC equations are the same.

According to the foregoing plurality of different designs, a correspondence among a message length, a transmission code length, and a number of first parity check bits, and a correspondence among a message length, a transmission code length, and an indication parameter of a PC equation can be flexibly configured, and therefore can be applied to different scenarios. A first correspondence and a second correspondence that correspond to each other can be configured in different scenarios.

In a possible design, a first threshold value of the first length range is 3, and a second threshold value of the first length range is 6.

In a possible design, a first threshold value of the second length range is 7, and a second threshold value of the first length range is 11.

In a possible design, the first communication apparatus determines, based on K, E, and a third correspondence, the specified threshold corresponding to the number of effective parity check bits, where the third correspondence includes a correspondence among K, E, and the specified threshold corresponding to the number of effective parity check bits.

In a possible design, the first correspondence includes at least one correspondence in the following table, and each correspondence is a correspondence among one k, one e, and one number of first parity check bits,

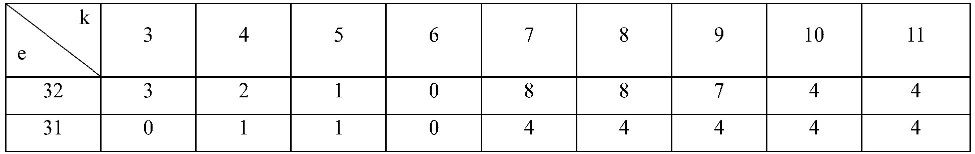

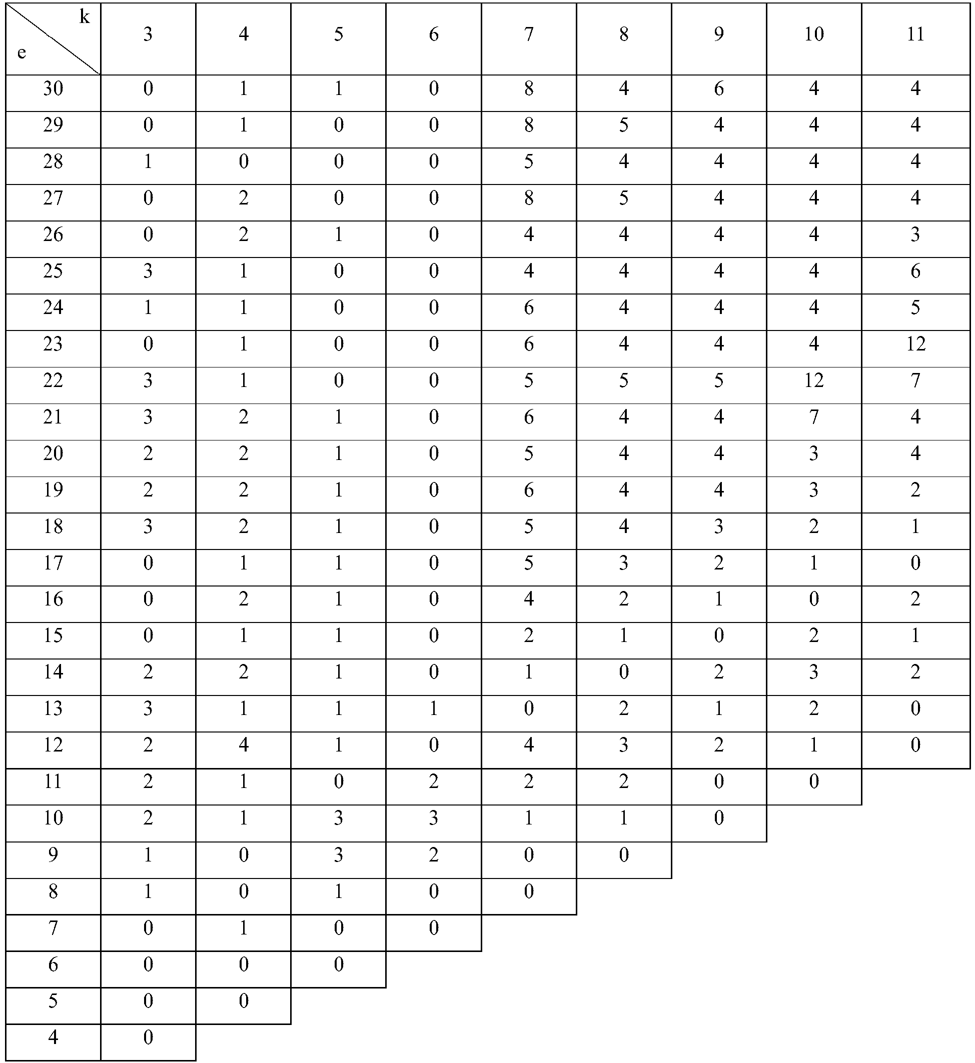

where k represents a message length, and e represents a transmission code length.

In a possible design, the second correspondence includes at least one correspondence in the following table, and each correspondence is a correspondence among one k, one e, and one indication parameter of a PC equation,

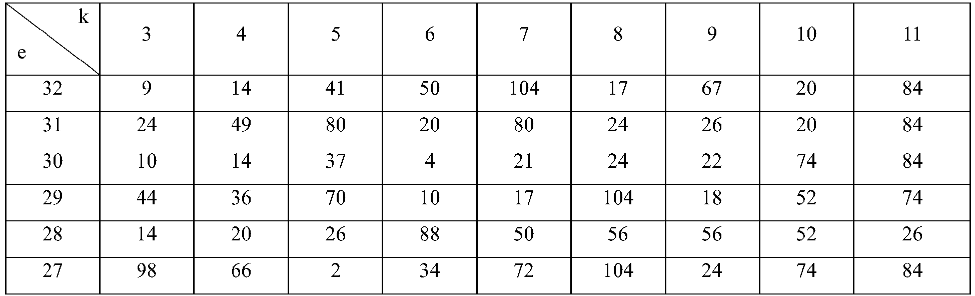

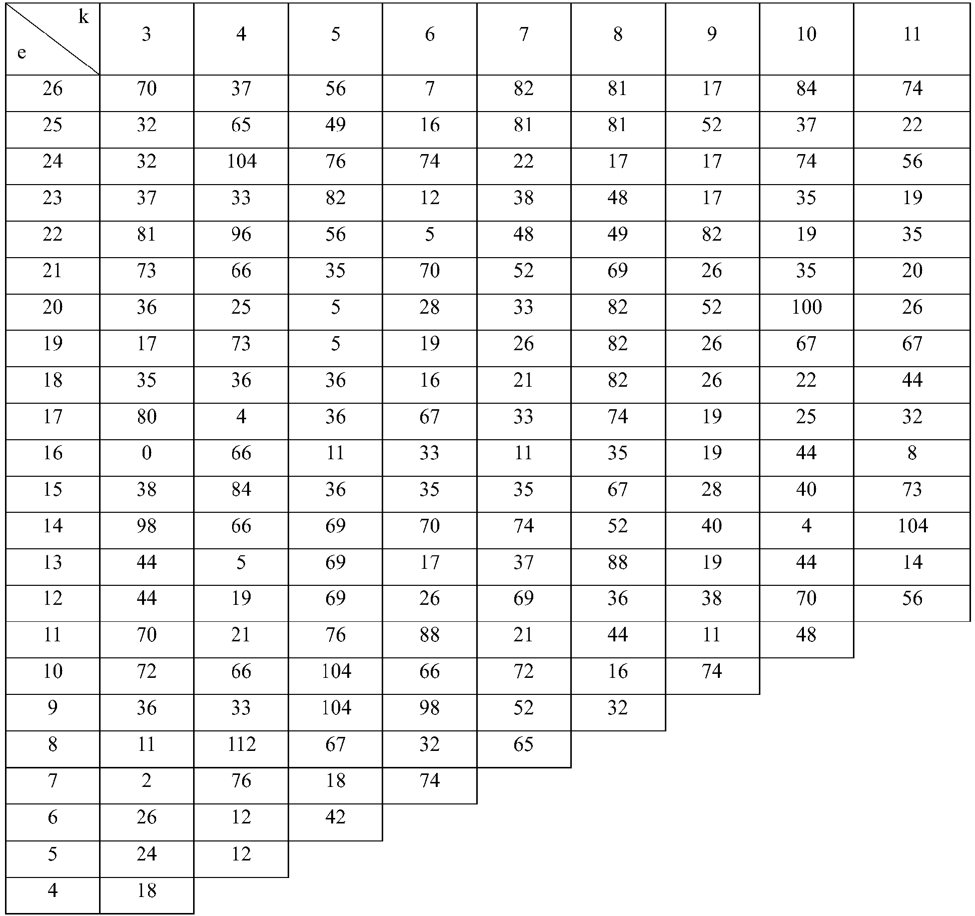

where k represents the message length, and e represents the transmission code length.

In a possible design, the first correspondence includes at least one correspondence in the following table, and each correspondence is a correspondence among one k, one e, and one number of first parity check bits,

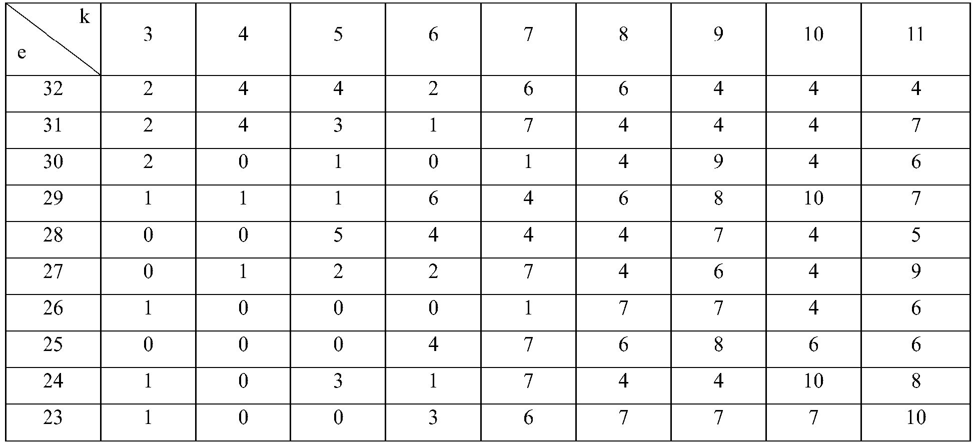

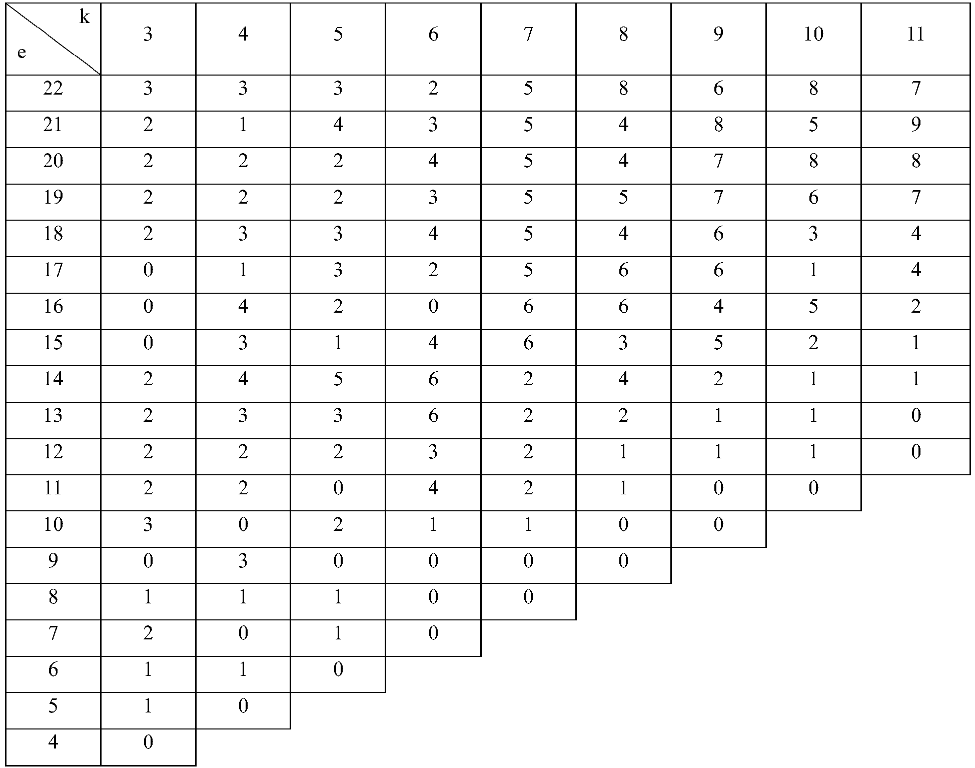

where k represents a message length, and e represents a transmission code length.

In a possible design, the second correspondence includes at least one correspondence in the following table, and each correspondence is a correspondence among one k, one e, and one number of first parity check bits,

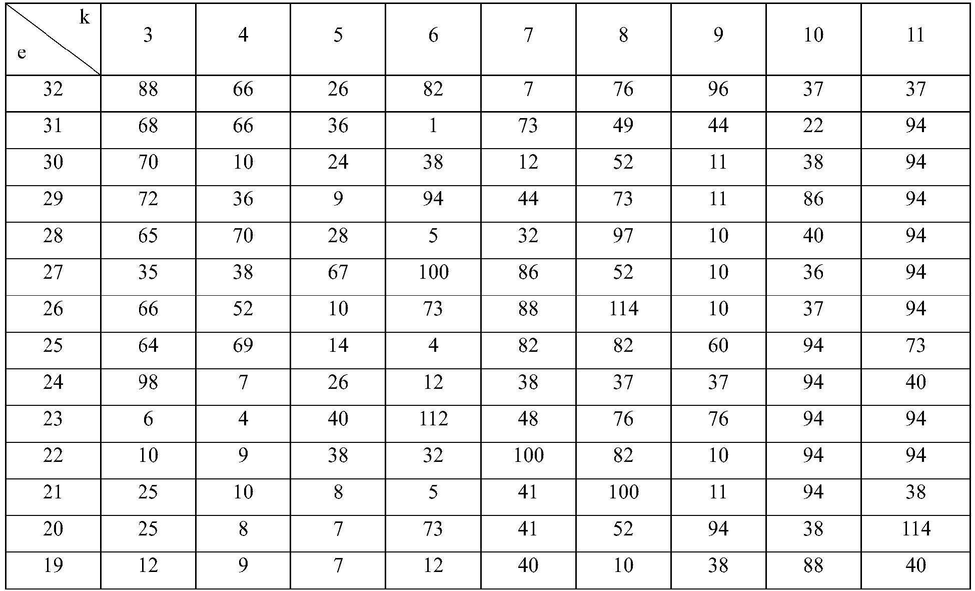

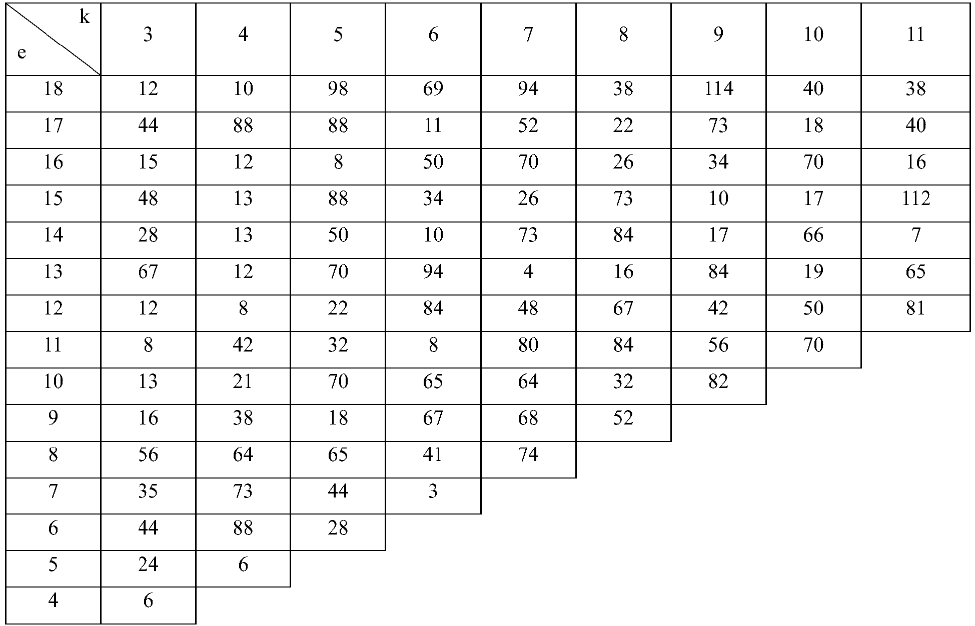

where k represents the message length, and e represents the transmission code length.

In a possible design, the third correspondence includes at least one correspondence in the following table, and each correspondence is a correspondence among one k, one e, and one specified threshold corresponding to a number of effective parity check bits,

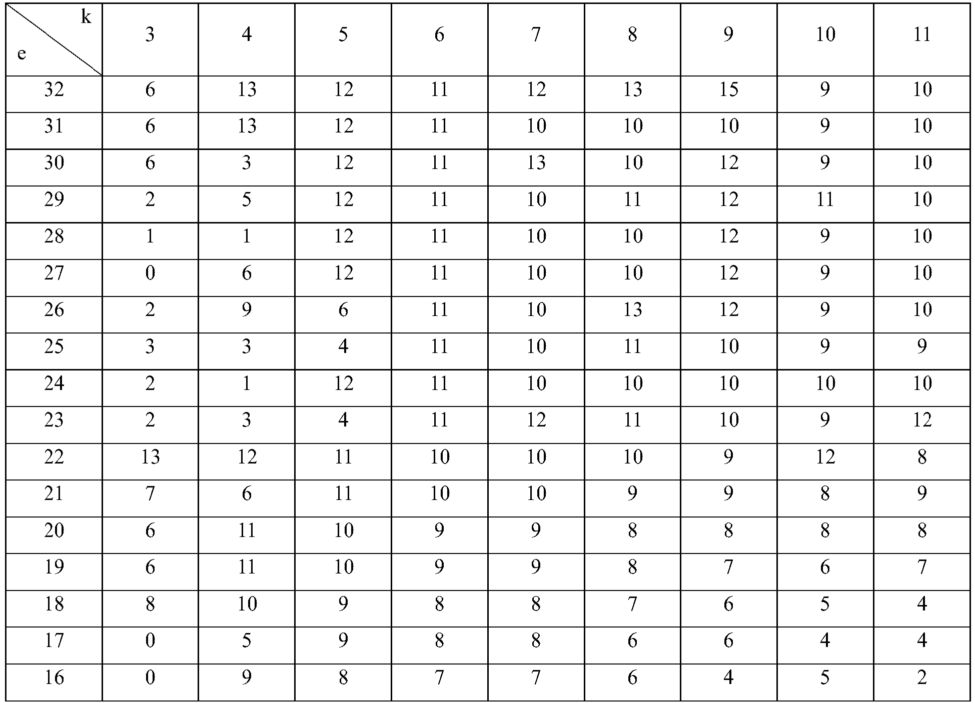

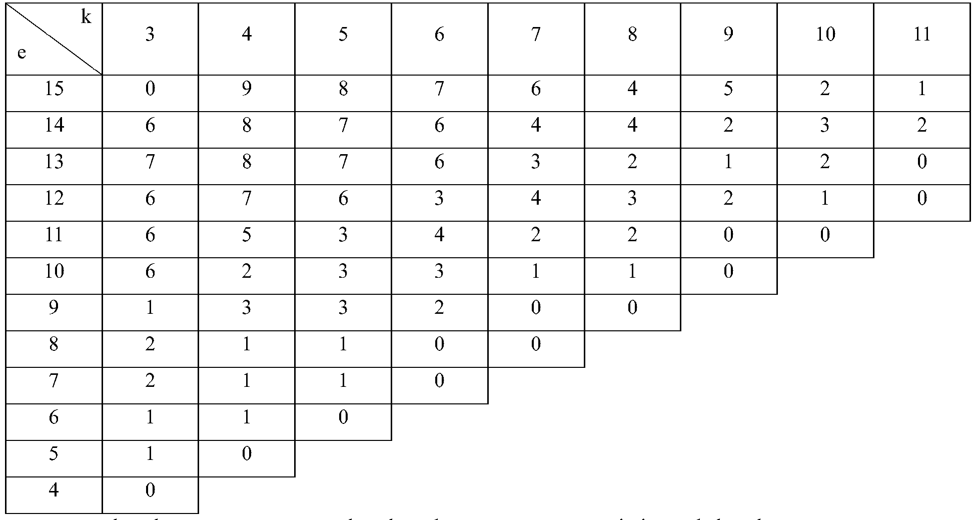

where k represents a message length, and e represents a transmission code length.

In a possible design, the third correspondence includes at least one correspondence in the following table, and each correspondence is a correspondence among one k, one e, and one specified threshold corresponding to a number of effective parity check bits,

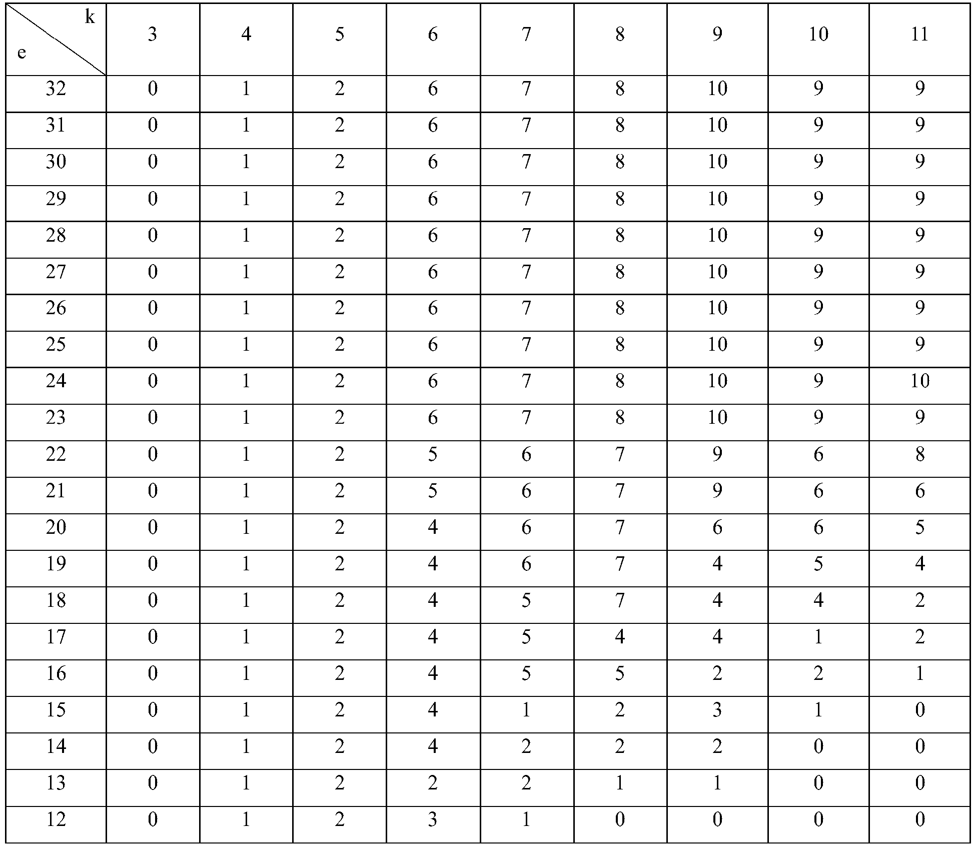

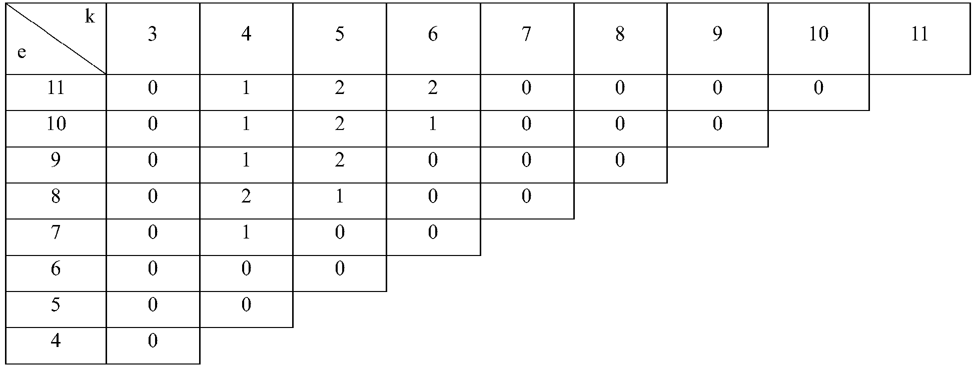

where k represents a message length, and e represents a transmission code length.

According to a second aspect, an embodiment of this application provides a decoding method. The method may be performed by a second communication apparatus or a module (such as a chip, a chip system, or a circuit) used in the second communication apparatus. An example in which the second communication apparatus performs the method is used. The method includes: obtaining a second sequence, where the second sequence is a to-be-decoded sequence, and obtaining a length K of a first sequence; determining, based on K, a mother code sequence corresponding to the first sequence; determining, based on a first correspondence, a number ${n}_{PC}^{wm}$ of first parity check bits corresponding to the first sequence, where the first correspondence includes a correspondence between K and the first parity check bit; determining ( $K + {n}_{PC}^{wm}$) positions in the mother code sequence based on reliability and a row weight, where the ( $K + {n}_{PC}^{wm}$) positions are for placing the first sequence and the first parity check bits; determining a position for a second parity check bit in the mother code sequence; and decoding the second sequence based on the ( $K + {n}_{PC}^{wm}$) positions, the position for the second parity check bit, and a target parity check PC equation, to obtain a parity check bit and an information bit in the first sequence, where the parity check bit includes the first parity check bit and the second parity check bit.

According to the foregoing method, when determining the parity check bit, the second communication apparatus may determine the number of first parity check bits based on the first correspondence, determine, from the mother code sequence, the ( $K + {n}_{PC}^{wm}$) positions for placing the first sequence and the first parity check bits, and determine the position for the second parity check bit in the mother code sequence, so that a parity check bit with a corresponding length can be flexibly generated, to improve polar code-based communication performance. In addition, the second communication apparatus determines the positions for the information bit in the first sequence and the first parity check bits from the mother code sequence based on the reliability and the row weight, so that a code spectrum can be further improved, and error correction performance can be improved.

In a possible design, the method further includes: The first communication apparatus determines the target PC equation based on a second correspondence, where the second correspondence includes a correspondence between K and an indication parameter of the target PC equation. According to the foregoing method, the first communication apparatus can flexibly generate the target PC equation corresponding to the length of the to-be-encoded bit sequence.

In a possible design, the first correspondence further includes a correspondence between a target transmission code length E and the first parity check bit, and E is a transmission code length after rate matching of an encoded sequence; and the second correspondence further includes a correspondence between E and the indication parameter of the target PC equation. According to the foregoing method, the first communication apparatus can flexibly generate the number of first parity check bits corresponding to the length of the to-be-encoded bit sequence and the transmission code length, and flexibly generate the target PC equation corresponding to the length of the to-be-encoded bit sequence and the transmission code length.

In a possible design, the number of first parity check bits corresponding to K and E is less than or equal to E-K, and/or a number of effective parity check bits corresponding to K and E is less than or equal to a specified threshold.

In a possible design, the first correspondence includes a correspondence among a plurality of message lengths, a plurality of transmission code lengths, and a number of first parity check bits, the plurality of message lengths include K, and the plurality of transmission code lengths include E. According to the foregoing method, the first communication apparatus can flexibly determine, from the first correspondence including the plurality of message lengths, the plurality of transmission code lengths, and the number of first parity check bits, the number of first parity check bits corresponding to the length of the to-be-encoded bit sequence and the transmission code length.

In a possible design, the second correspondence includes a correspondence among a plurality of message lengths, a plurality of transmission code lengths, and an indication parameter of a PC equation, the plurality of message lengths include K, and the plurality of transmission code lengths include E. According to the foregoing method, the first communication apparatus can flexibly determine, from the first correspondence including the plurality of message lengths, the plurality of transmission code lengths, and the indication parameter of the PC equation, the indication parameter of the target PC equation corresponding to the length of the to-be-encoded bit sequence and the transmission code length.

In a possible design, in the first correspondence, for a message length within a first length range, same message lengths correspond to a same number of first parity check bits; and in the second correspondence, for a message length within a first length range, same message lengths correspond to a same indication parameter of a PC equation. According to the foregoing method, because there are the same number of first parity check bits and the same indication parameter of the PC equation in the first correspondence and the second correspondence, a data volume for storing the first correspondence and the second correspondence can be reduced, and complexity of describing the first correspondence and the second correspondence can be reduced.

In a possible design, in the first correspondence, different message lengths within the first length range correspond to different numbers of first parity check bits; and/or in the second correspondence, different message lengths within the first length range correspond to different indication parameters of PC equations.

In a possible design, in the first correspondence, all message lengths within the first length range correspond to a same number of first parity check bits; and in the second correspondence, all message lengths within the first length range correspond to a same indication parameter of a PC equation.

In a possible design, in the first correspondence, for a message length within a second length range, when message lengths are the same and transmission code lengths are within different code length ranges, corresponding numbers of first parity check bits are different; and/or in the second correspondence, for a message length within a second length range, when message lengths are the same and transmission code lengths are within different code length ranges, corresponding indication parameters of PC equations are different.

In a possible design, in the first correspondence, for a message length within a second length range, when message lengths are the same and transmission code lengths are within a same code length range, corresponding numbers of first parity check bits are the same; and in the second correspondence, for a message length within a second length range, when message lengths are the same and transmission code lengths are within a same code length range, corresponding indication parameters of PC equations are the same.

According to the foregoing plurality of different designs, a correspondence among a message length, a transmission code length, and a number of first parity check bits, and a correspondence among a message length, a transmission code length, and an indication parameter of a PC equation can be flexibly configured, and therefore can be applied to different scenarios. A first correspondence and a second correspondence that correspond to each other can be configured in different scenarios.

In a possible design, a first threshold value of the first length range is 3, and a second threshold value of the first length range is 6.

In a possible design, a first threshold value of the second length range is 7, and a second threshold value of the first length range is 11.

In a possible design, the first communication apparatus determines, based on K, E, and a third correspondence, the specified threshold corresponding to the number of effective parity check bits, where the third correspondence includes a correspondence among K, E, and the specified threshold corresponding to the number of effective parity check bits.

In a possible design, the first correspondence includes at least one correspondence in the following table, and each correspondence is a correspondence among one k, one e, and one indication parameter of a PC equation,

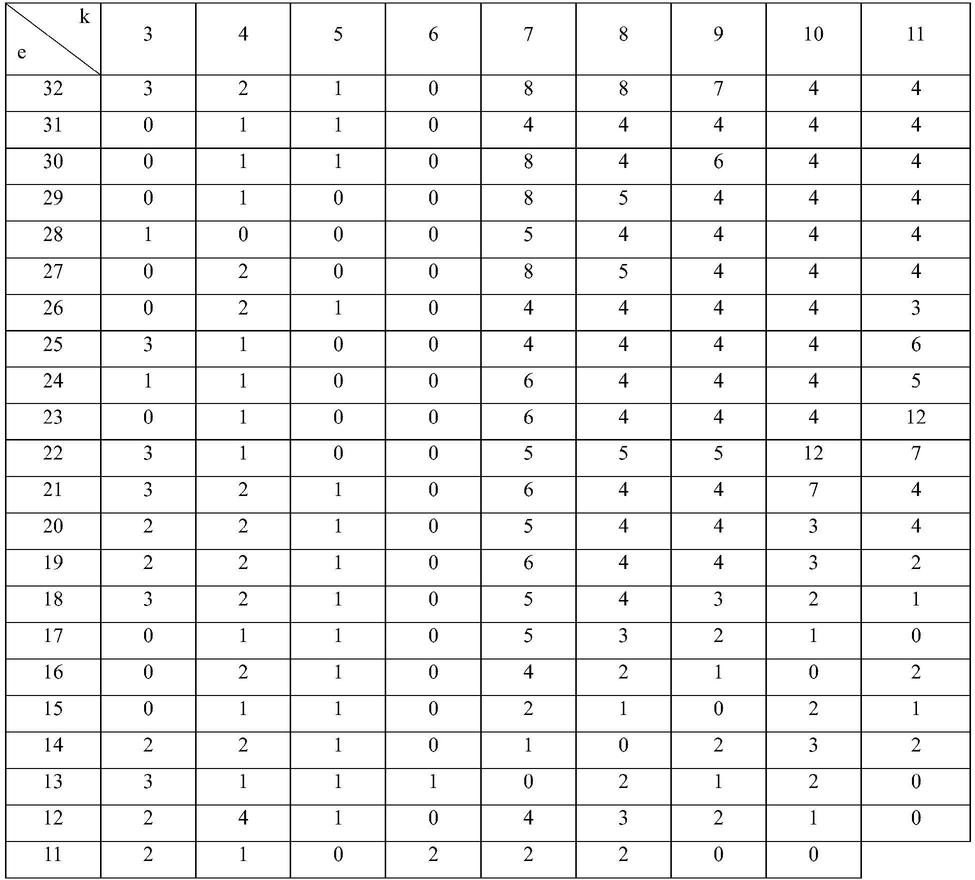

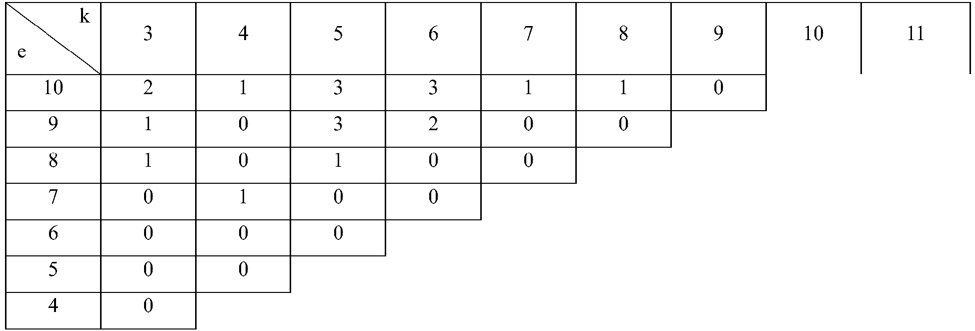

where k represents a message length, and e represents a transmission code length.

In a possible design, the second correspondence includes at least one correspondence in the following table, and each correspondence is a correspondence among one k, one e, and one indication parameter of a PC equation,

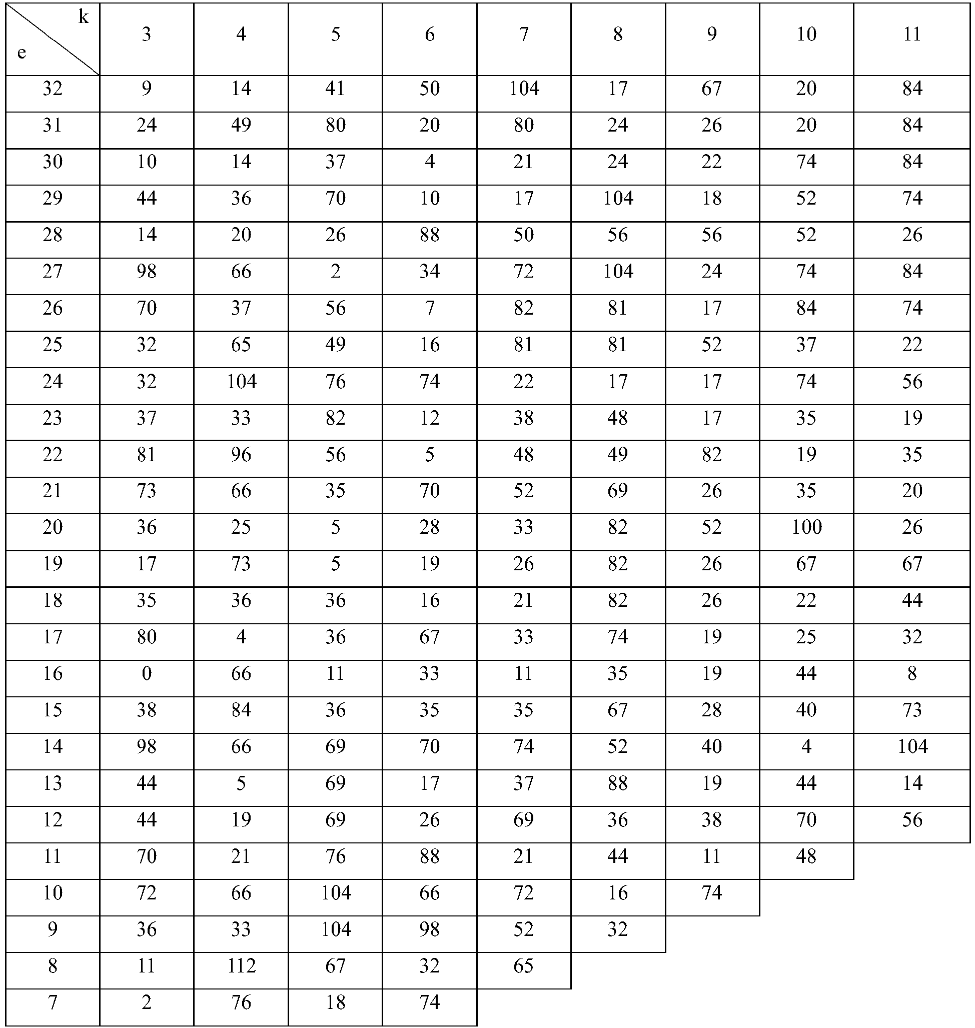

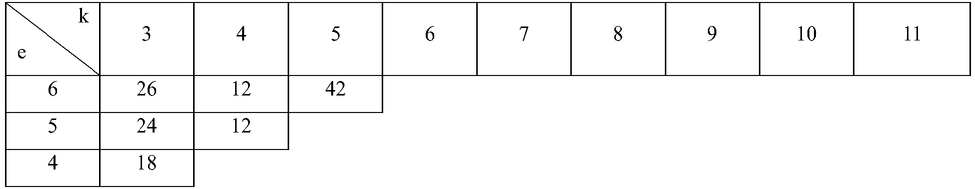

where k represents the message length, and e represents the transmission code length.

In a possible design, the first correspondence includes at least one correspondence in the following table, and each correspondence is a correspondence among one k, one e, and one number of first parity check bits,

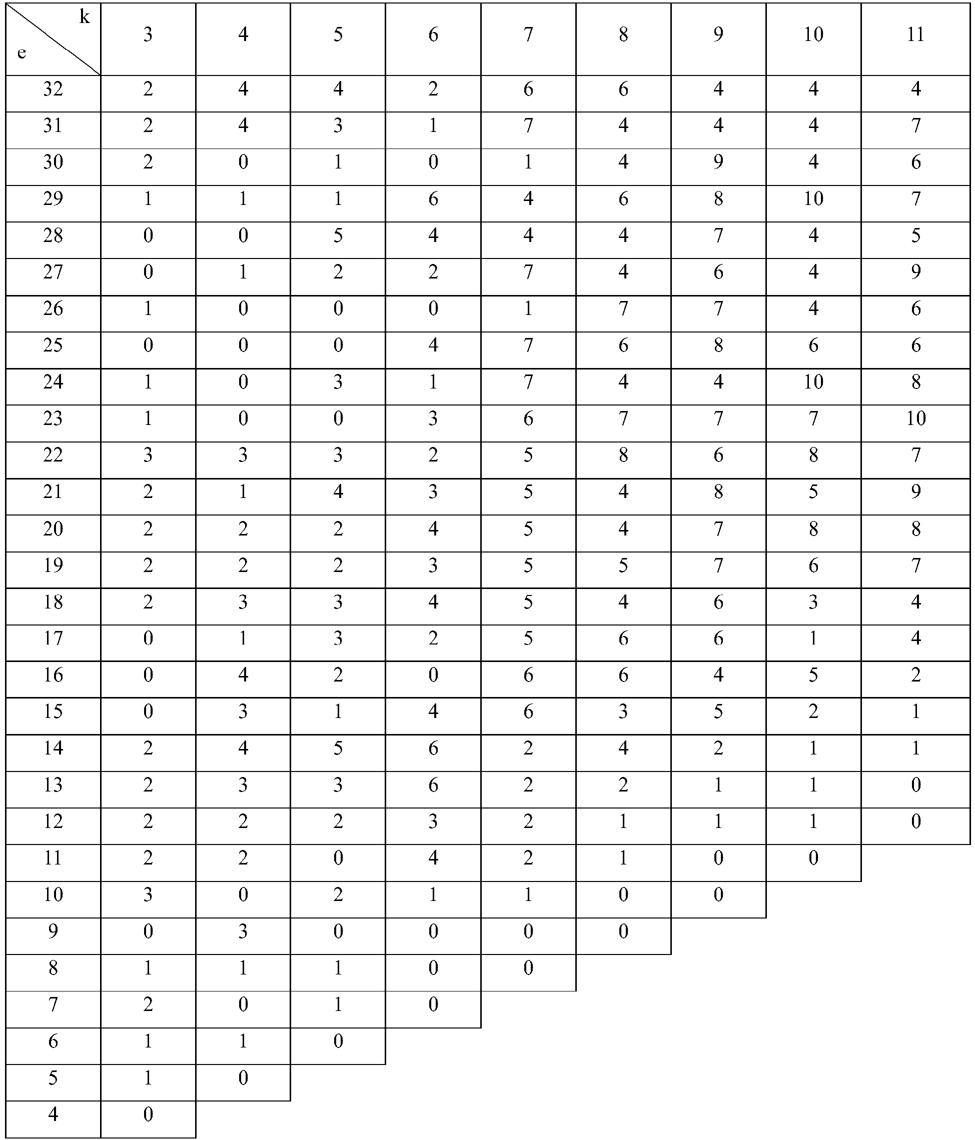

where k represents a message length, and e represents a transmission code length.

In a possible design, the second correspondence includes at least one correspondence in the following table, and each correspondence is a correspondence among one k, one e, and one indication parameter of a PC equation,

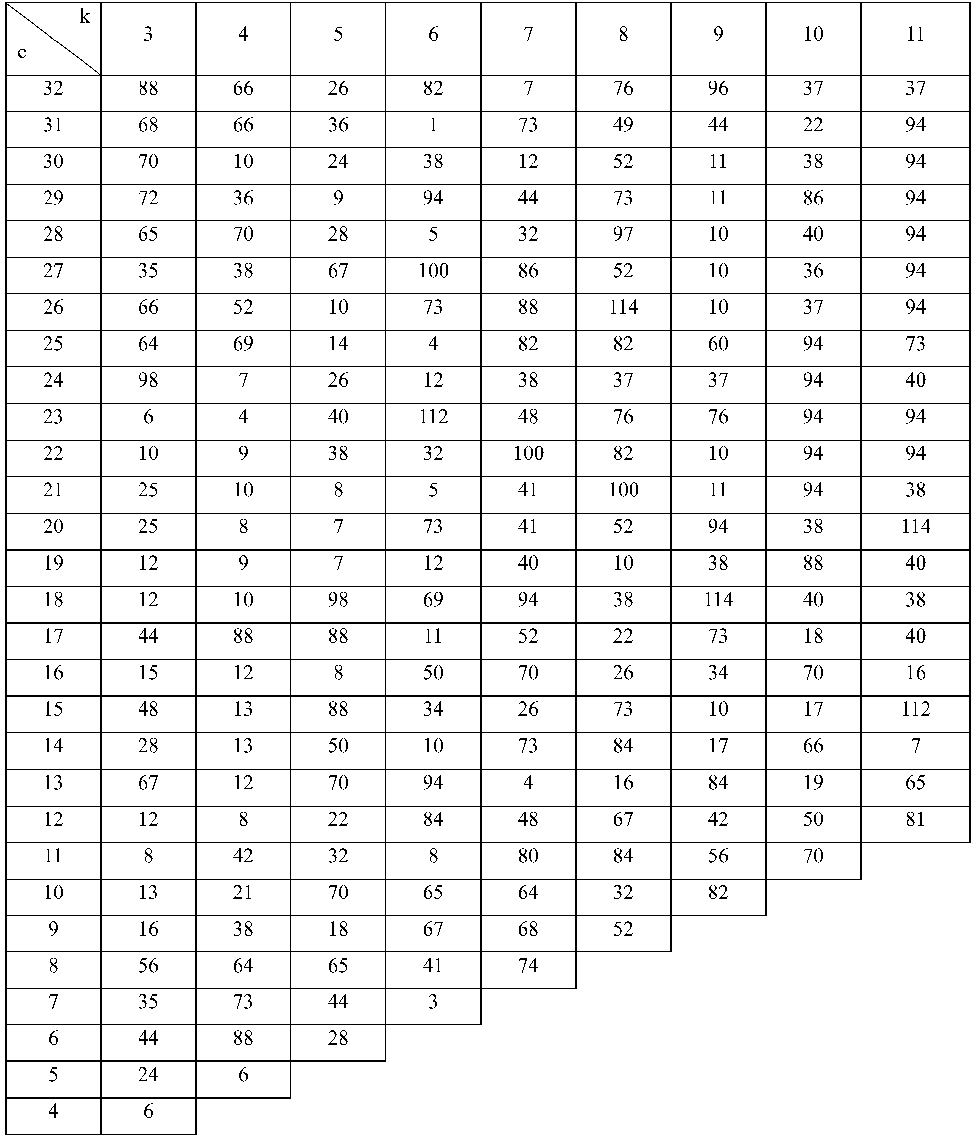

where k represents the message length, and e represents the transmission code length.

In a possible design, the third correspondence includes at least one correspondence in the following table, and each correspondence is a correspondence among one k, one e, and one specified threshold corresponding to a number of effective parity check bits,

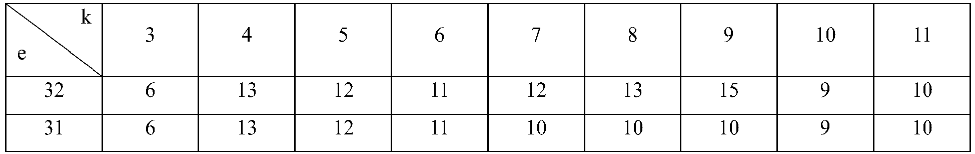

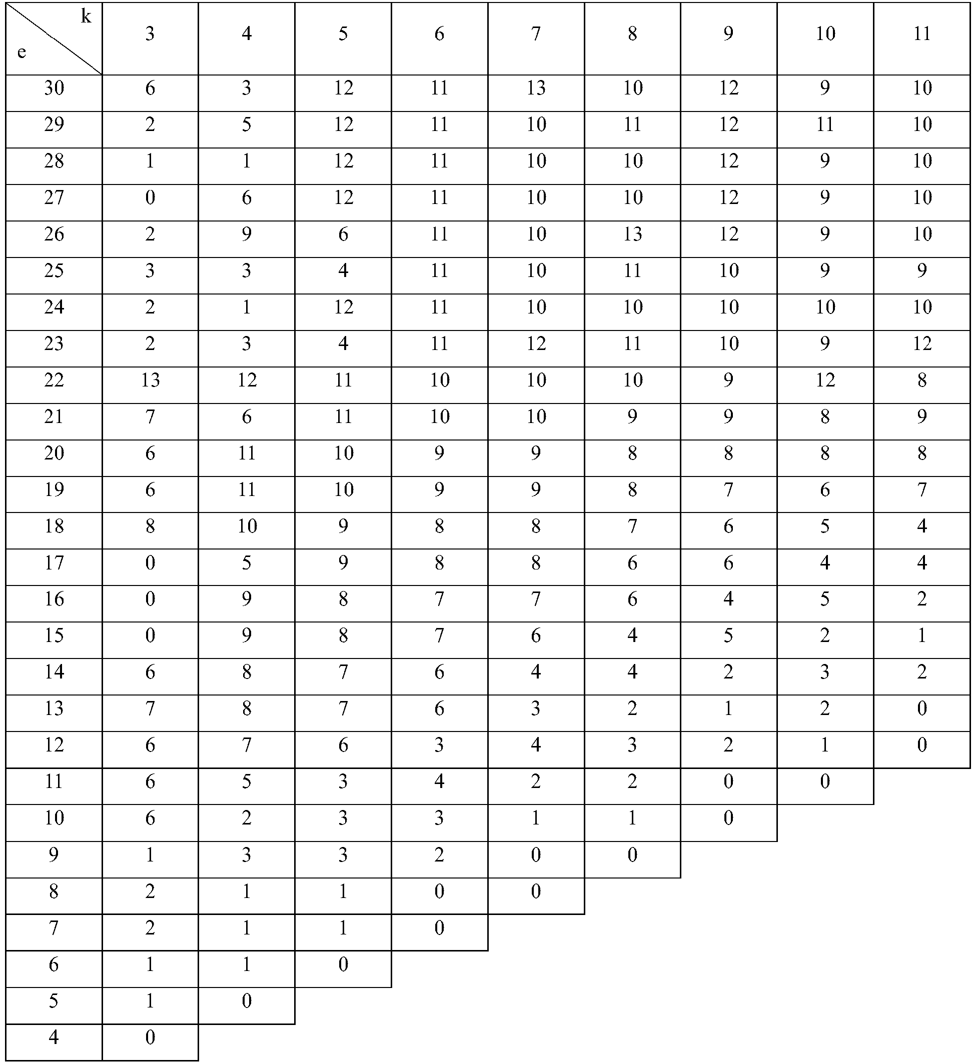

where k represents a message length, and e represents a transmission code length.

In a possible design, the third correspondence includes at least one correspondence in the following table, and each correspondence is a correspondence among one k, one e, and one specified threshold corresponding to a number of effective parity check bits,

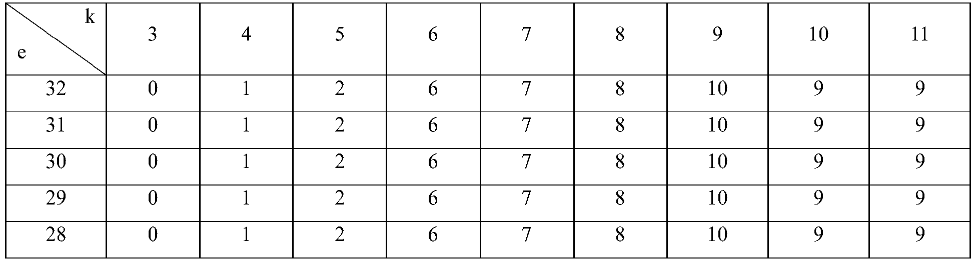

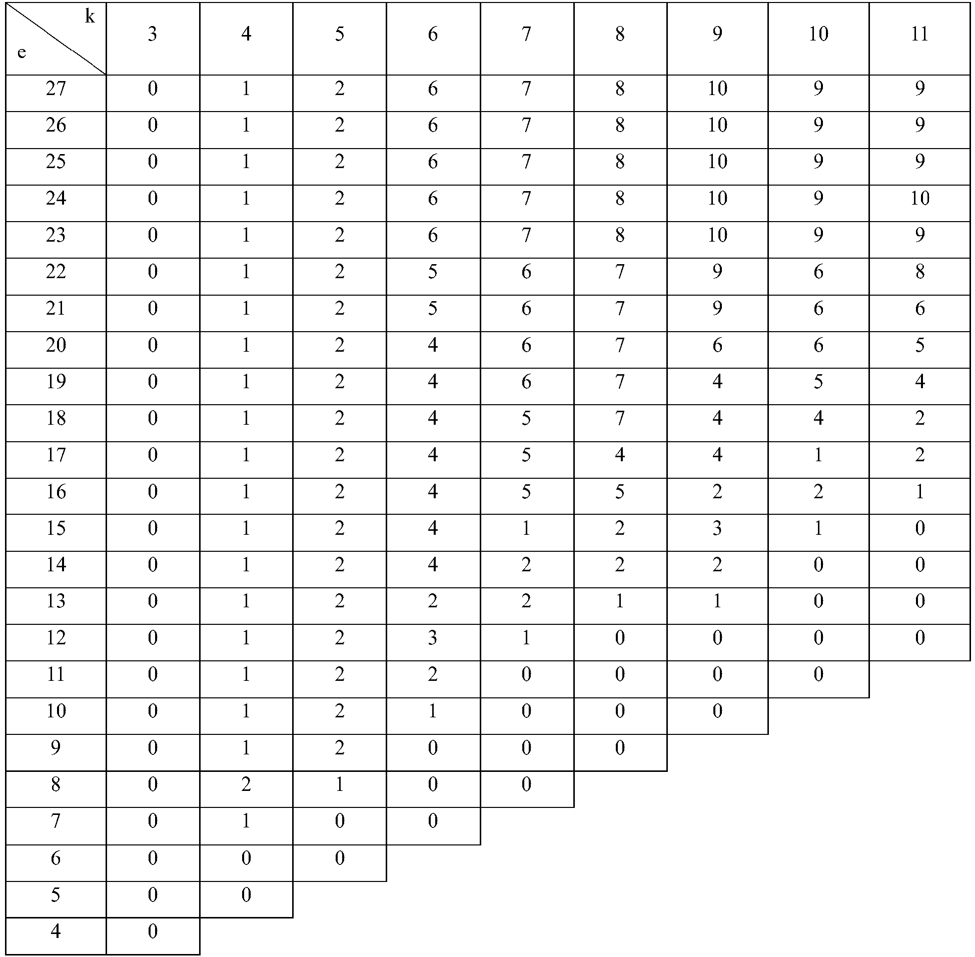

where k represents a message length, and e represents a transmission code length.

A third aspect provides a communication apparatus. The communication apparatus may be the first communication apparatus or the second communication apparatus. The communication apparatus may include a communication unit and a processing unit, to perform the first aspect or the second aspect, or perform any possible implementation in the first aspect or the second aspect. The communication unit is configured to perform sending and receiving operations, for example, functions related to sending and receiving. The communication unit may be referred to as a transceiver unit. Optionally, the communication unit includes a receiving unit and a sending unit. The processing unit is configured to perform a processing operation.

In a design, the communication apparatus is a communication chip, the processing unit may be one or more processors or processor cores, and the communication unit may be an input/output circuit, an input/output interface, or an antenna port of the communication chip.

In another design, the communication unit may be a transmitter and a receiver, or the communication unit is a transmitter machine and a receiver machine.

Optionally, the communication apparatus further includes modules that can be configured to perform the first aspect or the second aspect, or perform any possible implementation in the first aspect or the second aspect.

A fourth aspect provides a communication apparatus. The communication apparatus may be the first communication apparatus or the second communication apparatus. The communication apparatus may include a processor and a memory, to perform the first aspect or the second aspect, or perform any possible implementation in the first aspect or the second aspect. Optionally, the communication apparatus further includes a transceiver. The memory is configured to store a computer program or instructions. The processor is configured to call the computer program or the instructions from the memory and run the computer program or the instructions. When the processor executes the computer program or the instructions in the memory, the communication apparatus is enabled to perform the first aspect or the second aspect, or perform any possible implementation in the first aspect or the second aspect.

Optionally, there are one or more processors, and there are one or more memories.

Optionally, the memory and the processor may be integrated together, or the memory and the processor are separately disposed.

Optionally, the transceiver may include a transmitter machine (transmitter) and a receiver machine (receiver).

A fifth aspect provides a communication apparatus. The communication apparatus may be the first communication apparatus or the second communication apparatus. The communication apparatus may include a processor, to perform the first aspect or the second aspect, or perform any possible implementation in the first aspect or the second aspect. The processor is coupled to a memory. Optionally, the communication apparatus further includes the memory. Optionally, the communication apparatus further includes a communication interface, and the processor is coupled to the communication interface.

In an implementation, when the communication apparatus is the first communication apparatus or the second communication apparatus, the communication interface may be a transceiver or an input/output interface. Optionally, the transceiver may be a transceiver circuit. Optionally, the input/output interface may be an input/output circuit.

In another implementation, when the communication apparatus is a chip or a chip system, the communication interface may be an input/output interface, an interface circuit, an output circuit, an input circuit, a pin, a related circuit, or the like on the chip or the chip system. The processor may alternatively be embodied as a processing circuit or a logic circuit.

A sixth aspect provides a computer-readable storage medium. The computer-readable storage medium stores a computer program or instructions. When the computer program or the instructions are executed by a processor, the first aspect or the second aspect or any possible implementation thereof is implemented.

A seventh aspect provides a computer program product storing instructions. When the instructions are run by a processor, the first aspect or the second aspect or any possible implementation thereof is implemented.

An eighth aspect provides a communication apparatus. The communication apparatus includes a processor, and may further include a storage medium. The storage medium stores instructions. When the instructions are executed by the processor, the processor is configured to implement the first aspect or the second aspect or any possible implementation thereof. The communication apparatus may be a chip system. The chip system may include a chip, or may include a chip and another discrete component.

A ninth aspect provides a communication system. The communication system includes the first communication apparatus according to the first aspect and the second communication apparatus according to the second aspect.

According to a tenth aspect, this application further provides a chip, including a processor. The processor is coupled to a memory, and is configured to read and execute program instructions stored in the memory, for the chip to implement the first aspect or the second aspect or any possible implementation thereof.

For all of the third aspect to the tenth aspect and technical effects that can be achieved according to all aspects, refer to descriptions of any one of the first aspect and the second aspect, or technical effects that can be achieved according to all possible solutions in all the aspects. Details are not described herein again.

### BRIEF DESCRIPTION OF DRAWINGS

FIG. 1 is a diagram of an architecture of a communication system according to an embodiment of this application;
FIG. 2 is a diagram of an encoding and decoding procedure according to an embodiment of this application;
FIG. 3 is a schematic flowchart of an encoding method according to an embodiment of this application;
FIG. 4 is a schematic flowchart of determining positions for a parity check bit and an information bit in a mother code sequence according to an embodiment of this application;
FIG. 5 is a schematic flowchart of a decoding method according to an embodiment of this application;
FIG. 6 is a diagram of a shift register according to an embodiment of this application;
FIG. 7 is a diagram of a shift register according to an embodiment of this application;
FIG. 8 is a diagram of transmission performance according to an embodiment of this application;
FIG. 9 is a diagram of a shift register according to an embodiment of this application;
FIG. 10 is a diagram of a mother code sequence according to an embodiment of this application;
FIG. 11 is a diagram of a mother code sequence according to an embodiment of this application;
FIG. 12 is a diagram of a structure of a communication apparatus according to an embodiment of this application;
FIG. 13 is a diagram of a structure of a communication apparatus according to an embodiment of this application; and
FIG. 14 is a diagram of a structure of a communication apparatus according to an embodiment of this application.

### DESCRIPTION OF EMBODIMENTS

The technical solutions in embodiments of this application may be applied to various communication systems, such as a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a time division-synchronization code division multiple access (time division-synchronization code division multiple access, TD-SCDMA) system, a long term evolution (long term evolution, LTE) system, a worldwide interoperability for microwave access (worldwide interoperability for microwave access, WiMAX) communication system, and a 5th generation (5th generation, 5G) mobile communication system, for example, a new radio (new radio, NR) system. The technical solutions provided in this application may be further applied to a future communication system, for example, a 6th generation (6th generation, 6G) mobile communication system. Alternatively, a communication system may be a Bluetooth (Bluetooth) communication system, a wireless local area network (wireless local area network, WLAN)/wireless communication technology (Wi-Fi) communication system, a narrowband Internet of Things (narrowband Internet of Things, NB-IoT) communication system, or the like. The technical solutions provided in embodiments of this application may be further applied to a satellite communication system. The satellite communication system may be integrated with the foregoing communication system.

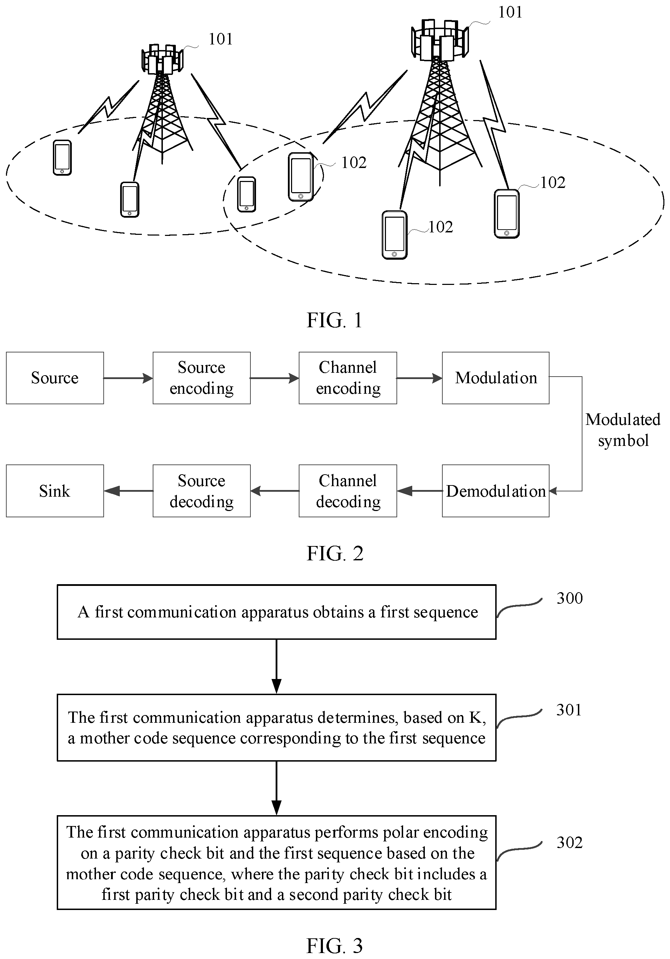

For ease of understanding of embodiments of this application, an application scenario to which this application is applicable is described by using an architecture of a communication system shown in FIG. 1 as an example. As shown in FIG. 1, the communication system includes a network device 101 and a terminal device 102. A communication apparatus provided in embodiments of this application may be used in the network device 101 or the terminal device 102. It may be understood that FIG. 1 shows only a possible architecture of the communication system to which embodiments of this application are applicable. In another possible scenario, an architecture of the communication system may alternatively include another device.

The network device 101 is a node in a radio access network (radio access network, RAN), and may be referred to as an access network device, a RAN node, or the like. Optionally, the RAN may be a 3GPP-related cellular system, such as a 4G mobile communication system (for example, an LTE system), a 5G mobile communication system (for example, an NR system), or a future-oriented evolved system (for example, a 6G mobile communication system). The RAN may alternatively be an open access network (open RAN, O-RAN or ORAN), a cloud radio access network (cloud radio access network, CRAN), or a wireless fidelity (wireless fidelity, Wi-Fi) system. The RAN may alternatively be a communication system that integrates two or more of the foregoing systems.

In a possible scenario, the access network device may be a base station, an evolved NodeB (evolved NodeB, eNodeB), an access point (access point, AP), a transmission reception point (transmission reception point, TRP), a next generation NodeB (next generation NodeB, gNB), a next generation NodeB in a 6th generation (6th generation, 6G) mobile communication system, a base station in a future mobile communication system, an access node in a Wi-Fi system, or the like. The access network device may alternatively be a macro base station, a micro base station, an indoor base station, a relay node, a donor node, or a radio controller in a CRAN scenario. Optionally, the access network device may alternatively be a server, a wearable device, a vehicle, an on-board device, or the like. For example, an access network device in a vehicle-to-everything (vehicle-to-everything, V2X) technology may be a roadside unit (roadside unit, RSU).

In another possible scenario, a plurality of RAN nodes cooperate to assist a terminal in implementing radio access, and different RAN nodes separately implement some functions of a base station. For example, the RAN node may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may also have different names, but a person skilled in the art may understand meanings thereof. For example, in an ORAN system, a CU may also be referred to as an open central unit (open central unit, O-CU) or an open CU, a DU may also be referred to as an open distributed unit (open distributed unit, O-DU), a CU-CP may also be referred to as an open-central unit-control plane (open-central unit-control plane, O-CU-CP), a CU-UP may also be referred to as an open-central unit-user plane (open-central unit-user plane, O-CU-UP), and an RU may also be referred to as an open radio unit (open radio unit, O-RU). For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

In embodiments of this application, a function of the network device may be performed by a module (for example, a chip) in the network device, or may be performed by a control subsystem including the function of the network device. The control subsystem including the function of the network device may be a control center in the foregoing application scenarios such as a smart grid, industrial control, intelligent transportation, and a smart city.

The terminal device 102 may also be referred to as user equipment (user equipment, UE), a mobile station (mobile station, MS), a mobile terminal (mobile terminal, MT), or the like, and is a device that provides voice or data connectivity for users. The terminal device may alternatively be an Internet of Things device. For example, the terminal device includes a handheld device or an on-board device with a wireless connection function. Currently, the terminal device may be a mobile phone, a tablet computer, a notebook computer, a palmtop computer, a mobile Internet device (mobile Internet device, MID), a wearable device (such as a smartwatch, a smart band, or a pedometer), an on-board device (such as a vehicle, a bicycle, an electric vehicle, an airplane, a ship, a train, or a high-speed railway), a virtual reality (virtual reality, VR) device, an augmented reality (augmented reality, AR) device, a wireless terminal in industrial control, a smart home device (such as a refrigerator, a television, an air conditioner, or a meter), a smart robot, a workshop device, a wireless terminal in self driving, a wireless terminal in remote surgery, a wireless terminal in a smart grid (smart grid), a wireless terminal in transportation safety, a wireless terminal in a smart city, a wireless terminal in a smart home, a flight device (such as a smart robot, a hot air balloon, an unmanned aerial vehicle, or an airplane). Alternatively, the terminal device may be another device with a terminal function. For example, the terminal device may be a device that functions as a terminal in device-to-device (device-to-device, D2D) communication. In this application, a terminal device with a wireless transceiver function and a chip that may be disposed in the terminal device are collectively referred to as a terminal device.

In an embodiment of this application, a function of the terminal device may be performed by a module (for example, a chip or a modem) in the terminal, or may be performed by an apparatus including the function of the terminal.

The network device and the terminal may be at fixed positions, or may be movable. The network device and the terminal may be deployed on land, including an indoor or outdoor scenario, and a handheld or on-board scenario; or may be deployed on water; or may be deployed on an airplane, a balloon, and an artificial satellite in the air. Application scenarios of the network device and the terminal are not limited in embodiments of this application.

In embodiments of this application, "at least one" means one or more, and "a plurality of" means two or more. "And/or" describes an association relationship between associated objects, and indicates that three relationships may exist. For example, A and/or B may indicate the following cases: Only A exists, both A and B exist, and only B exists, where A and B may be singular or plural. The character "/" usually indicates an "or" relationship between the associated objects. "At least one of the following items (pieces)" or a similar expression thereof refers to any combination of these items, including any combination of singular items (pieces) or plural items (pieces). For example, at least one of a, b, and(or) c may indicate a, b, c, a and b, a and c, b and c, or a, b and c, where each of a, b, and c may be an element, or may be a set including one or more elements.

In this application, "for example", "in some embodiments", "in some other embodiments", and the like are intended to indicate giving an example, an illustration, or a description. Any embodiment or design scheme described as an "example" in this application should not be explained as being more preferred or having more advantages than another embodiment or design scheme. To be precise, the word "example" is for presenting a concept in a specific manner.

"Of (of)", "corresponding (corresponding, relevant)", and "corresponding (corresponding)" in this application may be interchangeably used sometimes. It should be noted that expressed meanings are the same when differences are not emphasized. In embodiments of this application, communication and transmission may be interchangeably used sometimes. It should be noted that expressed meanings are the same when differences are not emphasized. For example, transmission may include sending and/or receiving, and may be a noun or a verb.

In this application, "indication" may include a direct indication, an indirect indication, an explicit indication, and an implicit indication. When a piece of indication information is described as indicating A, it may be understood that the indication information carries A, directly indicates A, or indirectly indicates A.

It should be noted that, in embodiments of this application, words such as "first" and "second" are merely used for distinction and descriptions, and cannot be understood as an indication or implication of relative importance or an indication or implication of a sequence.

The communication system shown in FIG. 1 is used as an example. To ensure reliability of communication between devices, a transmit end may encode to-be-sent information. Correspondingly, a receive end receives the encoded information and then decodes the encoded information. In an encoding and decoding procedure shown in FIG. 2, a source at a transmit end sequentially undergoes source encoding, channel encoding, rate matching, and modulation, and then is sent in a channel. After a receive end receives a signal, the signal sequentially undergoes demodulation, de-rate matching, channel decoding, and source decoding, and then a sink is obtained. The transmit end and the receive end may respectively serve as a network device or a terminal device. It may be understood that, in downlink communication, the network device is a transmit end, and the terminal device is a receive end; and in uplink communication, the terminal device is a transmit end, and the network device is a receive end. The network device may be a transmit end or a receive end. In addition, in this application, a case in which both a transmit end and a receive end are terminal devices is not excluded. In this case, D2D communication is performed between the transmit end and the receive end. A method provided in embodiments of this application may be applied to a channel encoding process.

FIG. 3 is a schematic flowchart of an encoding method. The method may be applied to a first communication apparatus. The first communication apparatus may be the transmit end in the encoding and decoding procedure shown in FIG. 2. Correspondingly, a second communication apparatus may be the receive end in the encoding and decoding procedure shown in FIG. 2. For example, when the first communication apparatus is a terminal device or a module (for example, a chip) in the terminal device, the second communication apparatus may be a terminal device or a module (for example, a chip) in the terminal device, or the second communication apparatus may be a network device or a module (for example, a chip) in the network device. When the first communication apparatus is a network device or a module (for example, a chip) in the network device, the second communication apparatus may be a module (for example, a chip) in a terminal device. The method includes the following steps.

Step 300: The first communication apparatus obtains a first sequence.

The first sequence is a to-be-encoded bit sequence. Optionally, the first sequence includes an information bit transmitted between the first communication apparatus and the second communication apparatus. For example, the information bit may be an information bit obtained through source encoding.

Optionally, a length of the first sequence is K. It may be understood that a number of information bits included in the first sequence is K, where K is an integer greater than 0.

Step 301: The first communication apparatus determines, based on K, a mother code sequence corresponding to the first sequence.

The mother code sequence may also be referred to as a reliability sequence. The mother code sequence includes indexes corresponding to N subchannels, and the indexes corresponding to the N subchannels may be sorted in ascending order of reliability. For example, N is an integer greater than 0.

A length of the mother code sequence may be a mother code length N. For example, the mother code length N may be a length of a codeword sequence obtained after the to-be-encoded bit sequence is encoded.

When determining the mother code sequence, the first communication apparatus may determine the mother code sequence based on the length K of the first sequence, or may determine the mother code sequence based on the length K of the first sequence and a transmission code length E. The transmission code length E may be an actual transmission code length of a codeword sequence transmitted between the first communication apparatus and the second communication apparatus, where E is an integer greater than 0.

A specific manner in which the first communication apparatus determines the mother code sequence may be implemented by using a conventional means.

Step 302: The first communication apparatus performs polar encoding on a parity check bit and the first sequence based on the mother code sequence, where the parity check bit includes a first parity check bit and a second parity check bit.

During polar encoding, the first communication apparatus determines positions, in the mother code sequence, for the parity check bit and the information bit in the first sequence. The first communication apparatus performs polar encoding on the parity check bit and the first sequence based on the positions, in the mother code sequence, for the parity check bit and the information bit in the first sequence.

The following separately describes a procedure of determining the positions for the parity check bit and the information bit in the mother code sequence and a procedure of polar encoding.

1. The first communication apparatus determines the positions for the parity check bit and the information bit in the mother code sequence.

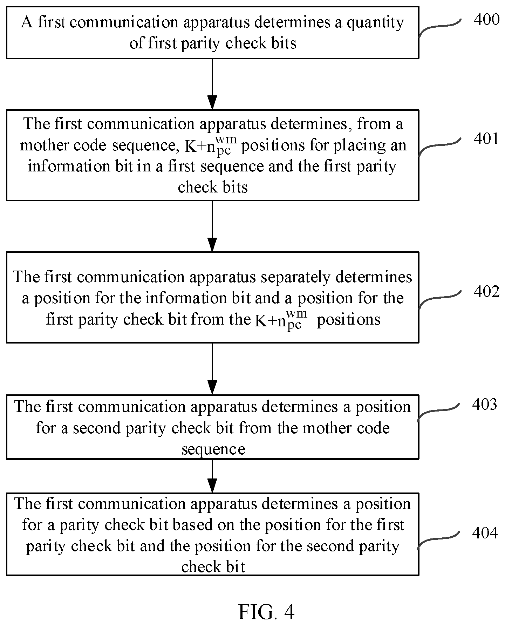

The procedure in which the first communication apparatus determines the positions for the parity check bit and the information bit in the mother code sequence may be shown in FIG. 4, and includes the following steps.

Step 400: The first communication apparatus determines a number of first parity check bits.

Herein, ${n}_{PC}^{wm}$ is the number of first parity check bits, and ${n}_{PC}^{wm}$ is an integer greater than or equal to 0.

For example, the parity check bit in embodiments of this application may include two types: a first parity check bit and a second parity check bit. These two types of parity check bits may be classified based on positions for the parity check bits in the mother code sequence. For example, the first parity check bit may be a parity check bit that sacrifices reliability of a message bit, and the second parity check bit may be a parity check bit that does not sacrifice reliability of a message bit. It may be understood that a position for the first parity check bit in the mother code sequence may be a position with high reliability. In a normal case, a message bit is located at a position with high reliability in the mother code sequence. When a position for the first parity check bit in the mother code sequence is the position with high reliability, the position for the message bit is occupied, and therefore reliability of the message bit is sacrificed. A position for the second parity check bit in the mother code sequence may be a position with low reliability. In a normal case, a message bit is located at a position with high reliability in the mother code sequence. When a position for the second parity check bit in the mother code sequence is the position with low reliability, the position for the message bit is not occupied, and therefore reliability of the message bit is not sacrificed.

Optionally, the first communication apparatus may determine, based on a first correspondence, a number ${n}_{PC}^{wm}$ of first parity check bits corresponding to the first sequence. The first correspondence includes a correspondence between the length K of the first sequence and the first parity check bits ${n}_{PC}^{wm}$.

For example, after obtaining the first sequence, the first communication apparatus determines, based on the length K of the first sequence and based on the first correspondence, the number ${n}_{PC}^{wm}$ of first parity check bits corresponding to the first sequence.

Optionally, in an embodiment of this application, the first correspondence may be generated in advance.

In a possible implementation 1, the first correspondence in an embodiment of this application may include a correspondence between a plurality of message lengths and a number of first parity check bits.

In a possible implementation 2, in an embodiment of this application, a transmission code length may be further considered when a number of first parity check bits is determined. The transmission code length is a transmission code length after rate matching of an encoded sequence (for example, the transmission code length is an actual transmission code length of a codeword sequence transmitted between the first communication apparatus and the second communication apparatus). In this implementation, the first correspondence may include a correspondence among a plurality of message lengths, a plurality of transmission code lengths, and a number of first parity check bits.

For the possible implementation 1, after obtaining the first sequence, the first communication apparatus determines, based on the length K of the first sequence and from the first correspondence including the plurality of message lengths and the number of first parity check bits, the number ${n}_{PC}^{wm}$ of first parity check bits corresponding to the first sequence.

For the possible implementation 2, after obtaining the first sequence, the first communication apparatus determines a target transmission code length E corresponding to the first sequence, and determines, based on the length K of the first sequence and the target transmission code length E and from the first correspondence including the plurality of message lengths, the plurality of transmission code lengths, and the number of first parity check bits, the number ${n}_{PC}^{wm}$ of first parity check bits corresponding to the first sequence.

Step 401: The first communication apparatus determines, from the mother code sequence, ( $K + {n}_{PC}^{wm}$) positions for placing the information bit in the first sequence and the first parity check bits.

The first communication apparatus performs rate matching based on the transmission code length E, and punctures or shortens the mother code sequence, to obtain a target sequence after rate matching.

For example, N = 32, E = 30, and a mother code sequence ${Q}_{0}^{N - 1}$ is {1, 2, 3, 4, 5, 6, 7, 8, 9, 17, 10, 18, 11, 19, 13, 21, 25, 12, 20, 14, 15, 22, 27, 26, 23, 29, 16, 24, 28, 30, 31, 32}. For example, the mother code sequence ${Q}_{0}^{N - 1}$ is punctured, and a sequence obtained by removing puncture positions from the mother code sequence is a target sequence. The target sequence ${\overline{Q}}_{I , tmp}^{N}$ may be {3, 4, 5, 6, 7, 8, 9, 17, 10, 18, 11, 19, 13, 21, 25, 12, 20, 14, 15, 22, 27, 26, 23, 29, 16, 24, 28, 30, 31, 32}.

Optionally, the first communication apparatus determines, from the target sequence obtained by performing rate matching on the mother code sequence, ( $K + {n}_{PC}^{wm}$) positions with the highest reliability for placing the information bit in the first sequence and the first parity check bit.

For example, if the target sequence ${\overline{Q}}_{I , tmp}^{N}$ is {3, 4, 5, 6, 7, 8, 9, 17, 10, 18, 11, 19, 13, 21, 25, 12, 20, 14, 15, 22, 27, 26, 23, 29, 16, 24, 28, 30, 31, 32}, K = 11, and ${n}_{PC}^{wm} = 4$, the ( $K + {n}_{PC}^{wm}$) positions determined by the first communication apparatus from the target sequence are {12, 20, 14, 15, 22, 27, 26, 23, 29, 16, 24, 28, 30, 31, 32}.

For ease of the following description, the ( $K + {n}_{PC}^{wm}$) positions determined by the first communication apparatus from the target sequence are marked as a set ${\overline{Q}}_{I}^{N}$.

Step 402: The first communication apparatus separately determines a position for the information bit and a position for the first parity check bit from the ( $K + {n}_{PC}^{wm}$) positions.

Optionally, the first communication apparatus determines the position for the first parity check bit from the ( $K + {n}_{PC}^{wm}$) positions based on a row weight of the set ${\overline{Q}}_{I}^{N}$ corresponding to the ( $K + {n}_{PC}^{wm}$) positions.

For example, the first communication apparatus determines a minimum row weight *w*ₘᵢₙ of the set ${\overline{Q}}_{I}^{N}$, and sequentially determines, from the set ${\overline{Q}}_{I}^{N}$ in descending order of reliability, ${n}_{PC}^{wm}$ positions whose row weights are equal to *w*ₘᵢₙ as positions for the first parity check bits. If a number of positions whose row weights are equal to *w*ₘᵢₙ in the set ${\overline{Q}}_{I}^{N}$ is less than ${n}_{PC}^{wm}$, after the positions whose row weights are equal to *w*ₘᵢₙ are determined from the set ${\overline{Q}}_{I}^{N}$, positions whose row weights are equal to 2**w*ₘᵢₙ are further sequentially determined from the set ${\overline{Q}}_{I}^{N}$ in descending order of reliability until ${n}_{PC}^{wm}$ positions are determined.

For example, a set ${\overline{Q}}_{I}^{N}$ is {12, 20, 14, 15, 22, 27, 26, 23, 29, 16, 24, 28, 30, 31, 32}, and ${n}_{PC}^{wm} = 4$. If a minimum row weight *w*ₘᵢₙ of the set ${\overline{Q}}_{I}^{N}$ is 8, four positions whose row weights are equal to 8 are sequentially determined from the set ${\overline{Q}}_{I}^{N}$ in descending order of reliability, which are {27, 26, 23, 29}. In this case, the positions for first parity check bits include {27, 26, 23, 29}.

Correspondingly, the first communication apparatus uses, as a position for the information bit in the first sequence, a position other than the position for the first parity check bit in the ( $K + {n}_{PC}^{wm}$) positions determined in step 401.

For example, if a set ${\overline{Q}}_{I}^{N}$ is {12, 20, 14, 15, 22, 27, 26, 23, 29, 16, 24, 28, 30, 31, 32}, and positions for first parity check bits include {27, 26, 23, 29}, positions for information bits in the first sequence include {12, 20, 14, 15, 22, 16, 24, 28, 30, 31, 32}.

Step 403. The first communication apparatus determines a position for the second parity check bit from the mother code sequence.

Optionally, the first communication apparatus may determine the position for the second parity check bit from the mother code sequence based on the target sequence obtained by performing rate matching on the mother code sequence.

For example, the first communication apparatus uses, as the position for the second parity check bit, a position other than the ( $K + {n}_{PC}^{wm}$) positions in the target sequence for placing the information bit in the first sequence and the first parity check bit.

For example, if a target sequence is {3, 4, 5, 6, 7, 8, 9, 17, 10, 18, 11, 19, 13, 21, 25, 12, 20, 14, 15, 22, 27, 26, 23, 29, 16, 24, 28, 30, 31, 32}, and ( $K + {n}_{PC}^{wm}$) positions determined by the first communication apparatus from the mother code sequence are {12, 20, 14, 15, 22, 27, 26, 23, 29, 16, 24, 28, 30, 31, 32}, positions for second parity check bits include {3, 4, 5, 6, 7, 8, 9, 17, 10, 18, 11, 19, 13, 21, 25}.

Step 404: The first communication apparatus determines a position for the parity check bit based on the position for the first parity check bit and the position for the second parity check bit.

Optionally, the first communication apparatus combines the position for the first parity check bit and the position for the second parity check bit, to obtain the position for the parity check bit.

For example, positions for first parity check bits include {27, 26, 23, 29}, and positions for second parity check bits include {3, 4, 5, 6, 7, 8, 9, 17, 10, 18, 11, 19, 13, 21, 25}. The first communication apparatus may determine that a set DF corresponding to positions for parity check bits is {3, 4, 5, 6, 7, 8, 9, 17, 10, 18, 11, 19, 13, 21, 25, 27, 26, 23, 29}.

In a possible implementation, after determining, based on step 404, a set DF corresponding to the position for the parity check bit, the first communication apparatus may further simplify the set DF. Optionally, the first communication apparatus may determine positions for effective parity check bits from the positions for the parity check bits, and form a simplified parity check bit position set *DF^{simplified}* including the positions for effective parity check bits.

The effective parity check bit may mean that a subchannel before a subchannel carrying the parity check bit carries an information bit.

For example, when determining a position for an effective parity check bit, the first communication apparatus may use, as the position for the effective parity check bit, a position for a parity check bit that is in the determined positions for the parity check bits and that is after a position for an information bit.

Optionally, the first communication apparatus uses a position for the effective parity check bit in the target sequence as an updated position for the parity check bit. Correspondingly, the first communication apparatus may use, as a frozen bit, a position other than the effective parity check bit in the positions for first parity check bits and the positions for second parity check bits.

For example, a set DF corresponding to positions for parity check bits is {3, 4, 5, 6, 7, 8, 9, 17, 10, 18, 11, 19, 13, 21, 25, 27, 26, 23, 29}, and positions for information bits in the first sequence include {12, 20, 14, 15, 22, 16, 24, 28, 30, 31, 32}. In this case, a set *DF^{simplified}* corresponding to positions for effective parity check bits is {13, 17, 18, 19, 21, 23, 25, 26, 27, 29}. A parity check bit position set finally determined by the first communication apparatus may be the set *DF^{simplified}.*

2. The first communication apparatus performs polar encoding on the parity check bit and the first sequence based on the positions, in the mother code sequence, for the parity check bit and the information bit in the first sequence.

After determining the positions for the parity check bit and the information bit in the mother code sequence, the first communication apparatus generates a precoded sequence.

In a process of generating the precoded sequence, the first communication apparatus determines the parity check bit based on the ( $K + {n}_{PC}^{wm}$) positions in the mother code sequence, the position for the second parity check bit, a target PC equation, and the first sequence.

Optionally, the first communication apparatus separately determines the first parity check bit and the second parity check bit based on the position for the information bit in the mother code sequence, the positions for the first parity check bit and the second parity check bit, the target PC equation, and the information bit in the first sequence.

The first communication apparatus may determine the target PC equation based on a second correspondence.

Optionally, the second correspondence includes a correspondence between the length K of the first sequence and an indication parameter of the target PC equation.

The first communication apparatus may determine, from the second correspondence based on the length K of the first sequence, the indication parameter of the target PC equation corresponding to K, and determine the target PC equation based on the determined indication parameter of the target PC equation.

For example, if an indication parameter of a target PC equation is 26 with a binary representation [1 1 0 1 0] (where the leftmost bit is the most significant bit), the corresponding target PC equation is D⁴+D³+D¹.

Optionally, in an embodiment of this application, the second correspondence may be generated in advance.

In a possible implementation 1, the second correspondence in an embodiment of this application may include a correspondence between a plurality of message lengths and an indication parameter of a PC equation.

In a possible implementation 2, in an embodiment of this application, a transmission code length may be further considered when an indication parameter of a PC equation is determined. The transmission code length is a transmission code length after rate matching of an encoded sequence (for example, the transmission code length is an actual transmission code length of a codeword sequence transmitted between the first communication apparatus and the second communication apparatus). In this implementation, the first correspondence may include a correspondence among a plurality of message lengths, a plurality of transmission code lengths, and an indication parameter of a PC equation.

For the possible implementation 1, after obtaining the first sequence, the first communication apparatus determines, based on the length K of the first sequence, an indication parameter of a target PC equation from the second correspondence including the plurality of message lengths and the indication parameter of the PC equation.

For the possible implementation 2, after obtaining the first sequence, the first communication apparatus determines a target transmission code length E corresponding to the first sequence, and determines, based on the length K of the first sequence and the target transmission code length E, the indication parameter of the target PC equation from the second correspondence including the plurality of message lengths, the plurality of transmission code lengths, and the indication parameter of the PC equation.

After determining the parity check bit (including the first parity check bit and the second parity check bit), the first communication apparatus maps the parity check bit and the information bit of the first sequence, to generate a precoded sequence. For example, the first communication apparatus may perform mapping based on the determined positions for the information bit and the parity check bit in the mother code sequence, to map the information bit to the position for the information bit in the mother code sequence and map the parity check bit to the position for the parity check bit in the mother code sequence, so as to generate the precoded sequence.

After generating the precoded sequence, the first communication apparatus performs polar encoding on the precoded sequence, to obtain an encoded codeword sequence; and the first communication apparatus performs rate matching on the codeword sequence based on the target transmission code length E, to obtain a second sequence. A length of the second sequence may be the target transmission code length E.

Optionally, the first communication apparatus may send the second sequence to the second communication apparatus.

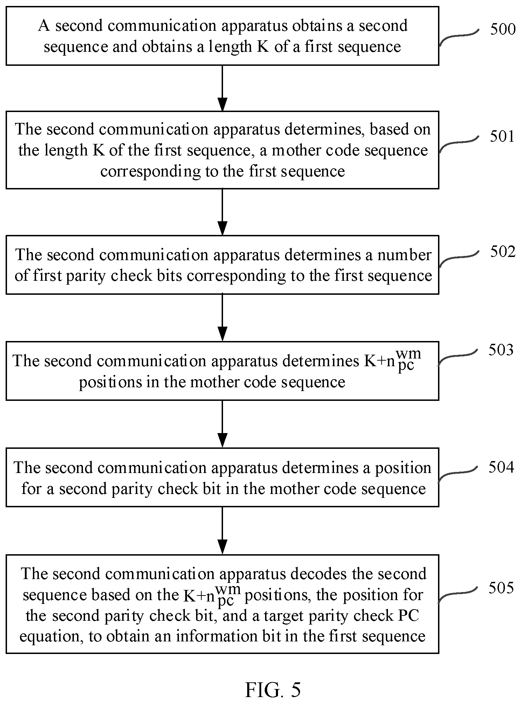

Based on an inventive concept same as that of the foregoing encoding method, correspondingly, embodiments of this application further provide a decoding method. The method may be applied to a second communication apparatus. The second communication apparatus may be the receive end in the encoding and decoding procedure shown in FIG. 2. FIG. 5 is a schematic flowchart of a decoding method. The method includes the following steps.

Step 500: The second communication apparatus obtains a second sequence and obtains a length K of a first sequence.

The second sequence is a to-be-decoded sequence that is sent by the first communication apparatus and that is obtained in the second communication apparatus after the first sequence is subjected to operations such as polar encoding, rate matching, modulation, and frequency conversion and is then transmitted through a wireless transmission environment.

Step 501: The second communication apparatus determines, based on the length K of the first sequence, a mother code sequence corresponding to the first sequence.

It should be noted that, for a manner in which the second communication apparatus determines the mother code sequence corresponding to the first sequence, refer to the foregoing description of step 301. Details are not described herein again.

Step 502: The second communication apparatus determines a number of first parity check bits corresponding to the first sequence.

Optionally, the second communication apparatus determines, based on a first correspondence, the number ${n}_{PC}^{wm}$ of first parity check bits corresponding to the first sequence, where the first correspondence includes a correspondence between the length K of the first sequence and the first parity check bit.

It should be noted that, for a manner in which the second communication apparatus determines the number ${n}_{PC}^{wm}$ of first parity check bits corresponding to the first sequence, refer to the foregoing description of step 400. Details are not described herein again.

Step 503: The second communication apparatus determines ( $K + {n}_{PC}^{wm}$) positions in the mother code sequence.

The ( $K + {n}_{PC}^{wm}$) positions are positions in the mother code sequence for placing the information bit in the first sequence and the first parity check bits.

Before performing step 503, the second communication apparatus may perform rate matching on the mother code sequence based on a target transmission code length E, to obtain a target sequence after rate matching.

Optionally, the second communication apparatus determines the ( $K + {n}_{PC}^{wm}$) positions in the target sequence based on reliability and a row weight.

It should be noted that, for a manner in which the second communication apparatus determines the ( $K + {n}_{PC}^{wm}$) positions in the target sequence, refer to the foregoing description of step 401. Details are not described herein again.

In a possible implementation, after determining the ( $K + {n}_{PC}^{wm}$) positions, the second communication apparatus may further determine the position for the information bit and the position for the first parity check bit from the ( $K + {n}_{PC}^{wm}$) positions.

For a manner in which the second communication apparatus separately determines the position for the information bit and the position for the first parity check bit from the ( $K + {n}_{PC}^{wm}$) positions, refer to the foregoing description of step 402. Details are not described herein again.

Step 504: The second communication apparatus determines a position for a second parity check bit in the mother code sequence.

It should be noted that, for a manner in which the second communication apparatus determines the position for the second parity check bit from the mother code sequence, refer to the foregoing description of step 403. Details are not described herein again.

Step 505: The second communication apparatus decodes the second sequence based on the ( $K + {n}_{PC}^{wm}$) positions, the position for the second parity check bit, and a target parity check PC equation, to obtain an information bit in the first sequence.

Optionally, the second communication apparatus decodes the second sequence based on the position for the information bit in the mother code sequence, the positions for the first parity check bit and the second parity check bit, and the target PC equation, to obtain the information bit in the first sequence.

If the first communication apparatus performs encoding based on a simplified parity check bit position set, correspondingly, in a decoding process, the second communication apparatus may also decode the second sequence based on a position for an effective parity check bit in the positions for the first parity check bit and the second parity check bit.

The second communication apparatus may determine the target PC equation based on a second correspondence.

Optionally, the second correspondence includes a correspondence between the length K of the first sequence and an indication parameter of the target PC equation.

The second communication apparatus may determine, from the second correspondence based on the length K of the first sequence, the indication parameter of the target PC equation corresponding to K, and determine the target PC equation based on the determined indication parameter of the target PC equation.

Optionally, in an embodiment of this application, the second correspondence may be generated in advance.

In a possible implementation 1, the second correspondence in an embodiment of this application may include a correspondence between a plurality of message lengths and an indication parameter of a PC equation.

In a possible implementation 2, in an embodiment of this application, a transmission code length may be further considered when an indication parameter of a PC equation is determined. The transmission code length is a transmission code length after rate matching of an encoded sequence (for example, the transmission code length is an actual transmission code length of a codeword sequence transmitted between the first communication apparatus and the second communication apparatus). In this implementation, the first correspondence may include a correspondence among a plurality of message lengths, a plurality of transmission code lengths, and an indication parameter of a PC equation.

For the possible implementation 1, the second communication apparatus determines, based on the length K of the first sequence, an indication parameter of a target PC equation from the second correspondence including the plurality of message lengths and the indication parameter of the PC equation.

For the possible implementation 2, the second communication apparatus determines, based on the length K of the first sequence and the target transmission code length E, an indication parameter of a target PC equation from the second correspondence including the plurality of message lengths, the plurality of transmission code lengths, and the indication parameter of the PC equation.

A manner in which the second communication apparatus decodes the second sequence may be successive cancellation list (successive cancellation list, SCL) decoding. Its specific decoding process may include the following steps.

Step 1: Perform de-rate matching on the second sequence to obtain a to-be-decoded sequence of a mother code length.

Step 2: Determine a type of a bit at a current decoding position. If the bit is a frozen bit, a decoding output is fixed to 0, without path splitting. If a current decoding result is not 0, a penalty value greater than zero is added to a current path metric. If the bit is a message bit, the message bit is split into two possible values: 0 or 1 that are stored as current decoding paths (that is, path splitting), and a decoding metric corresponding to each path is calculated (for example, a smaller metric is better). If a current position is of a parity check bit, the parity check bit at the current position is calculated based on a determined target PC equation and a previous decoding result. If a calculation result is consistent with a current decoding result of a decoder, a decoding metric of a current path does not increase. If a calculation result is inconsistent with a current decoding result of a decoder, a penalty value greater than 0 is added to a decoding metric of a current decoding path.

Step 3: Repeat step 2 until the decoder completes decoding of bits at N (N is the mother code length) positions, and select a path with a minimum decoding metric from at most List (for example, List = 8) decoding paths as a final decoding output sequence.

Step 4: Extract K message bits from the decoding sequence in step 3 based on positions of message bits, and end decoding.

The following describes in detail the first correspondence and the second correspondence in the foregoing encoding process and decoding process.

In the following description, an example in which the first correspondence includes a correspondence among a plurality of message lengths, a plurality of transmission code lengths, and a number of first parity check bits, and the second correspondence includes a correspondence among a plurality of message lengths, a plurality of transmission code lengths, and an indication parameter of a PC equation is used for description.

### Example 1:

In the first correspondence, a corresponding number of first parity check bits is determined for each message length and each transmission code length. In the second correspondence, a corresponding indication parameter of a PC equation is determined for each message length and each transmission code length.

In the first correspondence, one message length and one transmission code length correspond to one number of first parity check bits. When message lengths and/or transmission code lengths are different, corresponding numbers of first parity check bits may be the same or different. In the second correspondence, one message length and one transmission code length correspond to one indication parameter of a PC equation. When message lengths and/or transmission code lengths are different, corresponding indication parameters of PC equations may be the same or different.

Optionally, in the first correspondence, a number of first parity check bits corresponding to one message length and one transmission code length is not greater than a difference between the corresponding transmission code length and the corresponding message length.

For example, among a plurality of correspondences shown in Table 1, each correspondence is a correspondence among one message length k, one transmission code length e, and one number of first parity check bits. In Table 1, a value determined based on the intersection between a row corresponding to a message length k and a column corresponding to a transmission code length e is taken as a number of first parity check bits. For example, when k = 3 and e = 32, a corresponding number of first parity check bits is 3. In another example, when k = 5 and e = 26, a corresponding number of first parity check bits is 1.

Optionally, the first correspondence in an embodiment of this application may include at least one correspondence in Table 1.

In Table 1, an example in which a value range of k is 3 to 11 and a value range of e is 4 to 32 is used.

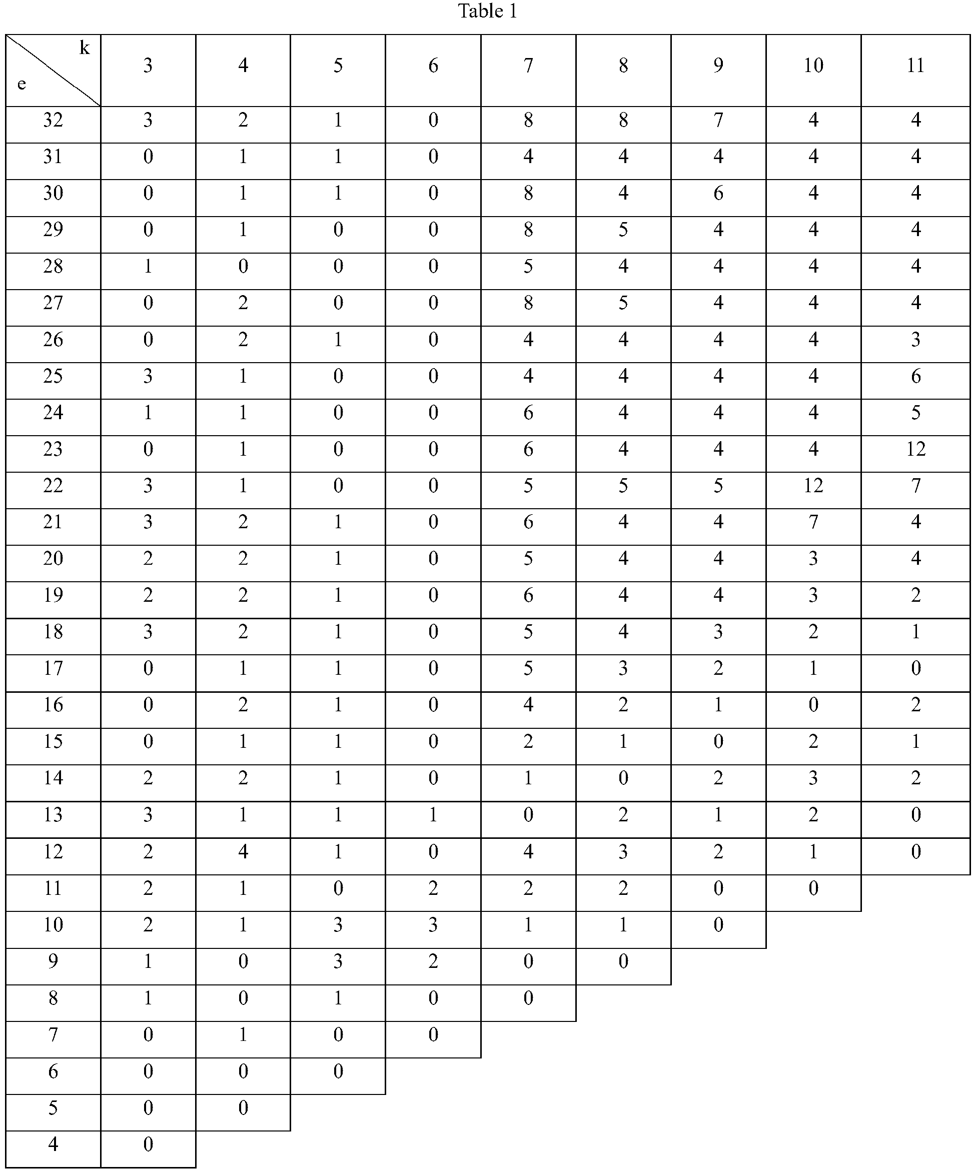

For example, among a plurality of correspondences shown in Table 2, each correspondence is a correspondence among one message length k, one transmission code length e, and one indication parameter of a PC equation. In Table 2, a value determined based on the intersection between a row corresponding to a message length k and a column corresponding to a transmission code length e is taken as an indication parameter of a PC equation. For example, when k = 3 and e = 32, a corresponding indication parameter of a PC equation is 9. In another example, when k = 4 and e = 22, a corresponding indication parameter of a PC equation is 96.

Optionally, the second correspondence in an embodiment of this application may include at least one correspondence in Table 2.

In Table 2, an example in which a value range of k is 3 to 11 and a value range of e is 4 to 32 is used.

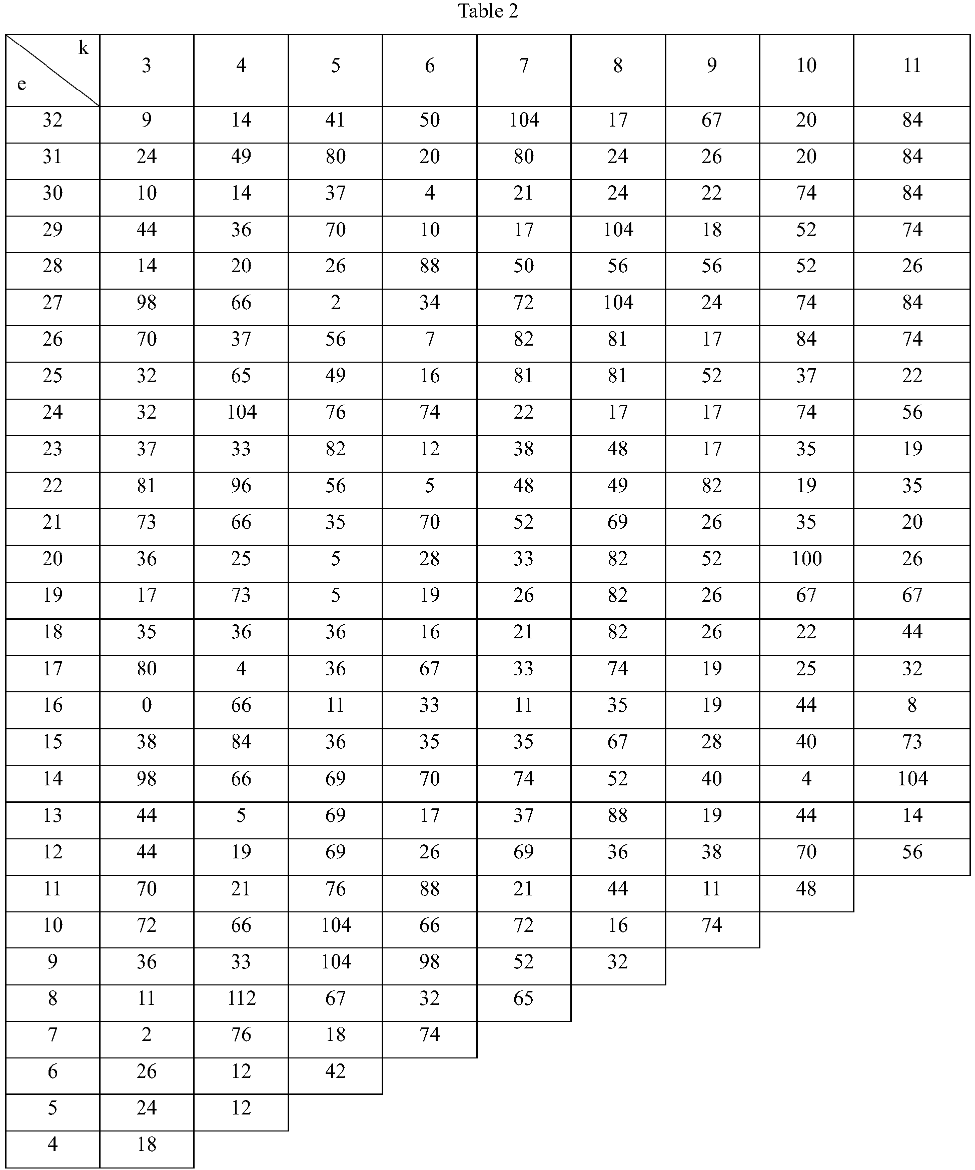

Alternatively, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

In a plurality of correspondences shown in Table 3, each correspondence is a correspondence among one message length k, one transmission code length e, one number of first parity check bits, and one indication parameter of a PC equation. In Table 3, values determined based on a row in which a message length k is located and a column in which a transmission code length e is located are a number of first parity check bits and an indication parameter of a PC equation. For example, when k = 3 and e = 32, a corresponding number of first parity check bits is 3, and a corresponding indication parameter of a PC equation is 9. In another example, when k = 4 and e = 22, a corresponding number of first parity check bits is 1, and a corresponding indication parameter of a PC equation is 96.

Optionally, the target correspondence in an embodiment of this application may include at least one correspondence in Table 3, where the target correspondence includes the first correspondence and the second correspondence.

In Table 3, an example in which a value range of k is 3 to 11 and a value range of e is 4 to 32 is used.

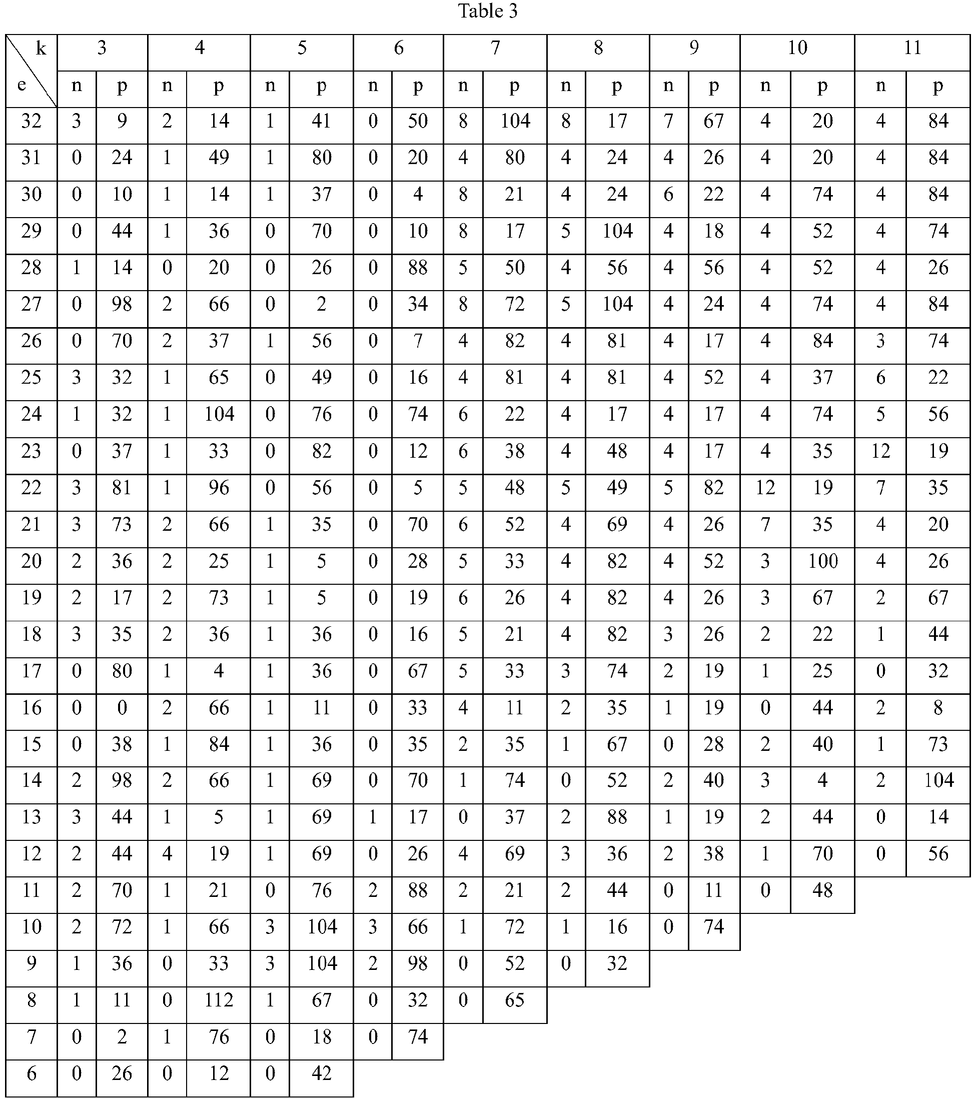

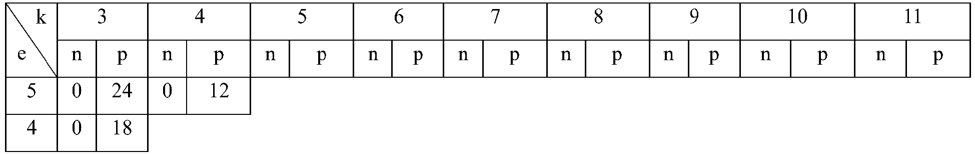

Based on the correspondence among the message length k, the transmission code length e, the number n of first parity check bits, and the indication parameter p of the PC equation in Example 1, after determining the number ${n}_{PC}^{wm}$ of first parity check bits and the indication parameter of the target PC equation based on the length K of the first sequence and the target transmission code length E, the first communication apparatus generates a precoded sequence based on the determined position for the information bit and the determined position for the parity check bit in the mother code sequence.

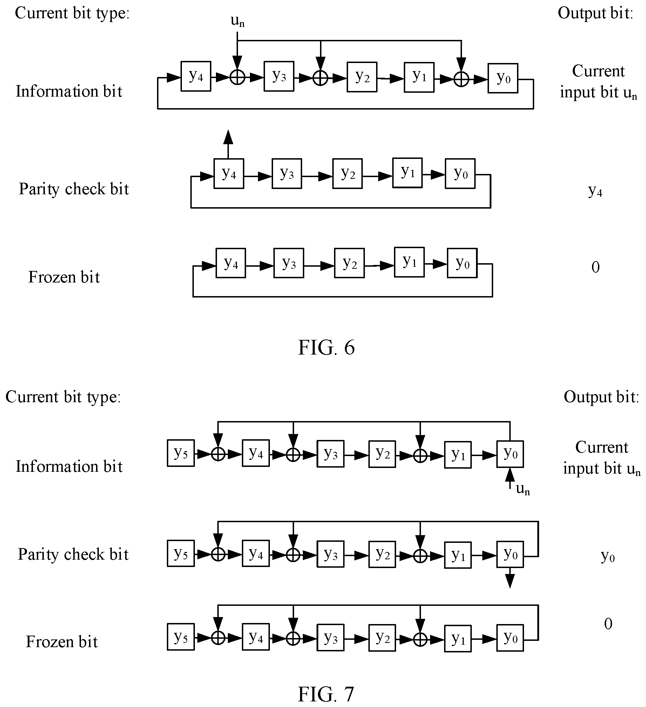

For example, pseudocode of the precoded sequence generated by the first communication apparatus is shown as follows. An example in which the determined indication parameter of the target PC equation is 26 is used. A shift register used may be shown in FIG. 6. When the indication parameter of the target PC equation is 26, its binary representation is [1 1 0 1 0] (where the leftmost bit is the most significant bit), and the target PC equation is D⁴+D³+D¹, that is, tap positions are y₄, y₃, and y₁. L is the highest power exponent of the target PC equation, for example, D⁴+D³+D¹ corresponds to L = 4. In this case, a number of shift registers is 5.

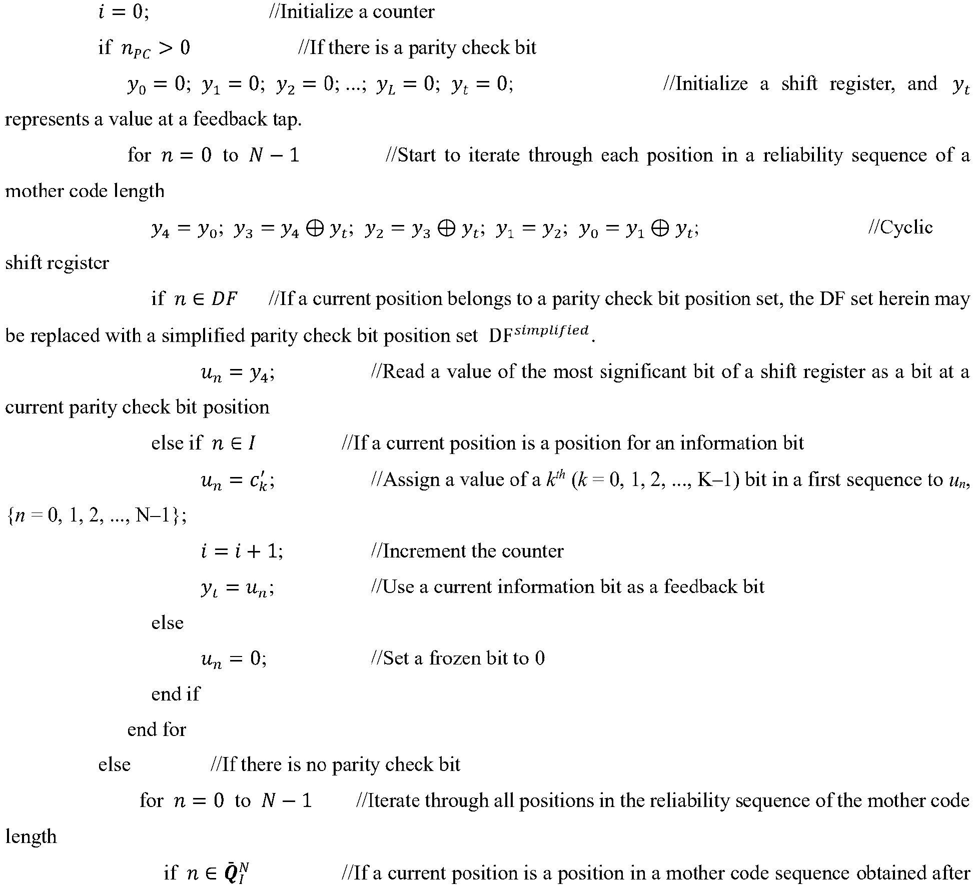

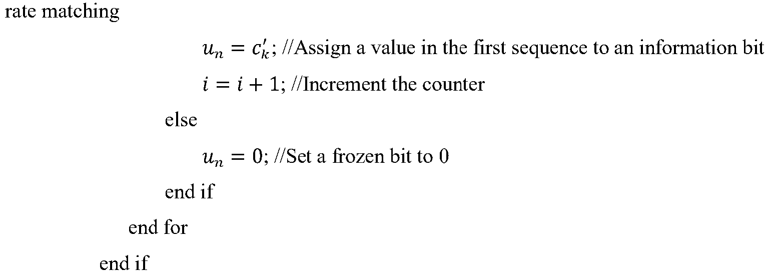

### Example 2:

In the first correspondence, a corresponding number of first parity check bits is determined for each message length and each transmission code length. In the second correspondence, a corresponding indication parameter of a PC equation is determined for each message length and each transmission code length.

In the first correspondence, one message length and one transmission code length correspond to one number of first parity check bits. When message lengths and/or transmission code lengths are different, corresponding numbers of first parity check bits may be the same or different. In the second correspondence, one message length and one transmission code length correspond to one indication parameter of a PC equation. When message lengths and/or transmission code lengths are different, corresponding indication parameters of PC equations may be the same or different.

Optionally, in the first correspondence, a number of first parity check bits corresponding to one message length and one transmission code length is not greater than a difference between the corresponding transmission code length and the corresponding message length.

For example, among a plurality of correspondences shown in Table 4, each correspondence is a correspondence among one message length k, one transmission code length e, and one number of first parity check bits. In Table 4, a value determined based on the intersection between a row corresponding to a message length k and a column corresponding to a transmission code length e is taken as a number of first parity check bits. For example, when k = 3 and e = 32, a corresponding number of first parity check bits is 2. In another example, when k = 6 and e = 23, a corresponding number of first parity check bits is 3.

Optionally, the first correspondence in an embodiment of this application may include at least one correspondence in Table 4.

In Table 4, an example in which a value range of k is 3 to 11 and a value range of e is 4 to 32 is used.

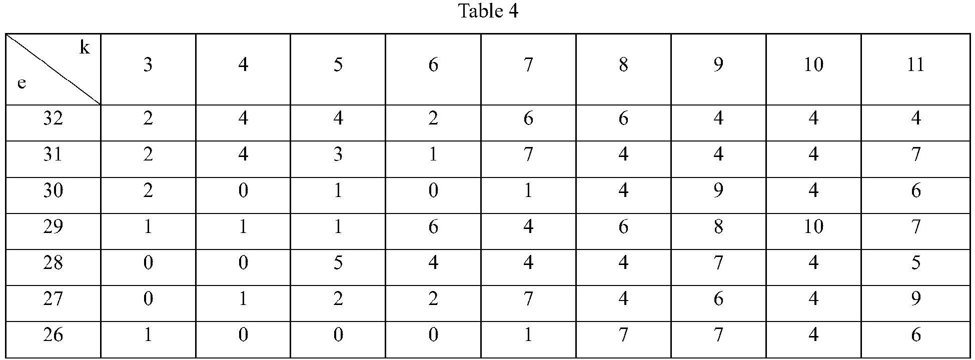

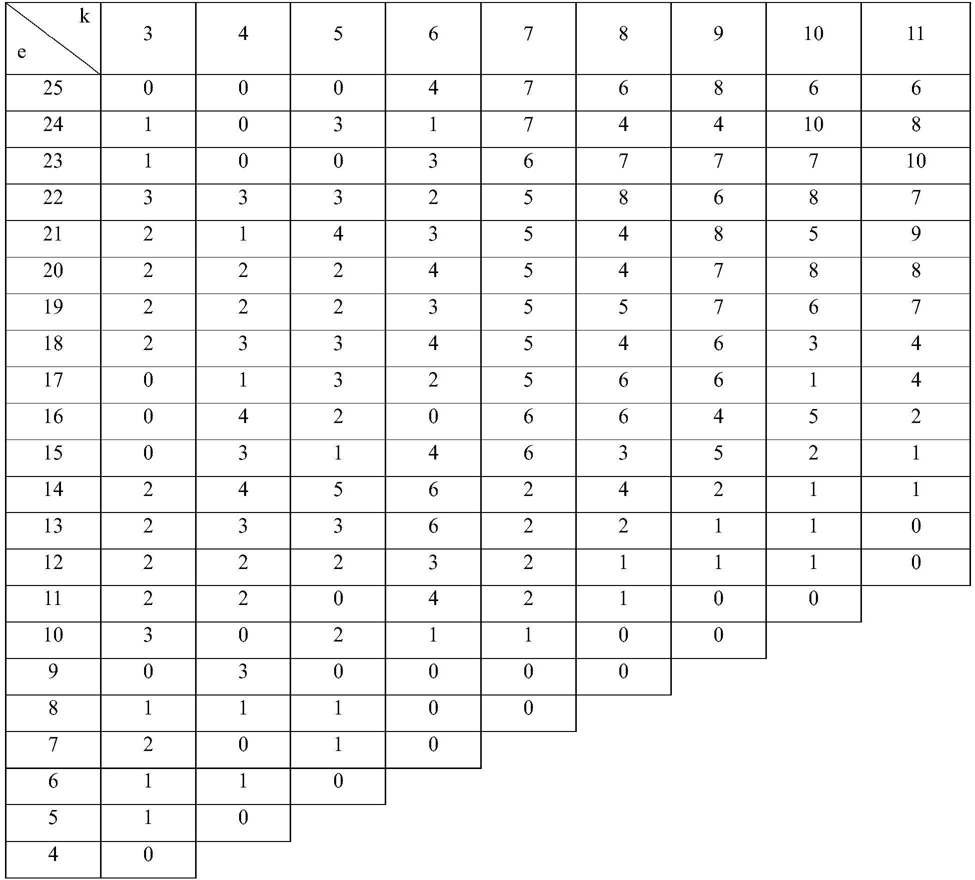

For example, among a plurality of correspondences shown in Table 5, each correspondence is a correspondence among one message length k, one transmission code length e, and one indication parameter of a PC equation. In Table 5, a value determined based on the intersection between a row corresponding to a message length k and a column corresponding to a transmission code length e is taken as an indication parameter of a PC equation. For example, when k = 3 and e = 32, a corresponding indication parameter of a PC equation is 88. In another example, when k = 5 and e = 10, a corresponding indication parameter of a PC equation is 70.

Optionally, the second correspondence in an embodiment of this application may include at least one correspondence in Table 5.

In Table 5, an example in which a value range of k is 3 to 11 and a value range of e is 4 to 32 is used.

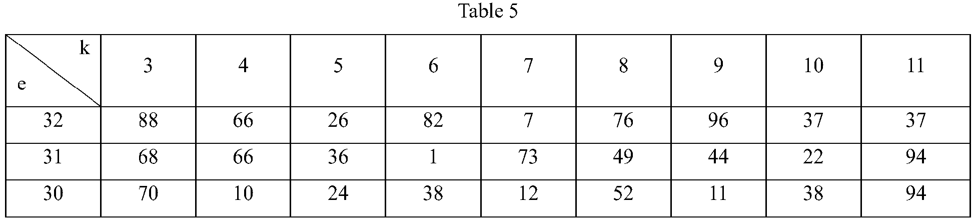

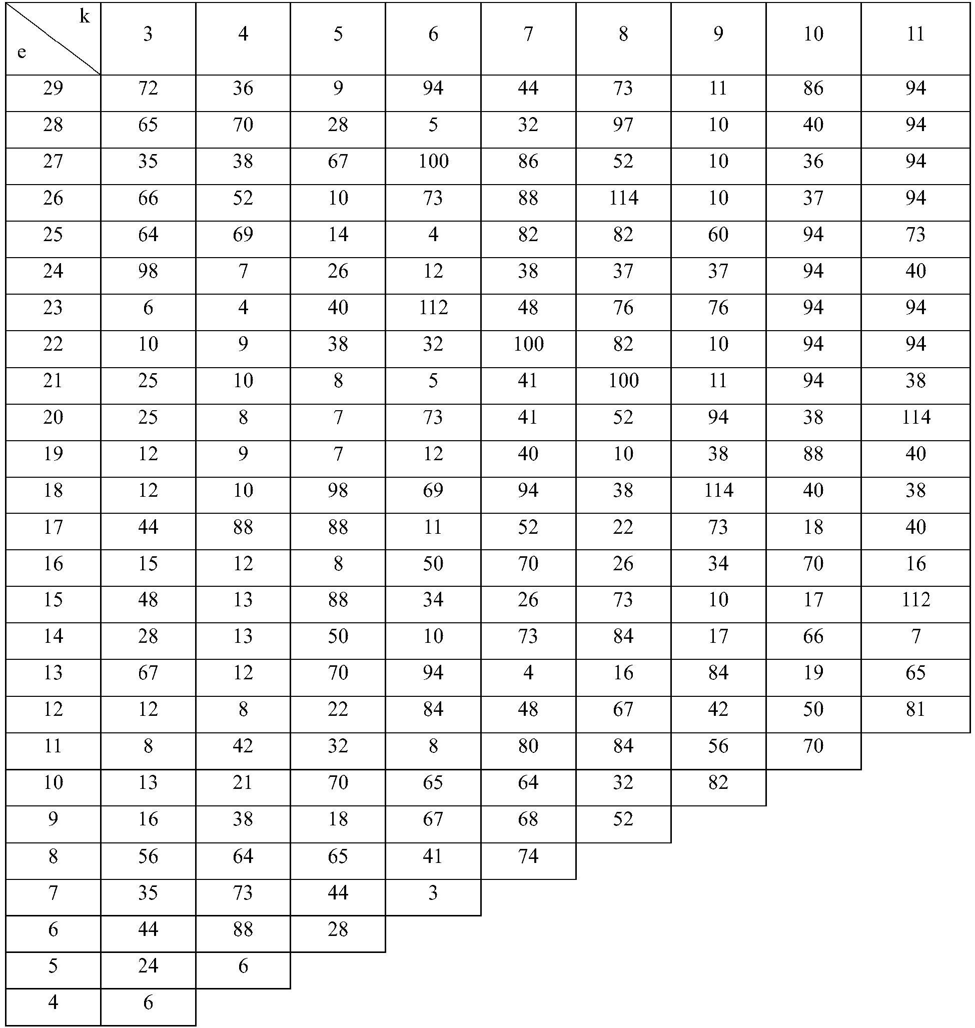

Alternatively, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

In a plurality of correspondences shown in Table 6, each correspondence is a correspondence among one message length k, one transmission code length e, one number of first parity check bits, and one indication parameter of a PC equation. In Table 6, values determined based on a row in which a message length k is located and a column in which a transmission code length e is located are a number n of first parity check bits and an indication parameter p of a PC equation. For example, when k = 3 and e = 32, a corresponding number of first parity check bits is 2, and a corresponding indication parameter of a PC equation is 88. In another example, when k = 4 and e = 22, a corresponding number of first parity check bits is 3, and a corresponding indication parameter of a PC equation is 9.

Optionally, the target correspondence in an embodiment of this application may include at least one correspondence in Table 6, where the target correspondence includes the first correspondence and the second correspondence.

In Table 6, an example in which a value range of k is 3 to 11 and a value range of e is 4 to 32 is used.

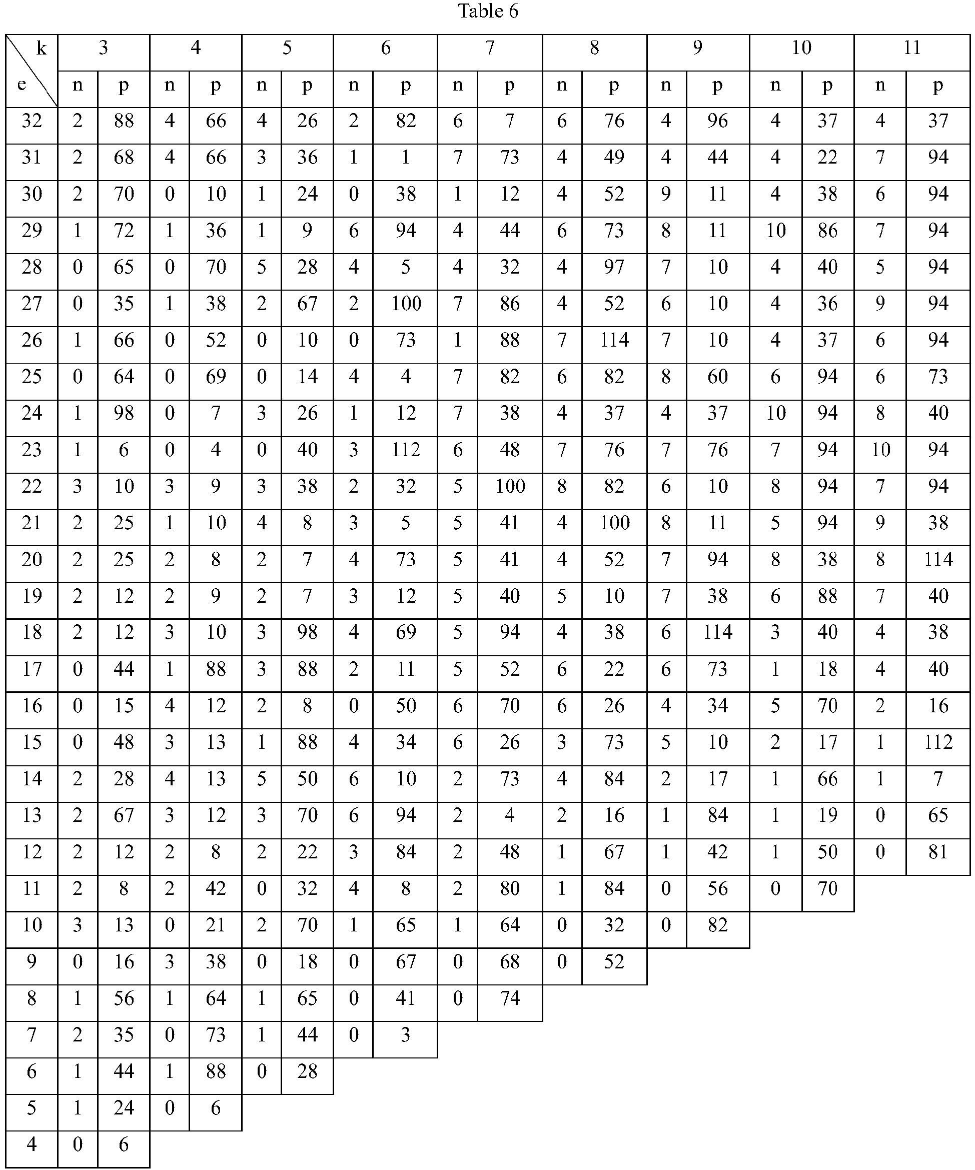

Based on the correspondence among the message length k, the transmission code length e, the number n of first parity check bits, and the indication parameter p of the PC equation in Example 2, after determining the number ${n}_{PC}^{wm}$ of first parity check bits and the indication parameter of the target PC equation based on the length K of the first sequence and the target transmission code length E, the first communication apparatus generates a precoded sequence based on the determined position for the information bit and the determined position for the parity check bit in the mother code sequence.

For example, pseudocode of the precoded sequence generated by the first communication apparatus is shown as follows. An example in which the determined indication parameter of the target PC equation is 52 is used. A shift register used may be shown in FIG. 7. When the indication parameter of the target PC equation is 26, its binary representation is [1 1 0 1 0 0] (where the leftmost bit is the most significant bit), and the target PC equation is D⁵+D⁴+D², that is, tap positions are y₅, y₄, and y₂. L is the highest power exponent of the target PC equation, for example, D⁵+D⁴+D² corresponds to L = 5. In this case, a number of shift registers is 6.

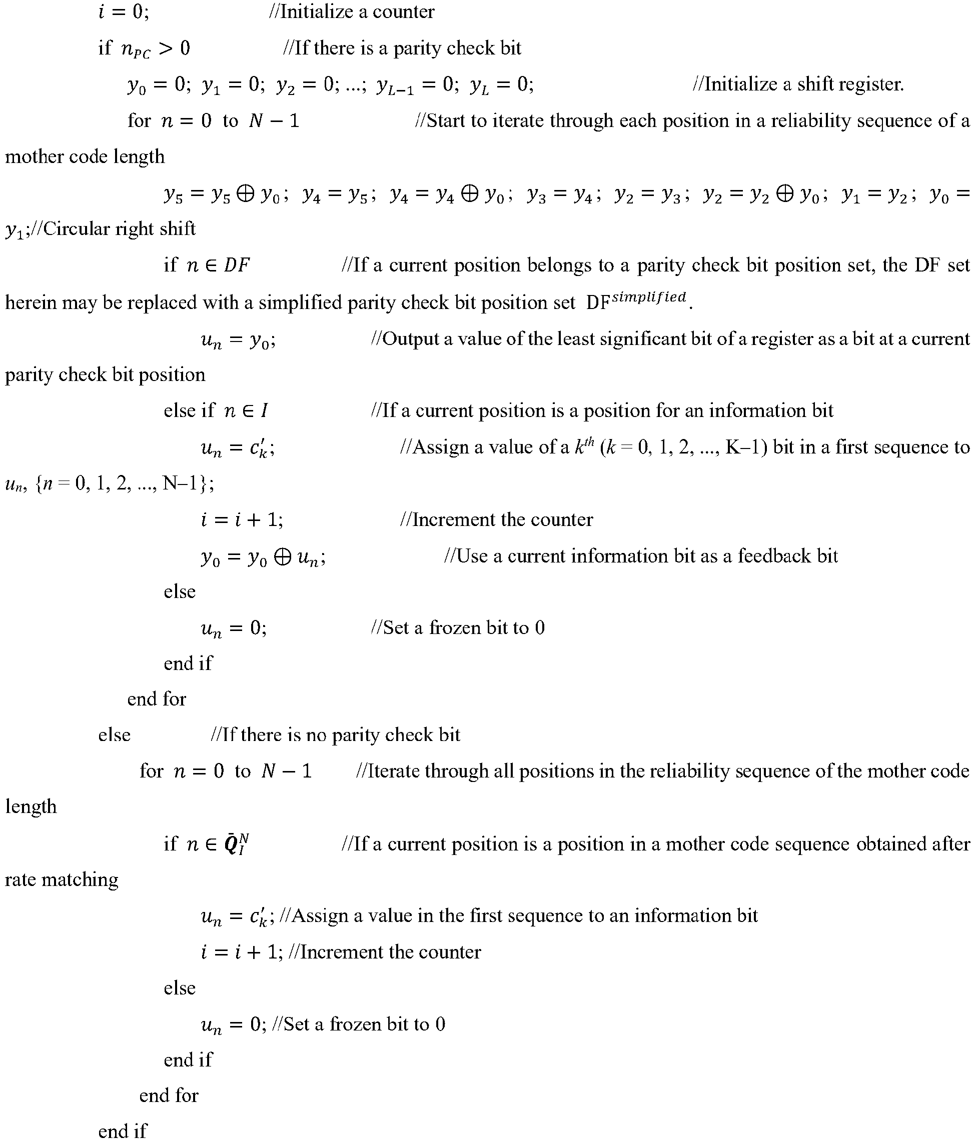

In addition, in an embodiment of this application, a number of effective parity check bits corresponding to the length K of the first sequence and the target transmission code length E is less than or equal to a specified threshold. It may be understood that an upper limit value of the number of effective parity check bits corresponding to the length K of the first sequence and the target transmission code length E is the specified threshold.

When message lengths and/or transmission code lengths are different, specified thresholds corresponding to effective parity check bits may also be different. For example, when a message length k is 11 and a transmission code length e is 32, a specified threshold corresponding to a number of effective parity check bits is 10 (that is, when k = 11 and e = 32, the number of effective parity check bits in the mother code sequence is less than or equal to 10). When a message length k is 9 and a transmission code length e is 30, a specified threshold corresponding to a number of effective parity check bits is 12 (that is, when k = 9 and e = 30, the number of effective parity check bits in the mother code sequence is less than or equal to 12).

Optionally, the third correspondence includes a correspondence among a message length k, a transmission code length e, and a specified threshold corresponding to a number of effective parity check bits.

For example, among a plurality of correspondences shown in Table 7, each correspondence is a correspondence among one message length k, one transmission code length e, and one specified threshold corresponding to a number of effective parity check bits. In Table 7, a value determined based on the intersection between a row corresponding to a message length k and a column corresponding to a transmission code length e is taken as a specified threshold corresponding to a number of effective parity check bits. For example, when k = 3 and e = 32, a specified threshold corresponding to a number of effective parity check bits is 6. In another example, when k = 5 and e = 10, a specified threshold corresponding to a number of effective parity check bits is 3.

Optionally, the third correspondence in an embodiment of this application may include at least one correspondence in Table 7.

In Table 7, an example in which a value range of k is 3 to 11 and a value range of e is 4 to 32 is used.

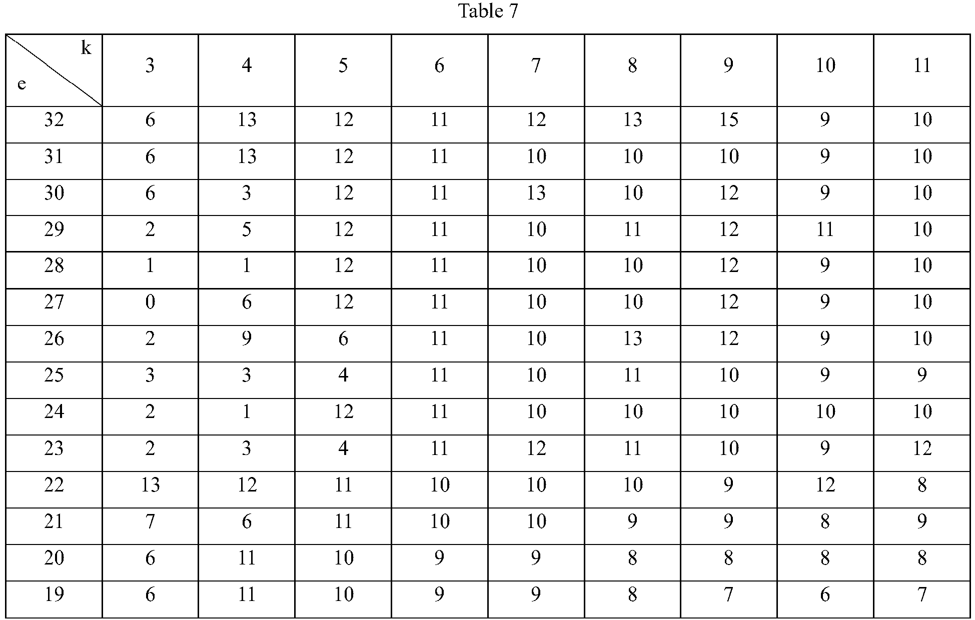

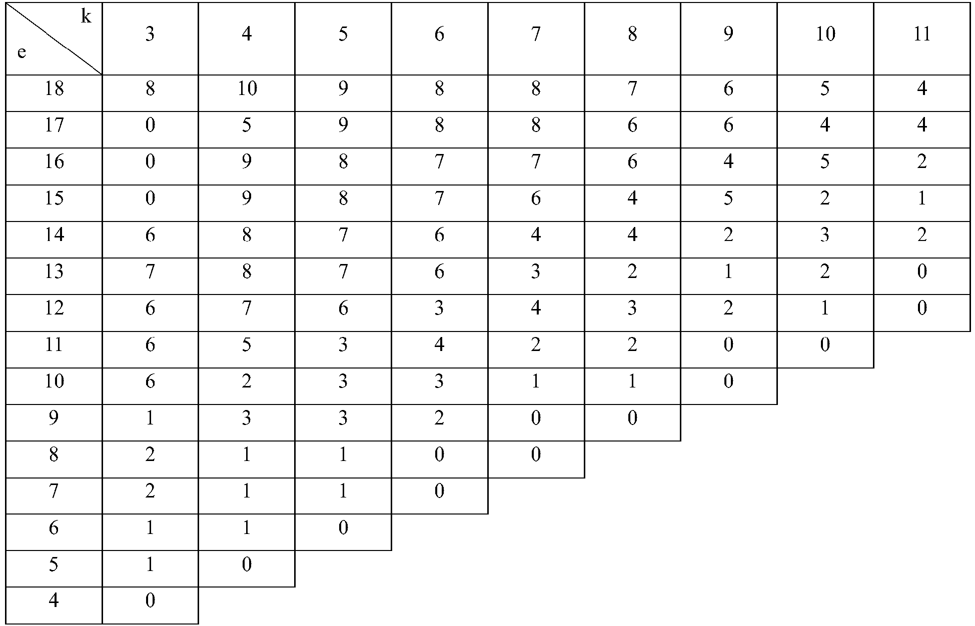

It should be noted that the third correspondence shown in Table 7 may be further combined randomly with the first correspondence and the second correspondence into one table. For example, a table includes a correspondence among a message length k, a transmission code length e, a number of first parity check bits, an indication parameter of a PC equation, and a specified threshold corresponding to a number of effective parity check bits. In another example, a table includes a correspondence among a message length k, a transmission code length e, a number of first parity check bits, and a specified threshold corresponding to a number of effective parity check bits.

In Example 1 and Example 2, a corresponding number of first parity check bits and a corresponding indication parameter of a PC equation are separately designed for each group of message length and transmission code length. In addition, in an embodiment of this application, a corresponding number of first parity check bits and a corresponding indication parameter of a PC equation may be further designed for message lengths and/or transmission code lengths within different ranges.

Optionally, in the first correspondence, for a message length within a first length range, same message lengths correspond to a same number of first parity check bits; and in the second correspondence, for a message length within a first length range, same message lengths correspond to a same indication parameter of a PC equation.

For example, the first length range includes a first threshold value 3 and a second threshold value 6, that is, the first length range is 3 to 6. For the message length within the first length range, when message lengths are the same and transmission code lengths are different, corresponding numbers of first parity check bits are the same, and when message lengths are the same and transmission code lengths are different, corresponding indication parameters of PC equations are the same.

The following describes this correspondence with reference to a plurality of examples.

### Example 3:

In this example, in the first correspondence, same message lengths within a first length range correspond to a same number of first parity check bits; in the second correspondence, same message lengths within the first length range correspond to a same indication parameter of a PC equation; in the first correspondence, different message lengths within the first length range correspond to different numbers of first parity check bits; and/or in the second correspondence, different message lengths within the first length range correspond to different indication parameters of PC equations.

For ease of description, numbers of first parity check bits and indication parameters of PC equations corresponding to same message lengths and transmission code lengths are referred to as a group of PC parameters below. For example, when a message length is 3 and a transmission code length is 32, a corresponding number of first parity check bits is 0, and a corresponding indication parameter of a PC equation is 26. In this case, the number 0 of first parity check bits and the indication parameter 26 of the PC equation may be referred to as a group of PC parameters.

In this example, a group of PC parameters is used for each message length within the first length range, and different message lengths within the first length range correspond to different groups of PC parameters. For example, the first length range includes a first threshold value 3 and a second threshold value 6, that is, the first length range is 3 to 6.

It should be noted that different groups of PC parameters may include different numbers of first parity check bits and/or different indication parameters of PC equations.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

When a message length k is 7, a transmission code length may be divided into two segments according to e-k, and each segment corresponds to a group of PC parameters. For example, 1 ≤e-k≤8 corresponds to a group of PC parameters, and 9 ≤e-k≤ 25 corresponds to a group of PC parameters.

When a message length k is 8, a transmission code length may be divided into three segments according to e-k, and each segment corresponds to a group of PC parameters. For example, 1 ≤e-k≤7 corresponds to a group of PC parameters, 8≤e-k≤ 9 corresponds to a group of PC parameters, and 10≤e-k≤ 24 corresponds to a group of PC parameters.

When a message length k is 9, a transmission code length may be divided into three segments according to e-k, and each segment corresponds to a group of PC parameters. For example, 1 ≤e-k≤ 7 corresponds to a group of PC parameters, 8≤e-k≤ 10 corresponds to a group of PC parameters, and 11≤e-k≤ 23 corresponds to a group of PC parameters.

When a message length k is 10, a transmission code length may be divided into two segments according to e-k, and each segment corresponds to a group of PC parameters. For example, 1 ≤e-k≤7 corresponds to a group of PC parameters, and 8≤e-k≤ 22 corresponds to a group of PC parameters.

When a message length k is 11, a transmission code length may be divided into three segments according to e-k, and each segment corresponds to a group of PC parameters. For example, 1 ≤e-k≤7 corresponds to a group of PC parameters, 8≤e-k≤ 10 and 15≤e-k≤ 21 correspond to a group of PC parameters, and 11 ≤e-k≤ 14 corresponds to a group of PC parameters.

Optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 8, each correspondence is a correspondence among one message length k, one transmission code length e, one number of first parity check bits, and one indication parameter of a PC equation. In Table 8, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 26. In another example, when k = 8 and e = 29, a corresponding number of first parity check bits is 4, and a corresponding indication parameter of a PC equation is 17.

Optionally, the target correspondence in an embodiment of this application may include at least one correspondence in Table 8, where the target correspondence includes the first correspondence and the second correspondence.

In Table 8, an example in which a value range of k is 3 to 11 and a value range of e is 4 to 32 is used.

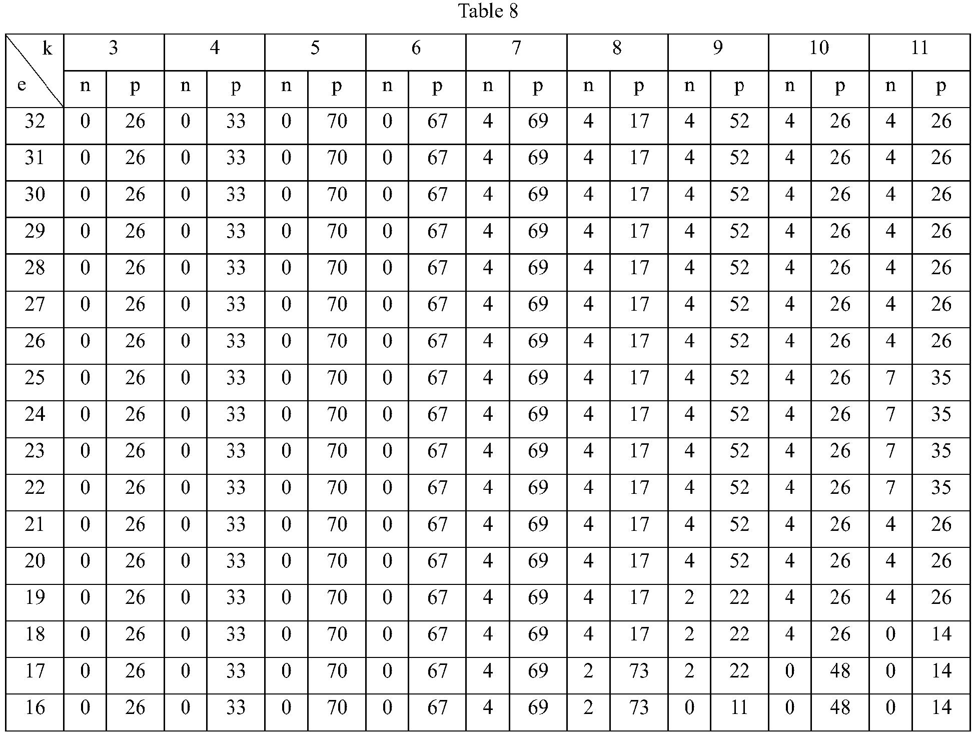

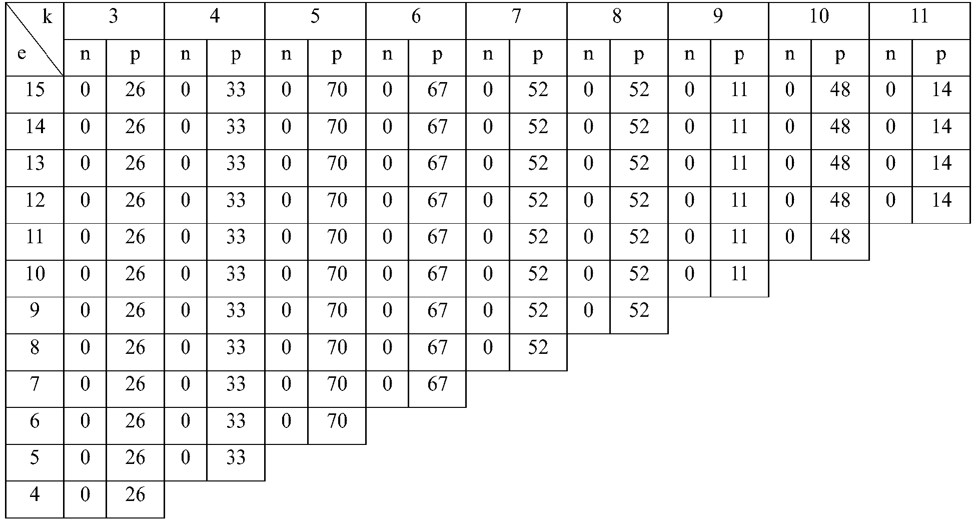

It should be noted that Table 8 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

In addition, in an embodiment of this application, a number of effective parity check bits corresponding to the length K of the first sequence and the target transmission code length E is less than or equal to a specified threshold. It may be understood that an upper limit value of the number of effective parity check bits corresponding to the length K of the first sequence and the target transmission code length E is the specified threshold.

When message lengths and/or transmission code lengths are different, specified thresholds corresponding to effective parity check bits may also be different. For example, when a message length k is 11 and a transmission code length e is 32, a specified threshold corresponding to a number of effective parity check bits is 9 (that is, when k = 11 and e = 32, the number of effective parity check bits is less than or equal to 9). When a message length k is 9 and a transmission code length e is 30, a specified threshold corresponding to a number of effective parity check bits is 10 (that is, when k = 9 and e = 30, the number of effective parity check bits is less than or equal to 10).

Optionally, the third correspondence includes a correspondence among a message length k, a transmission code length e, and a specified threshold corresponding to a number of effective parity check bits.

For example, among a plurality of correspondences shown in Table 9, each correspondence is a correspondence among one message length k, one transmission code length e, and one specified threshold corresponding to a number of effective parity check bits. In Table 9, a value determined based on the intersection between a row corresponding to a message length k and a column corresponding to a transmission code length e is taken as a specified threshold corresponding to a number of effective parity check bits. For example, when k = 3 and e = 32, a specified threshold corresponding to a number of effective parity check bits is 0. In another example, when k = 5 and e = 10, a specified threshold corresponding to a number of effective parity check bits is 2.

Optionally, the third correspondence in an embodiment of this application may include at least one correspondence in Table 9.

In Table 9, an example in which a value range of k is 3 to 11 and a value range of e is 4 to 32 is used.

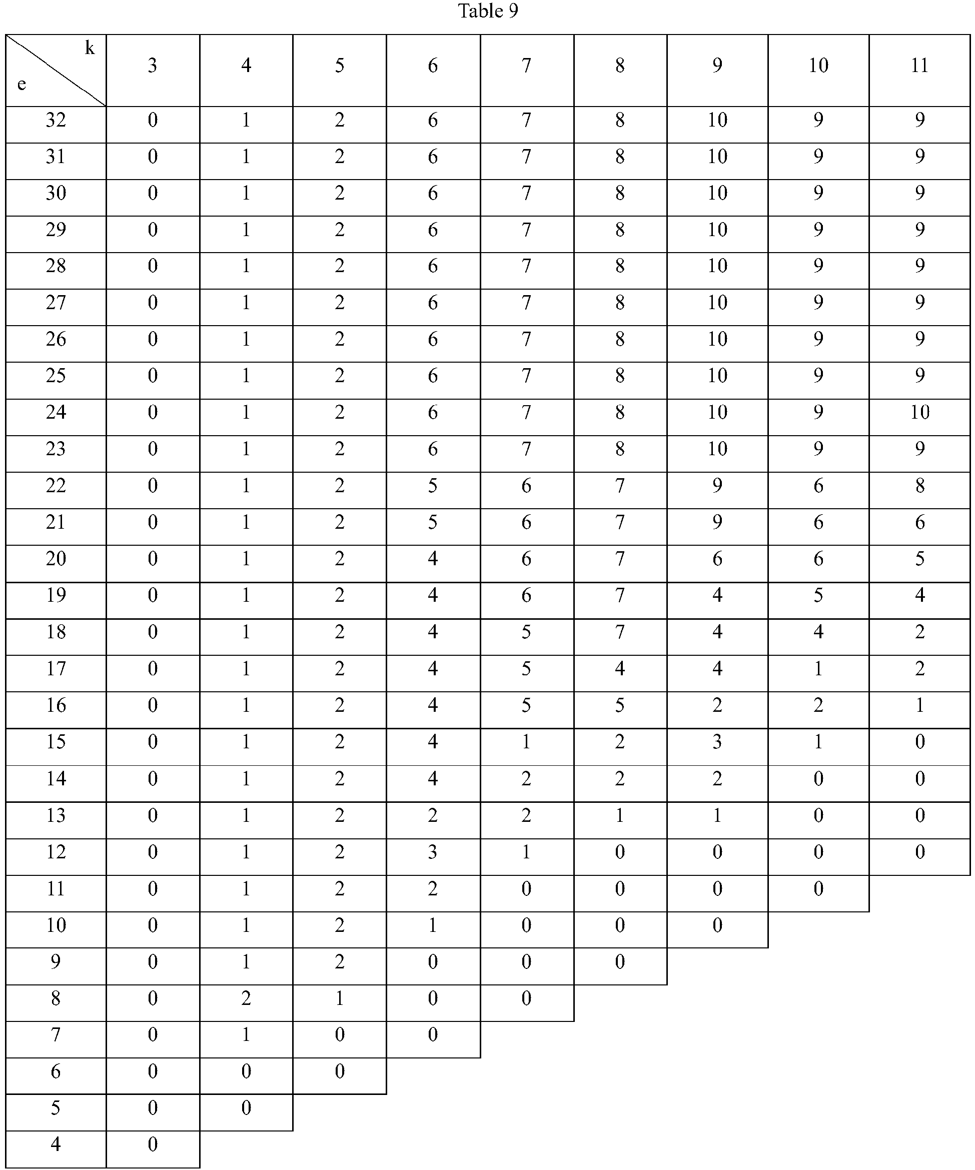

It should be noted that the third correspondence shown in Table 9 may be further combined randomly with the first correspondence and the second correspondence shown in Table 8 into one table. For example, a table includes a correspondence among a message length k, a transmission code length e, a number of first parity check bits, an indication parameter of a PC equation, and a specified threshold corresponding to a number of effective parity check bits. In another example, a table includes a correspondence among a message length k, a transmission code length e, a number of first parity check bits, and a specified threshold corresponding to a number of effective parity check bits.

### Example 4:

In this example, in the first correspondence, same message lengths within a first length range correspond to a same number of first parity check bits; in the second correspondence, same message lengths within the first length range correspond to a same indication parameter of a PC equation; in the first correspondence, all message lengths within the first length range correspond to a same number of first parity check bits; and in the second correspondence, all message lengths within the first length range correspond to a same indication parameter of a PC equation.

In this example, a group of PC parameters is used for all message lengths within the first length range. For example, the first length range includes a first threshold value 3 and a second threshold value 6, that is, the first length range is 3 to 6.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

When a message length k is 7, a transmission code length may be divided into three segments according to e-k, and each segment corresponds to a group of PC parameters. For example, 12≤e-k≤ 25 corresponds to a group of PC parameters, 9≤e-k≤ 11 corresponds to a group of PC parameters, and 1≤e-k≤8 corresponds to a group of PC parameters that are the same as PC parameters corresponding to 3 ≤k≤ 6.

When a message length k is 8, a transmission code length may be divided into three segments according to e-k, and each segment corresponds to a group of PC parameters. For example, 10 ≤e-k≤ 24 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

When a message length k is 9, a transmission code length may be divided into three segments according to e-k, and each segment corresponds to a group of PC parameters. For example, 10 ≤e-k≤ 23 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤k≤ 6.

When a message length k is 9, a transmission code length may be divided into three segments according to e-k, and each segment corresponds to a group of PC parameters. For example, 10 ≤e-k≤ 22 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

When a message length k is 9, a transmission code length may be divided into three segments according to e-k, and each segment corresponds to a group of PC parameters. For example, 10 ≤e-k≤ 21 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

Herein, k = 7 and 9≤e-k≤ 11, k = 10 and 8≤e-k≤ 9, and k = 11 and 8≤e-k≤ 9 may correspond to a same group of PC parameters; and 7 ≤k≤ 11 and 21 ≤e≤ 32 may correspond to a same group of PC parameters.

Optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 10, each correspondence is a correspondence among one message length k, one transmission code length e, one number of first parity check bits, and one indication parameter of a PC equation. In Table 10, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 52. In another example, when k = 8 and e = 29, a corresponding number of first parity check bits is 4, and a corresponding indication parameter of a PC equation is 52.

Optionally, the target correspondence in an embodiment of this application may include at least one correspondence in Table 10, where the target correspondence includes the first correspondence and the second correspondence.

In Table 10, an example in which a value range of k is 3 to 11 and a value range of e is 4 to 32 is used.

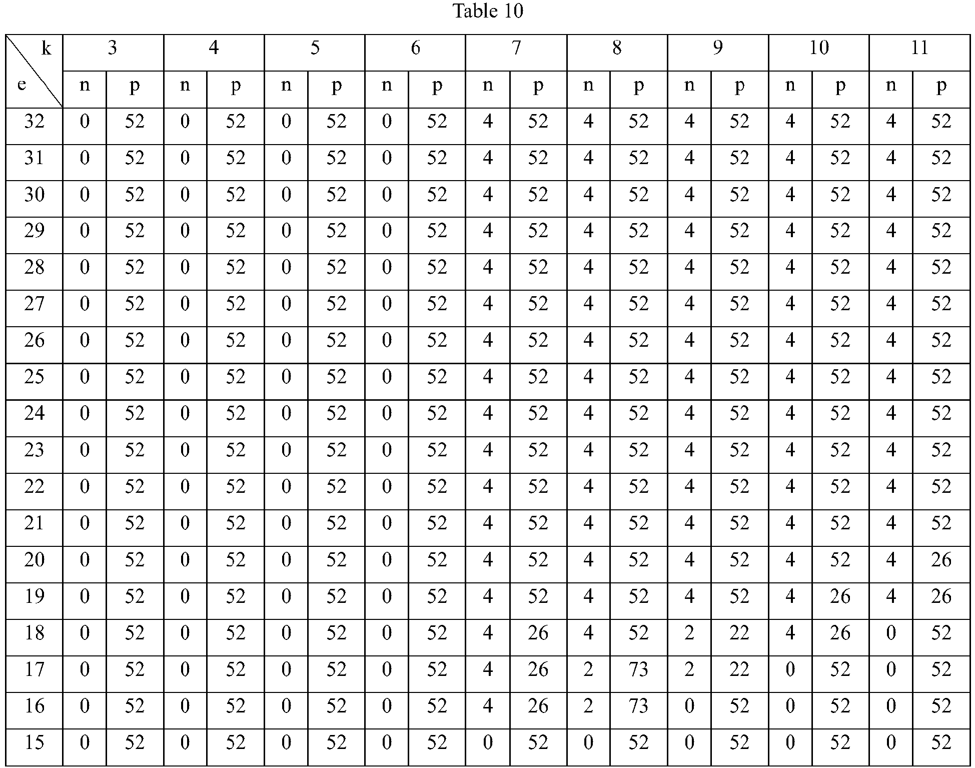

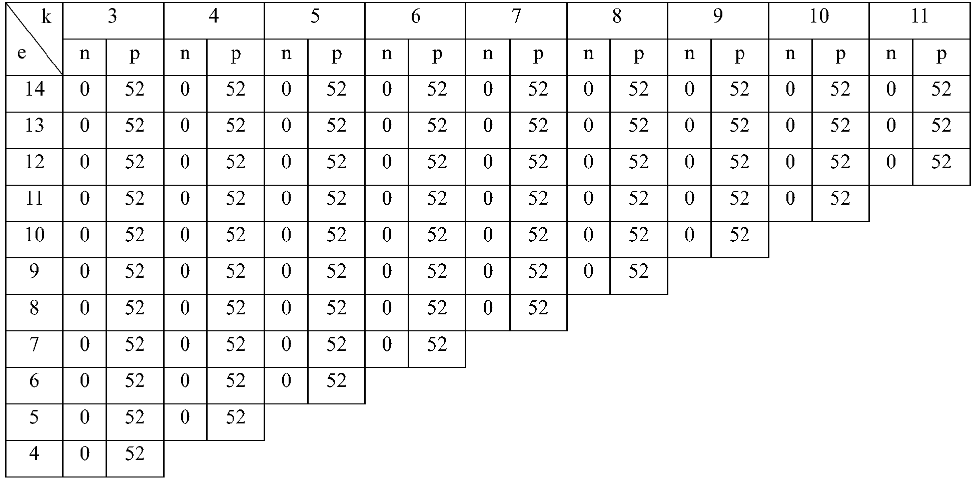

It should be noted that Table 10 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

### Example 5:

In this example, in the first correspondence, same message lengths within a first length range correspond to a same number of first parity check bits; in the second correspondence, same message lengths within the first length range correspond to a same indication parameter of a PC equation; in the first correspondence, all message lengths within the first length range correspond to a same number of first parity check bits; and in the second correspondence, all message lengths within the first length range correspond to a same indication parameter of a PC equation.

In this example, a group of PC parameters is used for all message lengths within the first length range. For example, the first length range includes a first threshold value 3 and a second threshold value 6, that is, the first length range is 3 to 6.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

When a message length k is 7, a transmission code length may be divided into four segments according to e-k, and each segment corresponds to a group of PC parameters. For example, 12≤e-k≤ 25 corresponds to a group of PC parameters, 10≤e-k≤ 11 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤ k ≤ 6.

When a message length k is 8, a transmission code length may be divided into three segments according to e-k, and each segment corresponds to a group of PC parameters. For example, 10 ≤e-k≤ 24 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

When a message length k is 9, a transmission code length may be divided into three segments according to e-k, and each segment corresponds to a group of PC parameters. For example, 10 ≤e-k≤ 23 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

When a message length k is 10, a transmission code length may be divided into three segments according to e-k, and each segment corresponds to a group of PC parameters. For example, 10 ≤e-k≤ 22 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

When a message length k is 11, a transmission code length may be divided into three segments according to e-k, and each segment corresponds to a group of PC parameters. For example, 10 ≤e-k≤ 21 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤K≤ 6.

Herein, K = 7 and 8≤e-k≤ 9, K = 8 and 8≤e-k≤ 9, K = 9 and 8≤e-k≤ 9, and K = 10 and 8≤e-k≤ 9 may correspond to a same group of PC parameters; K = 7 and 10≤e-k≤ 11, and K = 11 and 8≤e-k≤ 9 may correspond to a same group of PC parameters; and 7 ≤k≤ 11 and 21 ≤e≤ 32 may correspond to a same group of PC parameters.

Optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 11, each correspondence is a correspondence among one message length k, one transmission code length e, one number of first parity check bits, and one indication parameter of a PC equation. In Table 11, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 52. In another example, when k = 8 and e = 29, a corresponding number of first parity check bits is 4, and a corresponding indication parameter of a PC equation is 52.

Optionally, the target correspondence in an embodiment of this application may include at least one correspondence in Table 11, where the target correspondence includes the first correspondence and the second correspondence.

In Table 11, an example in which a value range of k is 3 to 11 and a value range of e is 4 to 32 is used.

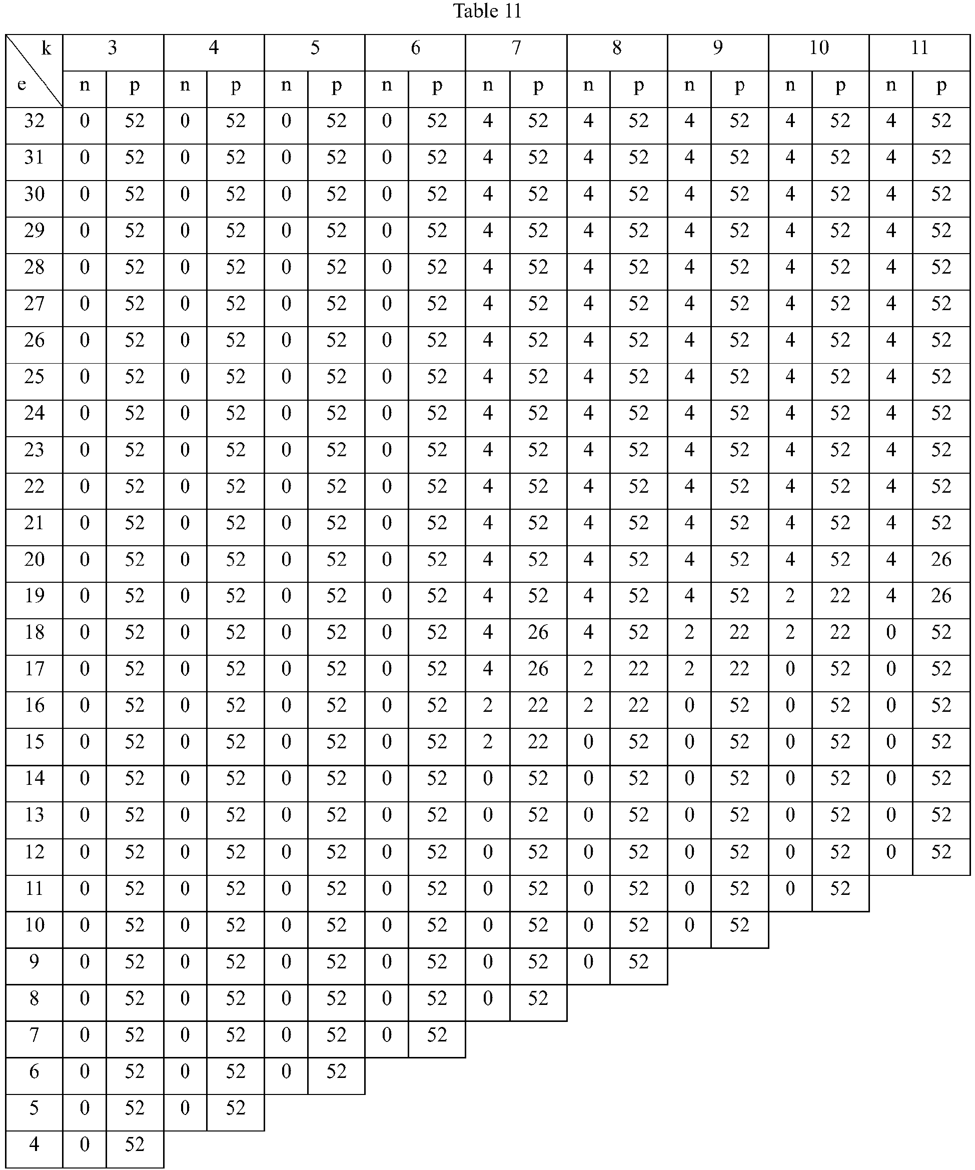

It should be noted that Table 11 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

### Example 6:

In this example, in the first correspondence, same message lengths within a first length range correspond to a same number of first parity check bits; in the second correspondence, same message lengths within the first length range correspond to a same indication parameter of a PC equation; in the first correspondence, all message lengths within the first length range correspond to a same number of first parity check bits; and in the second correspondence, all message lengths within the first length range correspond to a same indication parameter of a PC equation.

In this example, a group of PC parameters is used for all message lengths within the first length range. For example, the first length range includes a first threshold value 3 and a second threshold value 6, that is, the first length range is 3 to 6.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

When a message length k is 7, a transmission code length may be divided into three segments according to e-k, and each segment corresponds to a group of PC parameters. For example, 12≤e-k≤ 25 corresponds to a group of PC parameters, 9≤e-k≤ 11 corresponds to a group of PC parameters, and 1≤e-k≤ 8 corresponds to a group of PC parameters that are the same as PC parameters corresponding to 3 ≤k≤ 6.

When a message length k is 8, a transmission code length may be divided into three segments according to e-k, and each segment corresponds to a group of PC parameters. For example, 10 ≤e-k≤ 24 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤k≤ 6.

When a message length k is 9, a transmission code length may be divided into three segments according to e-k, and each segment corresponds to a group of PC parameters. For example, 10 ≤e-k≤ 23 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤k≤ 6.

When a message length k is 10, a transmission code length may be divided into three segments according to e-k, and each segment corresponds to a group of PC parameters. For example, 10 ≤e-k≤ 22 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤k≤ 6.

When a message length k is 11, a transmission code length may be divided into three segments according to e-k, and each segment corresponds to a group of PC parameters. 10 ≤e-k≤ 21 corresponds to a group of PC parameters, 8≤e-k≤ 9 corresponds to a group of PC parameters, and 1≤e-k≤ 7 corresponds to a group of PC parameters that are the same as PC parameters corresponding to 3 ≤k≤ 6.

Herein, k = 7 and 9≤e-k≤ 11, k = 10 and 8≤e-k≤ 9, and k = 11 and 8≤e-k≤ 9 may correspond to a same group of PC parameters; k = 8 and 8≤e-k≤ 9, and k = 9 and 8≤e-k≤ 9 may correspond to a same group of PC parameters; and 7 ≤k≤ 11 and 21 ≤e≤ 32 may correspond to a same group of PC parameters.

For example, optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 12, each correspondence is a correspondence among one message length k, one transmission code length e, one number of first parity check bits, and one indication parameter of a PC equation. In Table 12, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 52. In another example, when k = 8 and e = 29, a corresponding number of first parity check bits is 4, and a corresponding indication parameter of a PC equation is 52.

Optionally, the target correspondence in an embodiment of this application may include at least one correspondence in Table 12, where the target correspondence includes the first correspondence and the second correspondence.

In Table 12, an example in which a value range of k is 3 to 11 and a value range of e is 4 to 32 is used.

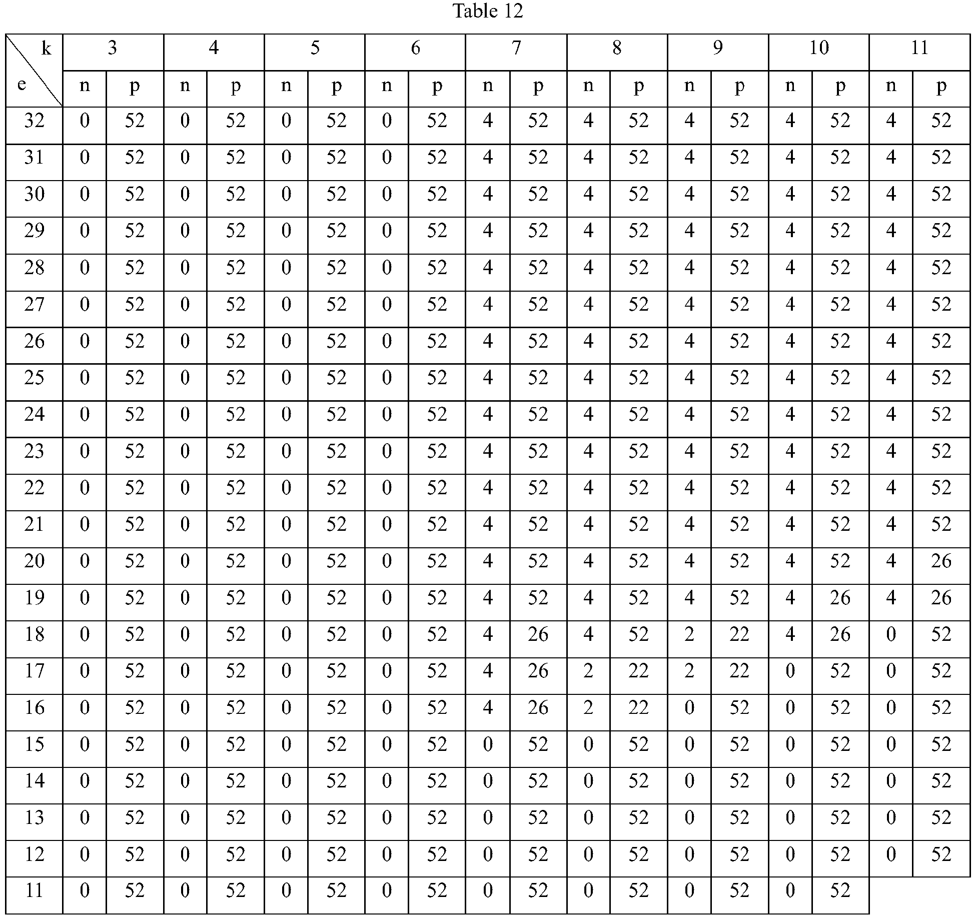

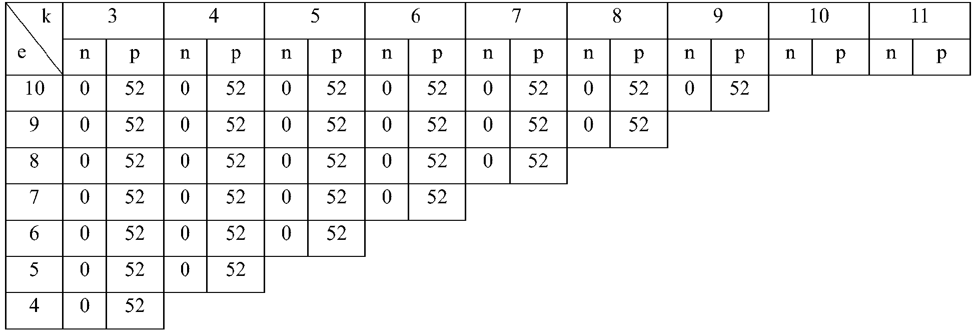

It should be noted that Table 12 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

### Example 7:

In this example, in the first correspondence, same message lengths within a first length range correspond to a same number of first parity check bits; in the second correspondence, same message lengths within the first length range correspond to a same indication parameter of a PC equation; in the first correspondence, all message lengths within the first length range correspond to a same number of first parity check bits; and in the second correspondence, all message lengths within the first length range correspond to a same indication parameter of a PC equation.

In this example, a group of PC parameters is used for all message lengths within the first length range. For example, the first length range includes a first threshold value 3 and a second threshold value 6, that is, the first length range is 3 to 6.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

When 7≤k≤ 11, a transmission code length may be divided into four segments according to e-k, and each segment corresponds to a group of PC parameters. For example, 12≤e-k≤ 25 corresponds to a group of PC parameters, 10≤e-k≤ 11 corresponds to a group of PC parameters, 8≤e-k≤ 9 corresponds to a group of PC parameters, and 1 ≤ e-k ≤ 7 corresponds to a group of PC parameters that are the same as PC parameters corresponding to 3 ≤k≤ 6.

When k = 11, 10≤e-k≤ 11 and 8≤e-k≤ 9 may be combined into one segment corresponding same PC parameters.

For example, optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 13, each correspondence is a correspondence among one message length k, one transmission code length e, one number of first parity check bits, and one indication parameter of a PC equation. In Table 13, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 52. In another example, when k = 8 and e = 29, a corresponding number of first parity check bits is 4, and a corresponding indication parameter of a PC equation is 52.

Optionally, the target correspondence in an embodiment of this application may include at least one correspondence in Table 13, where the target correspondence includes the first correspondence and the second correspondence.

In Table 13, an example in which a value range of k is 3 to 11 and a value range of e is 4 to 32 is used.

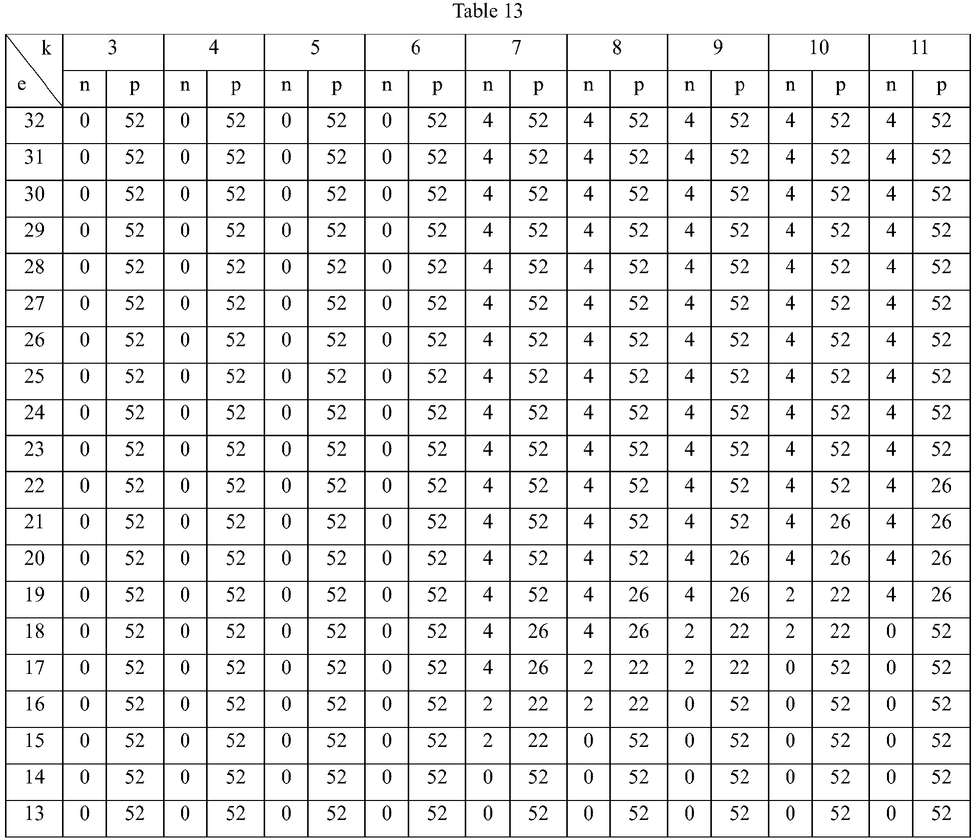

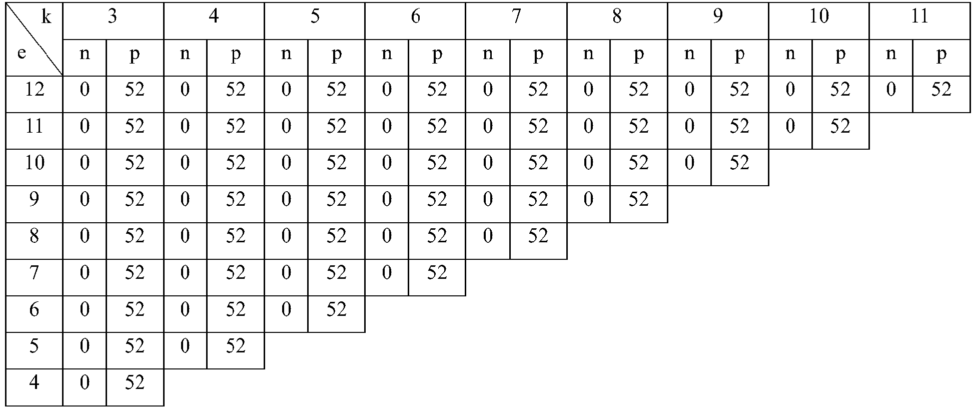

It should be noted that Table 13 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

### Example 8:

In this example, in the first correspondence, same message lengths within a first length range correspond to a same number of first parity check bits; in the second correspondence, same message lengths within the first length range correspond to a same indication parameter of a PC equation; in the first correspondence, all message lengths within the first length range correspond to a same number of first parity check bits; and in the second correspondence, all message lengths within the first length range correspond to a same indication parameter of a PC equation.

In this example, a group of PC parameters is used for all message lengths within the first length range. For example, the first length range includes a first threshold value 3 and a second threshold value 6, that is, the first length range is 3 to 6.

For a message length within a second length range, in the first correspondence, when message lengths are the same and transmission code lengths are within different code length ranges, corresponding numbers of first parity check bits are different; and/or for a message length within a second length range, in the second correspondence, when message lengths are the same and transmission code lengths are within different code length ranges, corresponding indication parameters of PC equations are different.

In an embodiment of this application, for the message length within the second length range, a transmission code length is divided into a plurality of code length ranges. When transmission code lengths are within different code length ranges, same message lengths correspond to different groups of PC parameters.

For example, the second length range includes a first threshold value 7 and a second threshold value 11, that is, the second length range is 7 to 11.

In the case of 7≤k≤ 11, when e-k≤ 7, a transmission code length does not need to be segmented according to e-k, and when e-k≥ 8, a transmission code length may be segmented according to e-k.

Optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 14, each correspondence is a correspondence among one message length k, one transmission code length e, one number of first parity check bits, and one indication parameter of a PC equation. In Table 14, values determined based on a row in which a message length k is located and a column in which a transmission code length e is located are a number n of first parity check bits and an indication parameter p of a PC equation. For example, when k = 3 and e = 32, a corresponding number of first parity check bits is 0, and a corresponding indication parameter of a PC equation is 52. In another example, when k = 8 and e = 29, a corresponding number of first parity check bits is 4, and a corresponding indication parameter of a PC equation is 26.

Optionally, the target correspondence in an embodiment of this application may include at least one correspondence in Table 14, where the target correspondence includes the first correspondence and the second correspondence.

In Table 14, an example in which a value range of k is 3 to 11 and a value range of e is 4 to 32 is used.

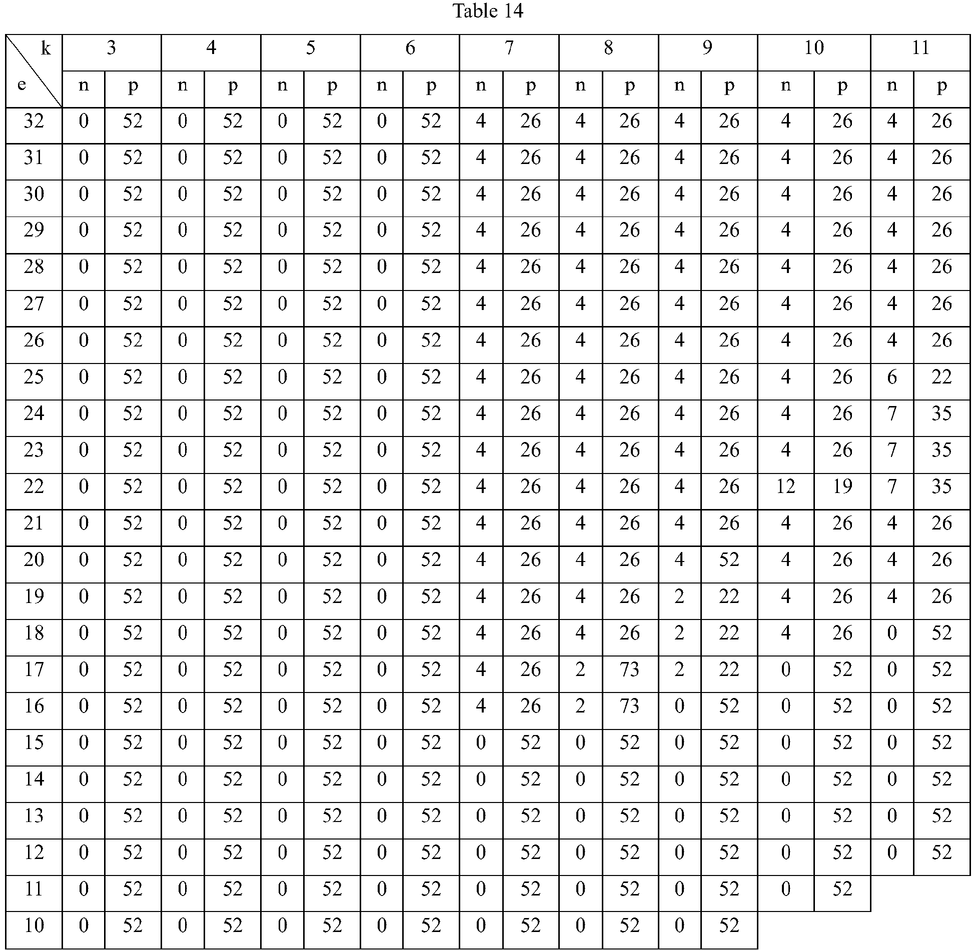

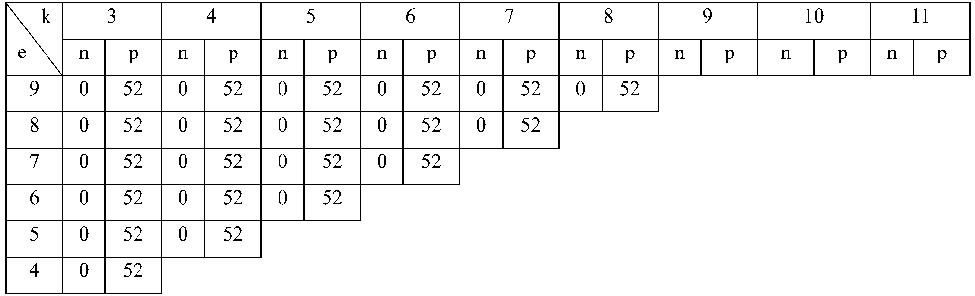

It should be noted that Table 14 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

In addition, K in embodiments of this application is a length of a first sequence obtained by the first communication apparatus, and is specifically the length of the first sequence; and k in embodiments of this application represents different message lengths, and is generally each message length. Correspondingly, E in embodiments of this application is a target transmission code length corresponding to a first sequence obtained by the first communication apparatus, and is specifically the target transmission code length corresponding to the first sequence; and e in embodiments of this application represents different transmission code lengths, and is generally each transmission code length. Correspondingly, N in embodiments of this application is a mother code length corresponding to a first sequence obtained by the first communication apparatus, and is specifically the mother code length corresponding to the first sequence; and n in embodiments of this application represents different numbers of first parity check bits, and is generally each number of first parity check bits.

In embodiments of this application, based on the foregoing plurality of designs for numbers of first parity check bits and indication parameters of PC equations corresponding to different message lengths and transmission code lengths, the first communication apparatus performs polar encoding and rate matching on a first sequence based on the number of first parity check bits and the indication parameter of the PC equation that are determined in any one of the foregoing plurality of manners, to obtain a second sequence, and the first communication apparatus sends the second sequence to the second communication apparatus. Compared with the conventional technology, the solution provided in embodiments of this application offers greatly improved transmission performance. For example, the improvement in transmission performance may be reflected in the fact that the solution provided in embodiments of this application provides a signal-to-noise ratio lower than the conventional technology when a bit error rate reaches a preset threshold. For example, when it is ensured that a bit error rate is less than 1%, a signal-to-noise ratio in the solution provided in embodiments of this application is lower than a signal-to-noise ratio in the conventional technology.

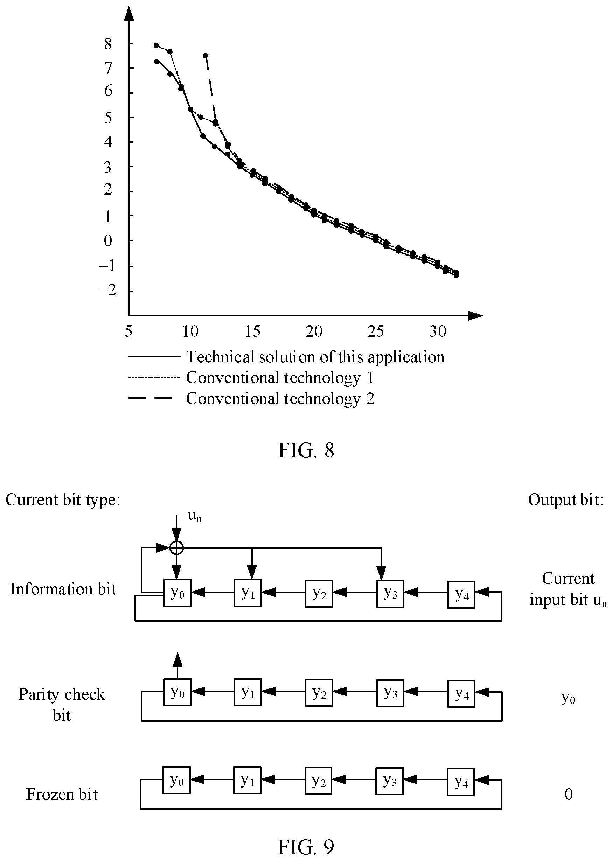

FIG. 8 is a diagram of transmission performance obtained from the solution provided in embodiments of this application, conventional technology 1, and conventional technology 2. A horizontal axis represents different transmission code lengths, and a vertical axis represents a signal-to-noise ratio when it is ensured that a bit error rate is less than 1%. For example, conventional technology 1 may be a PC-polar encoding scheme with a nested PC equation, and conventional technology 2 may be an LTE-RM code and FHT decoding scheme.

In an embodiment of this application, different message lengths and/or transmission code lengths may correspond to a same indication parameter of a PC equation. Corresponding first parity check bits may be independently designed for different message lengths and/or transmission code lengths. The following describes this correspondence with reference to Example 9.

### Example 9:

Optionally, in an embodiment of this application, the first correspondence and the second correspondence may be implemented by using a target correspondence. The target correspondence includes the first correspondence and the second correspondence. For example, the target correspondence includes a correspondence among a message length k, a transmission code length e, a number n of first parity check bits, and an indication parameter p of a PC equation.

For example, among a plurality of correspondences shown in Table 15, each correspondence is a correspondence among one message length k, one transmission code length e, one number of first parity check bits, and one indication parameter of a PC equation. In Table 15, values determined based on a row in which a message length k is located and a column in which a transmission code length e is located are a number n of first parity check bits and an indication parameter p of a PC equation. For example, an indication parameter p of a PC equation is a fixed value. For example, in Table 15, a value of an indication parameter p of a PC equation is 26. When k = 3 and e = 32, a corresponding number of first parity check bits is 3, and a corresponding indication parameter of a PC equation is 26. In another example, when k = 8 and e = 29, a corresponding number of first parity check bits is 6, and a corresponding indication parameter of a PC equation is 26.

Optionally, the target correspondence in an embodiment of this application may include at least one correspondence in Table 15, where the target correspondence includes the first correspondence and the second correspondence.

In Table 15, an example in which a value range of k is 3 to 11 and a value range of e is 4 to 32 is used.

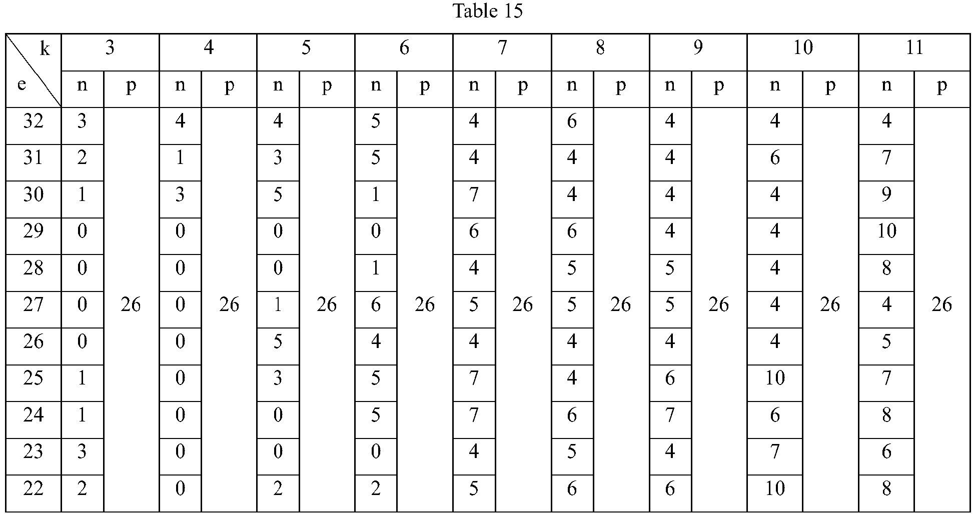

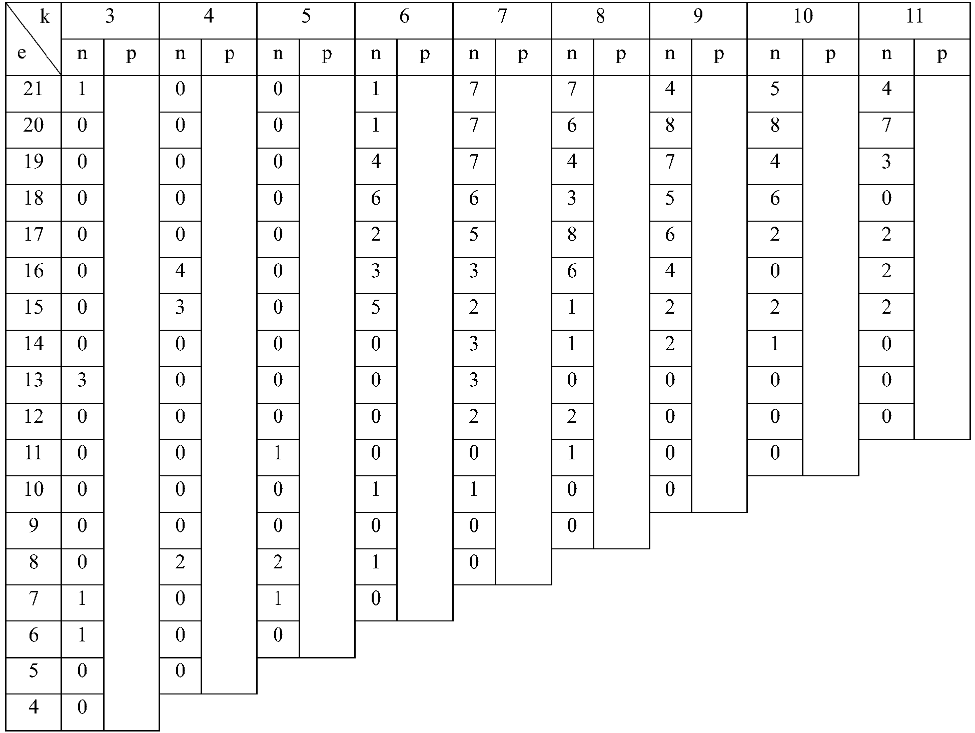

It should be noted that Table 15 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

According to the correspondence shown in Table 15, when the indication parameter p of the PC equation is the fixed value 26, a length of a shift register may be 5, a number of taps may be 3, and the used shift register may be shown in FIG. 9.

In addition, an embodiment of this application further provides a solution for the first communication apparatus to determine a position for the first parity check bit.

Optionally, after determining a set ${\overline{Q}}_{I}^{N}$, the first communication apparatus sorts bit positions in the set ${\overline{Q}}_{I}^{N}$ in descending order of reliability, and the first communication apparatus may use n positions with high reliability in the set ${\overline{Q}}_{I}^{N}$ as positions for first parity check bits.

Compared with the foregoing solution for the first communication apparatus to determine a position for the first parity check bit, this solution does not require the first communication apparatus to calculate a row weight, making the solution for determining the position for the first parity check bit simpler, reducing a calculation amount.

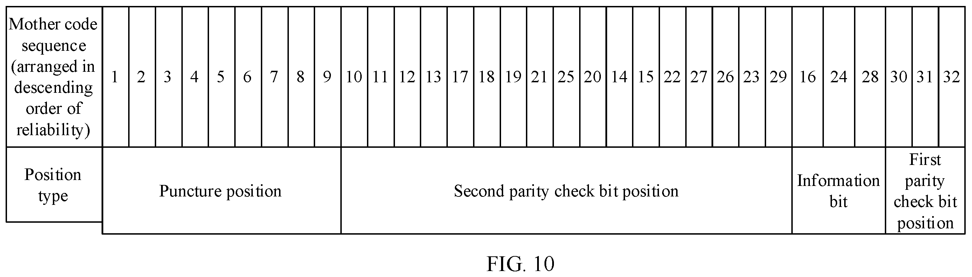

As shown in FIG. 10, a mother code sequence is arranged in descending order of reliability, and the mother code sequence includes a puncture position, an information bit position, and a parity check bit position. When a value of a transmission code length E is 23, the mother code sequence includes nine puncture positions. For example, if a value of n is 3, the last three bit positions in the mother code sequence are positions for first parity check bits.

In the solution in which the first communication apparatus may use n positions with high reliability as the positions for first parity check bits, the first correspondence and the second correspondence in an embodiment of this application may be shown in Table 16.

For example, among a plurality of correspondences shown in Table 16, each correspondence is a correspondence among one message length k, one transmission code length e, one number of first parity check bits, and one indication parameter of a PC equation. In Table 16, values determined based on a row in which a message length k is located and a column in which a transmission code length e is located are a number n of first parity check bits and an indication parameter p of a PC equation.

Optionally, the target correspondence in an embodiment of this application may include at least one correspondence in Table 16, where the target correspondence includes the first correspondence and the second correspondence.

In Table 16, an example in which a value range of k is 3 to 11 and a value range of e is 4 to 32 is used.

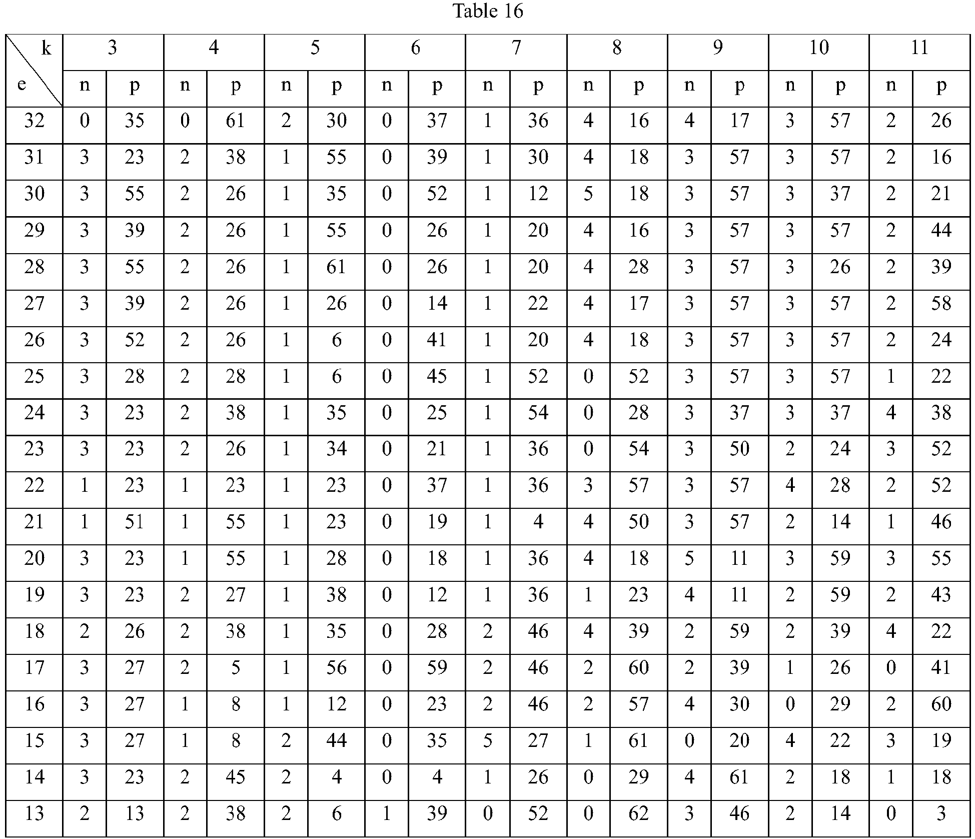

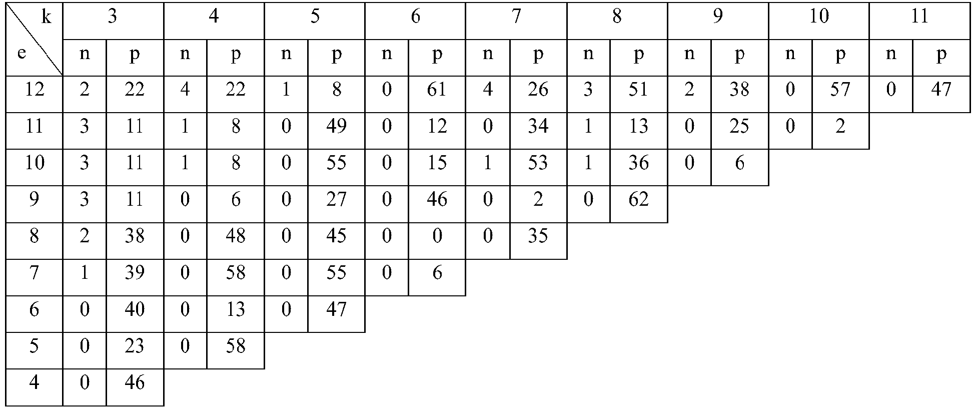

It should be noted that Table 16 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

An embodiment of this application further provides a solution for the first communication apparatus to determine a position for the first parity check bit.

Optionally, after determining a set ${\overline{Q}}_{I}^{N}$, the first communication apparatus uses n positions with the largest indexes in the set ${\overline{Q}}_{I}^{N}$ as positions for first parity check bits.

Compared with the foregoing solution for the first communication apparatus to determine a position for the first parity check bit, this solution does not require the first communication apparatus to calculate a row weight, making the solution for determining the position for the first parity check bit simpler, reducing a calculation amount. In addition, this solution does not require sorting based on reliability, and directly selects n positions with the largest indexes from the set ${\overline{Q}}_{I}^{N}$ as the positions for first parity check bits.

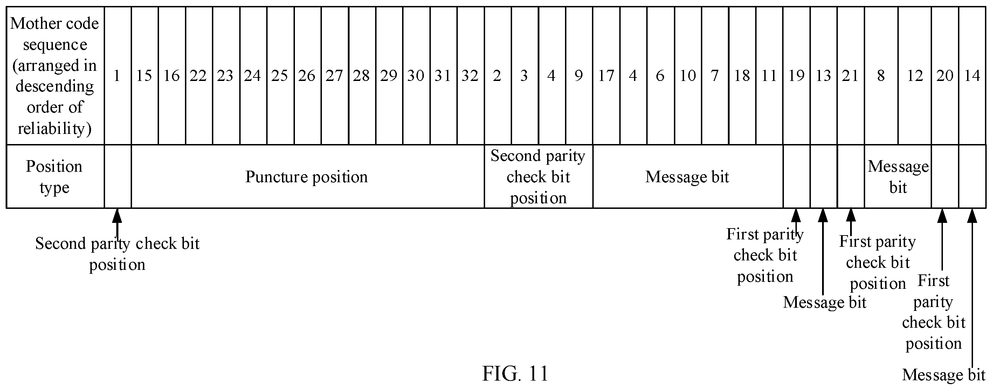

As shown in FIG. 11, a mother code sequence includes a puncture position, an information bit position, and a parity check bit position. When a value of a transmission code length E is 19, the mother code sequence includes 13 puncture positions. For example, if a value of n is 3, three positions with the largest indexes in a set ${\overline{Q}}_{I}^{N}$ (a sequence excluding the puncture positions) in the mother code sequence are used as positions for first parity check bits, for example, bit positions with indexes 19, 20, and 21 in FIG. 11.

The following uses several examples to describe the first correspondence and the second correspondence in an embodiment of this application in the solution in which the first communication apparatus uses n positions with the largest indexes in the set ${\overline{Q}}_{I}^{N}$ as the positions for first parity check bits.

The first correspondence and the second correspondence shown in Table 17:

For example, among a plurality of correspondences shown in Table 17, each correspondence is a correspondence among one message length k, one transmission code length e, one number of first parity check bits, and one indication parameter of a PC equation. In Table 17, values determined based on a row in which a message length k is located and a column in which a transmission code length e is located are a number n of first parity check bits and an indication parameter p of a PC equation.

Optionally, the target correspondence in an embodiment of this application may include at least one correspondence in Table 17, where the target correspondence includes the first correspondence and the second correspondence.

In Table 17, an example in which a value range of k is 3 to 11 and a value range of e is 4 to 32 is used.

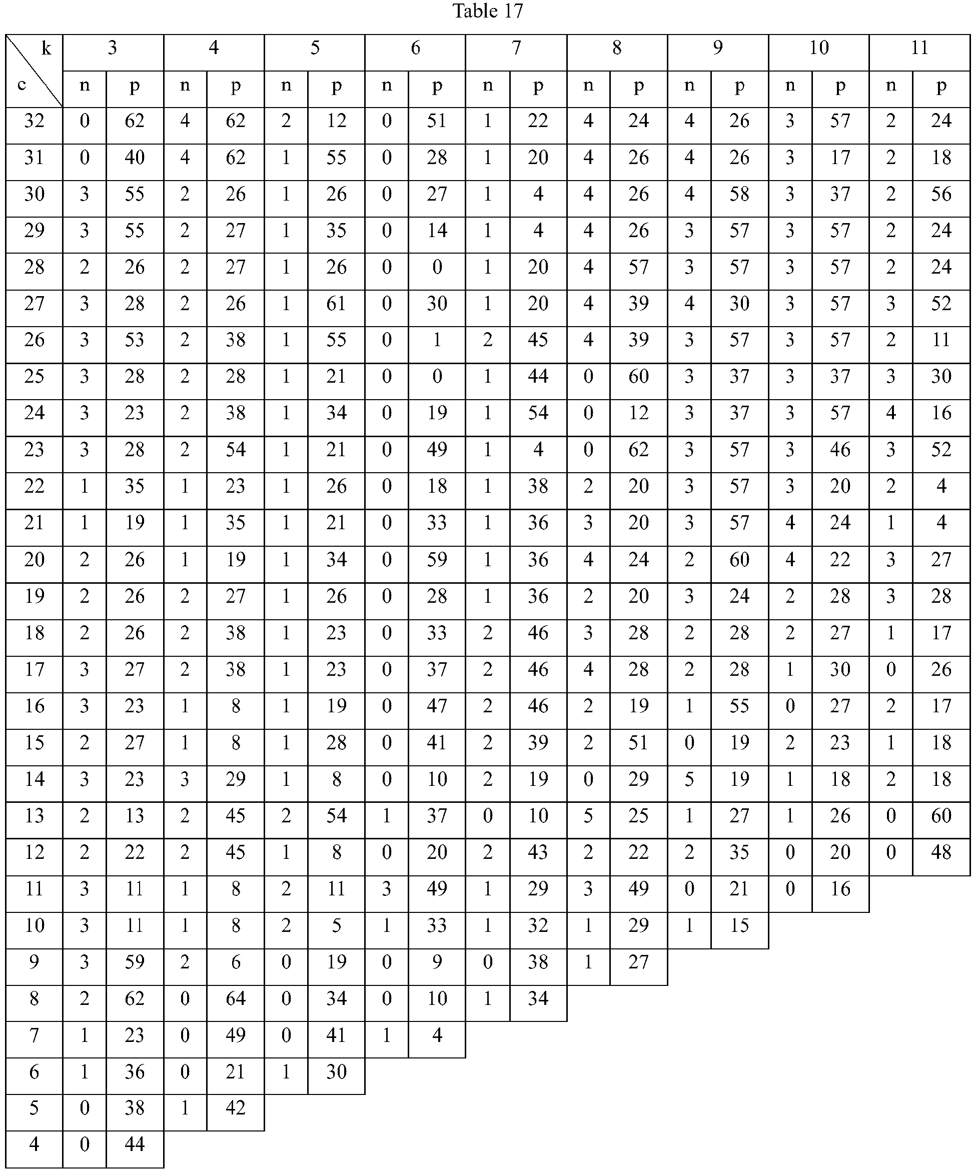

It should be noted that Table 17 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

The first correspondence and the second correspondence shown in Table 18:
For example, among a plurality of correspondences shown in Table 18, each correspondence is a correspondence among one message length k, one transmission code length e, one number of first parity check bits, and one indication parameter of a PC equation. In Table 18, values determined based on a row in which a message length k is located and a column in which a transmission code length e is located are a number n of first parity check bits and an indication parameter p of a PC equation. For example, an indication parameter p of a PC equation is a fixed value. For example, in Table 18, a value of an indication parameter p of a PC equation is 16.

Optionally, the target correspondence in an embodiment of this application may include at least one correspondence in Table 18, where the target correspondence includes the first correspondence and the second correspondence.

In Table 18, an example in which a value range of k is 3 to 11 and a value range of e is 4 to 32 is used.

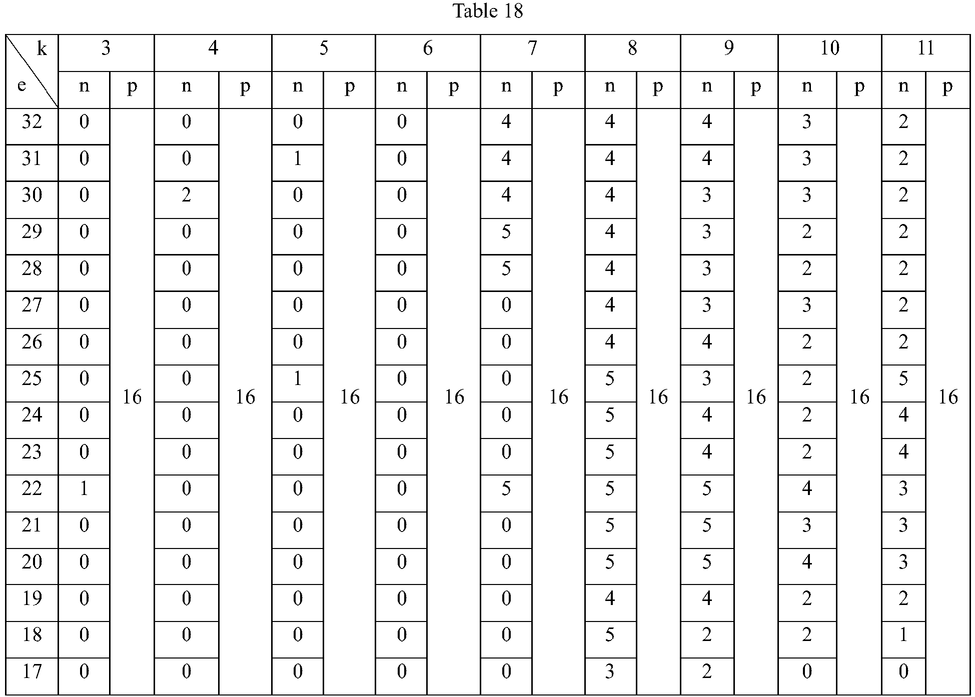

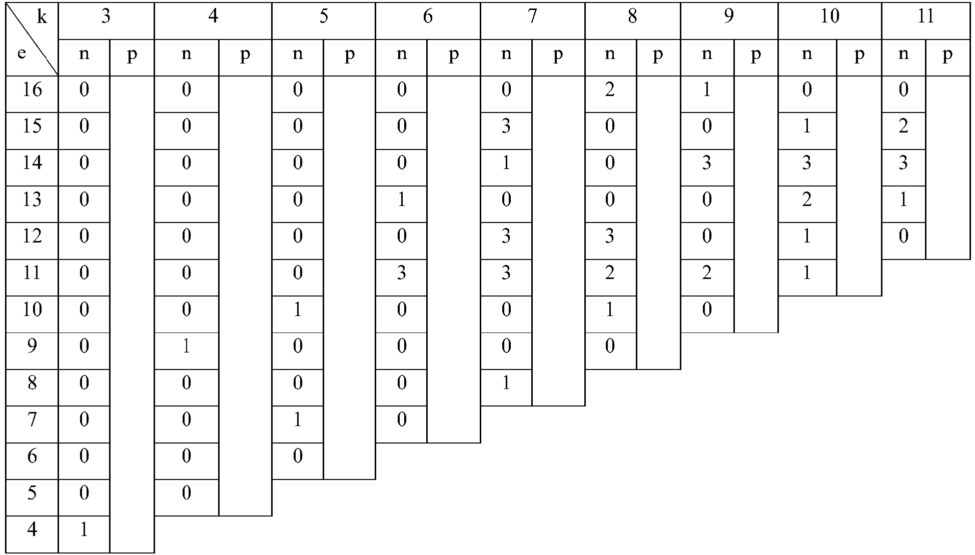

It should be noted that Table 18 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

The first correspondence and the second correspondence shown in Table 19:
For example, among a plurality of correspondences shown in Table 19, each correspondence is a correspondence among one message length k, one transmission code length e, one number of first parity check bits, and one indication parameter of a PC equation. In Table 19, values determined based on a row in which a message length k is located and a column in which a transmission code length e is located are a number n of first parity check bits and an indication parameter p of a PC equation. For example, an indication parameter p of a PC equation is a fixed value. For example, in Table 19, a value of an indication parameter p of a PC equation is 16.

Optionally, the target correspondence in an embodiment of this application may include at least one correspondence in Table 19, where the target correspondence includes the first correspondence and the second correspondence.

In Table 19, an example in which a value range of k is 3 to 11 and a value range of e is 4 to 32 is used.

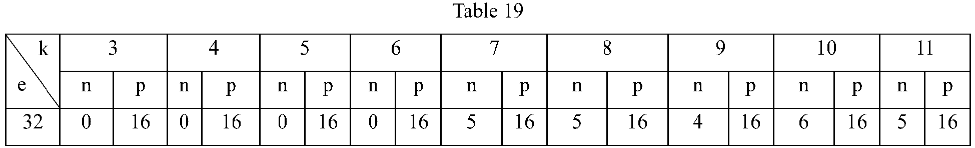

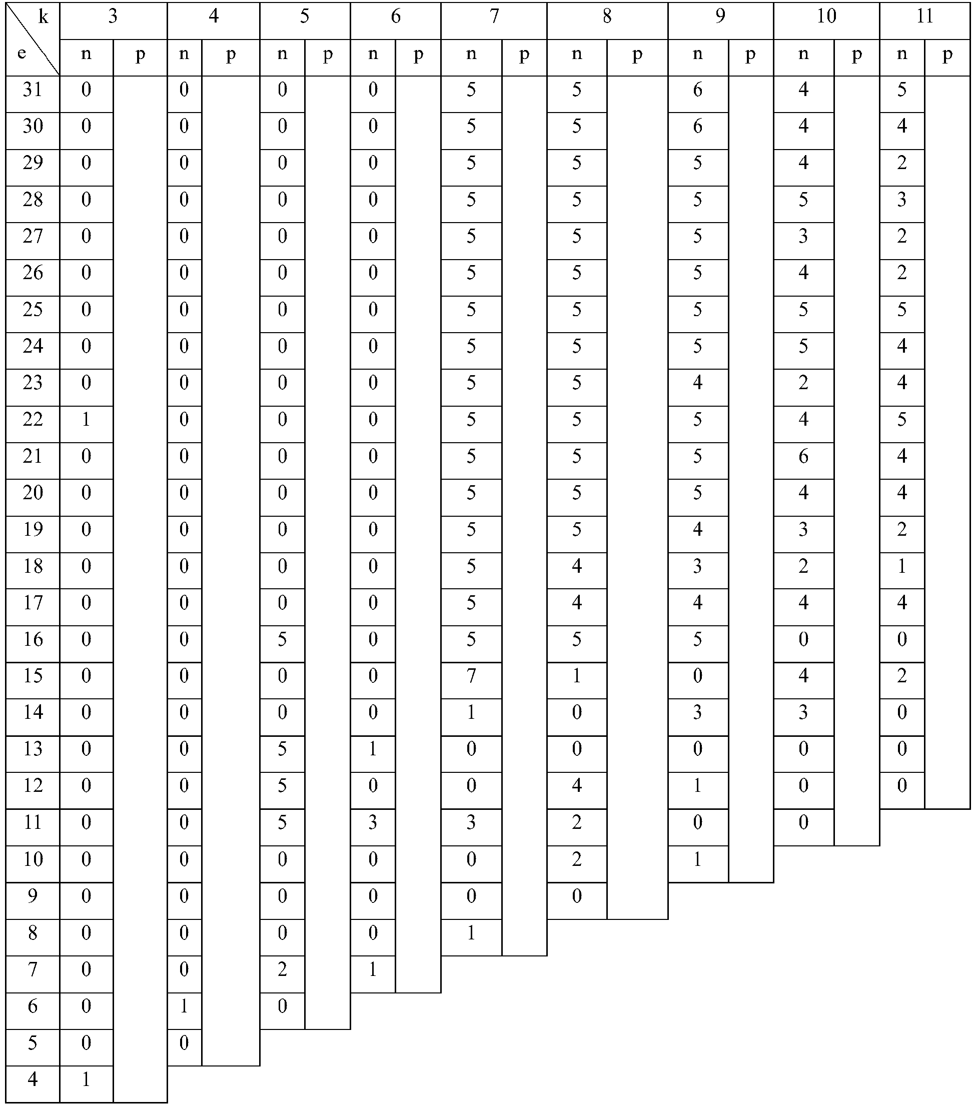

It should be noted that Table 19 is described by using an example in which the first correspondence and the second correspondence are implemented by using the target correspondence (that is, the target correspondence includes the first correspondence and the second correspondence). It may be understood that the first correspondence and the second correspondence may alternatively be implemented separately by using different correspondences. In this manner, the first correspondence and the second correspondence each correspond to a table.

It should be noted that values in tables in embodiments of this application are merely examples of embodiments of this application. In embodiments of this application, a missing part in each table above indicates that no correspondence exists at the corresponding position. For example, in each table above, a corresponding position where k is 5 and e is 4 has no value, indicating that there is no correspondence in which k is 5 and e is 4.

Compared with the PC-polar encoding scheme with the nested PC equation and the LTE-RM code and FHT decoding scheme, the solution provided in embodiments of this application significantly improves transmission performance, for example, provides bit error rates in different transmission code lengths that are lower than those in the PC-polar encoding scheme with the nested PC equation and in the LTE-RM code and FHT decoding scheme.

It may be understood that each device in the foregoing embodiments may perform some or all of the steps in each embodiment. These steps or operations are merely examples. Other operations or variations of various operations may be further performed in embodiments of this application. In addition, the steps may be performed in a sequence different from a sequence shown in embodiments, and not all of operations in embodiments of this application need to be performed. In addition, sequence numbers of the steps do not mean an execution sequence. An execution sequence of the processes should be determined based on functions and internal logic of the processes, and should not constitute any limitation on the implementation processes of embodiments of this application.

The following describes a communication apparatus provided in embodiments of this application.

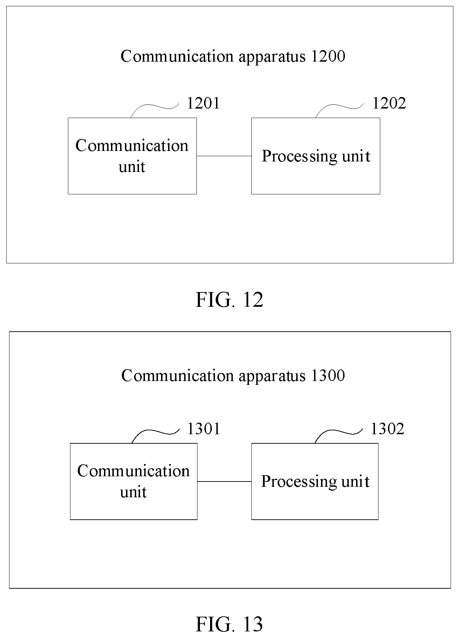

FIG. 12 is a diagram of a structure of a communication apparatus according to an embodiment of this application. As shown in FIG. 12, the communication apparatus may be configured to perform a process performed by the first communication apparatus in any one of the embodiments shown in FIG. 3 and FIG. 4. For details, refer to related descriptions in the foregoing method embodiments.

The communication apparatus 1200 includes a communication unit 1201 and a processing unit 1202.

The processing unit 1202 is configured to perform data processing. The communication unit 1201 may implement a corresponding communication function. The communication unit 1201 may also be referred to as a communication interface, a communication module, a transceiver unit, or a transceiver module.

Optionally, the communication apparatus 1200 may further include a storage unit. The storage unit may be configured to store instructions and/or data. The processing unit 1202 may read the instructions and/or data in the storage unit, for the communication apparatus to implement the foregoing method embodiments.

The communication apparatus 1200 may be configured to perform an action performed by the first communication apparatus in the foregoing method embodiments. The communication apparatus 1200 may be the first communication apparatus or a component (for example, a chip) that can be configured in the first communication apparatus. The processing unit 1202 is configured to perform a processing-related operation of the first communication apparatus in the foregoing method embodiments. The communication unit 1201 is configured to perform a receiving-related operation of the first communication apparatus in the foregoing method embodiments.

Optionally, the communication unit 1201 may include a sending unit and a receiving unit. The sending unit is configured to perform a sending operation in the foregoing method embodiments. The receiving unit is configured to perform a receiving operation in the foregoing method embodiments.

It should be noted that the communication unit 1201 may include a sending unit, but does not include a receiving unit. Alternatively, the communication apparatus 1200 may include a receiving unit, but does not include a sending unit. This may be specifically determined depending on whether the foregoing solutions performed by the communication apparatus 1200 include sending actions and receiving actions.

Optionally, the communication apparatus 1200 is configured to perform an action performed by the first communication apparatus in any one of the embodiments shown in FIG. 3 and FIG. 4.

FIG. 13 is a diagram of a structure of a communication apparatus according to an embodiment of this application. As shown in FIG. 13, the communication apparatus may be configured to perform a process performed by the second communication apparatus in any one of the embodiments shown in FIG. 5. For details, refer to related descriptions in the foregoing method embodiments.

The communication apparatus 1300 includes a communication unit 1301 and a processing unit 1302.

The processing unit 1302 is configured to perform data processing. The communication unit 1301 may implement a corresponding communication function. The communication unit 1301 may also be referred to as a communication interface, a communication module, a transceiver unit, or a transceiver module.

Optionally, the communication apparatus 1300 may further include a storage unit. The storage unit may be configured to store instructions and/or data. The processing unit 1302 may read the instructions and/or data in the storage unit, for the communication apparatus to implement the foregoing method embodiments.

The communication apparatus 1300 may be configured to perform an action performed by the second communication apparatus in the foregoing method embodiments. The communication apparatus 1300 may be the second communication apparatus or a component (for example, a chip) that can be configured in the second communication apparatus. The processing unit 1302 is configured to perform a processing-related operation of the second communication apparatus in the foregoing method embodiments. The communication unit 1301 is configured to perform a receiving-related operation of the second communication apparatus in the foregoing method embodiments.

Optionally, the communication unit 1301 may include a sending unit and a receiving unit. The sending unit is configured to perform a sending operation in the foregoing method embodiments. The receiving unit is configured to perform a receiving operation in the foregoing method embodiments.

It should be noted that the communication unit 1301 may include a sending unit, but does not include a receiving unit. Alternatively, the communication apparatus 1300 may include a receiving unit, but does not include a sending unit. This may be specifically determined depending on whether the foregoing solutions performed by the communication apparatus 1300 include sending actions and receiving actions.

Optionally, the communication apparatus 1300 is configured to perform an action performed by the second communication apparatus in any one of the embodiments shown in FIG. 5.

Division into the modules in embodiments of this application is an example, is merely logical function division. During actual implementation, another division manner may be used. In addition, functional modules in embodiments of this application may be integrated into one processor, or each of the modules may exist alone physically, or two or more modules may be integrated into one module. The integrated module may be implemented in a form of hardware, or may be implemented in a form of a software functional module. It may be understood that, for functions or implementations of the modules in embodiments of this application, further refer to related descriptions in the method embodiments.

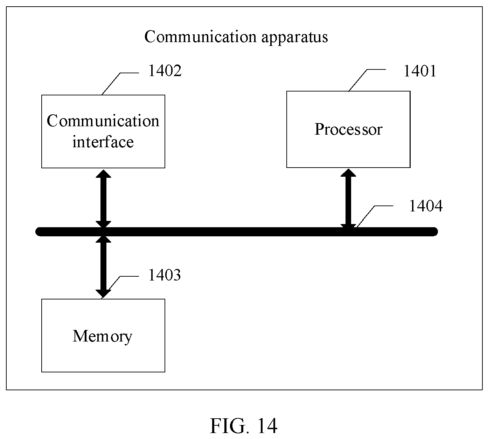

In a possible manner, the communication apparatus may be shown in FIG. 14. The apparatus may be a communication apparatus or a chip in the communication apparatus. The communication apparatus may be the first communication apparatus in the foregoing embodiments, or may be the second communication apparatus in the foregoing embodiments. The apparatus includes a processor 1401 and a communication interface 1402, and may further include a memory 1403. The processing unit 1202 and the processing unit 1302 may be the processor 1401. The communication unit 1201 and the communication unit 1301 may be the communication interface 1402. Optionally, the processor 1401 and the memory 1403 may be integrated together.

The processor 1401 may be a CPU, a digital processing unit, or the like. The communication interface 1402 may be a transceiver, an interface circuit such as a transceiver circuit, a transceiver chip, or the like. The apparatus further includes the memory 1403 configured to store a program executed by the processor 1401. The memory 1403 may be a nonvolatile memory such as a hard disk drive (hard disk drive, HDD) or a solid-state drive (solid-state drive, SSD), or may be a volatile memory (volatile memory) such as a random access memory (random access memory, RAM). The memory 1403 is any other medium that can carry or store expected program code in a form of an instruction or data structure and that can be accessed by a computer, but is not limited thereto.

The processor 1401 is configured to execute the program code stored in the memory 1403, and is specifically configured to perform an action of the processing unit 1202 or the processing unit 1302. Details are not described in this application again. The communication interface 1402 is specifically configured to perform an action of the communication unit 1201 or the communication unit 1301. Details are not described in this application again.

A specific connection medium among the communication interface 1402, the processor 1401, and the memory 1403 is not limited in embodiments of this application. In an embodiment of this application, in FIG. 14, the memory 1403, the processor 1401, and the communication interface 1402 are connected by a bus 1404. The bus is represented by a bold line in FIG. 14. A connection manner between other components is merely an example for description, and does not constitute a limitation. The bus may be classified into an address bus, a data bus, a control bus, and the like. For ease of representation, only one bold line is used to represent the bus in FIG. 14, but this does not mean that there is only one bus or only one type of bus.

An embodiment of the present invention further provides a computer-readable storage medium configured to store computer software instructions that need to be executed for execution of the foregoing processor, and the computer software instructions include a program that needs to be executed for execution of the foregoing processor.

An embodiment of this application further provides a communication system, including the first communication apparatus configured to implement the embodiments in FIG. 3 or FIG. 4 and the second communication apparatus configured to implement the embodiments in FIG. 5.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a magnetic disk storage, a CD-ROM, and an optical memory) that include computer-usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of another programmable data processing device to generate a machine, so that the instructions executed by a computer or a processor of another programmable data processing device generate an apparatus for implementing a specific function in one or more processes in the flowcharts and/or in one or more blocks in the block diagrams.

These computer program instructions may be stored in a computer-readable memory that can instruct the computer or another programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

These computer program instructions may alternatively be loaded onto the computer or another programmable data processing device, so that a series of operations and steps are performed on the computer or another programmable device, to generate computer-implemented processing. Therefore, the instructions executed on the computer or another programmable device provide steps for implementing a specific function in one or more processes in the flowcharts and/or in one or more blocks in the block diagrams.

It is clear that a person skilled in the art can make various modifications and variations to this application without departing from the scope of this application. This application is intended to cover these modifications and variations of this application provided that they fall within the scope of the claims of this application and their equivalent technologies.

## Claims

1. An encoding method, wherein the method comprises:
obtaining a first sequence, wherein the first sequence is a to-be-encoded bit sequence, and a length of the first sequence is K;
determining, based on K, a mother code sequence corresponding to the first sequence; and
performing polar encoding on a parity check bit and the first sequence based on the mother code sequence, wherein the parity check bit comprises a first parity check bit and a second parity check bit; and
the parity check bit is determined in the following manner:
determining, based on a first correspondence, a number ${n}_{PC}^{wm}$ of first parity check bits corresponding to the first sequence, wherein the first correspondence comprises a correspondence between K and the number of first parity check bits;
determining, based on reliability and a row weight, ( $K + {n}_{PC}^{wm}$) positions in the mother code sequence for placing the first sequence and the first parity check bits;
determining a position for the second parity check bit in the mother code sequence; and
determining the parity check bit based on the ( $K + {n}_{PC}^{wm}$) positions, the position for the second parity check bit, a target parity check PC equation, and the first sequence.

2. A decoding method, wherein the method comprises:
obtaining a second sequence and a length K of a first sequence;
determining, based on K, a mother code sequence corresponding to the first sequence;
determining, based on a first correspondence, a number ${n}_{PC}^{wm}$ of first parity check bits corresponding to the first sequence, wherein the first correspondence comprises a correspondence between K and the first parity check bit;
determining ( $K + {n}_{PC}^{wm}$) positions in the mother code sequence based on reliability and a row weight, wherein the ( $K + {n}_{PC}^{wm}$) positions are for placing the first sequence and the first parity check bits;
determining a position for a second parity check bit in the mother code sequence; and
decoding the second sequence based on the ( $K + {n}_{PC}^{wm}$) positions, the position for the second parity check bit, and a target parity check PC equation, to obtain an information bit in the first sequence.

3. The method according to claim 1 or 2, wherein the method further comprises:
determining the target PC equation based on a second correspondence, wherein the second correspondence comprises a correspondence between K and an indication parameter of the target PC equation.

4. The method according to claim 3, wherein the first correspondence further comprises a correspondence between a target transmission code length E and the first parity check bit, and E is a transmission code length after rate matching of an encoded sequence; and
the second correspondence further comprises a correspondence between E and the indication parameter of the target PC equation.

5. The method according to claim 4, wherein the number of first parity check bits corresponding to K and E is less than or equal to E-K, and/or a number of effective parity check bits corresponding to K and E is less than or equal to a specified threshold.

6. The method according to claim 4 or 5, wherein the first correspondence comprises a correspondence among a plurality of message lengths, a plurality of transmission code lengths, and a number of first parity check bits, the plurality of message lengths comprise K, and the plurality of transmission code lengths comprise E.

7. The method according to claim 6, wherein the second correspondence comprises a correspondence among a plurality of message lengths, a plurality of transmission code lengths, and an indication parameter of a PC equation, the plurality of message lengths comprise K, and the plurality of transmission code lengths comprise E.

8. The method according to claim 6, wherein in the first correspondence, for a message length within a first length range, same message lengths correspond to a same number of first parity check bits; and
in the second correspondence, for a message length within a first length range, same message lengths correspond to a same indication parameter of a PC equation.

9. The method according to claim 8, wherein in the first correspondence, different message lengths within the first length range correspond to different numbers of first parity check bits; and/or
in the second correspondence, different message lengths within the first length range correspond to different indication parameters of PC equations.

10. The method according to claim 8, wherein in the first correspondence, all message lengths within the first length range correspond to a same number of first parity check bits; and
in the second correspondence, all message lengths within the first length range correspond to a same indication parameter of a PC equation.

11. The method according to any one of claims 6 or 8 to 10, wherein in the first correspondence, for a message length within a second length range, when message lengths are the same and transmission code lengths are within different code length ranges, corresponding numbers of first parity check bits are different; and/or
in the second correspondence, for a message length within a second length range, when message lengths are the same and transmission code lengths are within different code length ranges, corresponding indication parameters of PC equations are different.

12. The method according to any one of claims 6 or 8 to 11, wherein in the first correspondence, for a message length within a second length range, when message lengths are the same and transmission code lengths are within a same code length range, corresponding numbers of first parity check bits are the same; and
in the second correspondence, for a message length within a second length range, when message lengths are the same and transmission code lengths are within a same code length range, corresponding indication parameters of PC equations are the same.

13. The method according to any one of claims 8 to 10, wherein a first threshold value of the first length range is 3, and a second threshold value of the first length range is 6.

14. The method according to claim 11 or 12, wherein a first threshold value of the second length range is 7, and a second threshold value of the first length range is 11.

15. The method according to claim 5, wherein the method further comprises:
determining, based on K, E, and a third correspondence, the specified threshold corresponding to the number of effective parity check bits, wherein the third correspondence comprises a correspondence among K, E, and the specified threshold corresponding to the number of effective parity check bits.

16. The method according to claim 7, wherein the first correspondence comprises at least one correspondence in the following table, and each correspondence is a correspondence among one k, one e, and one indication parameter of a PC equation, 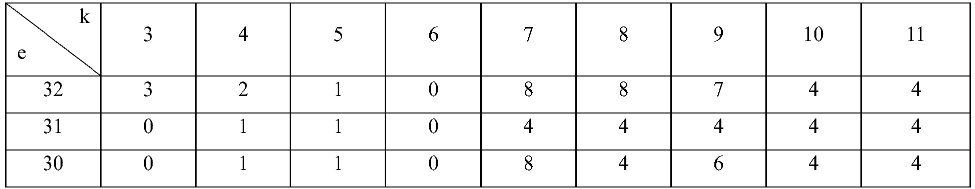 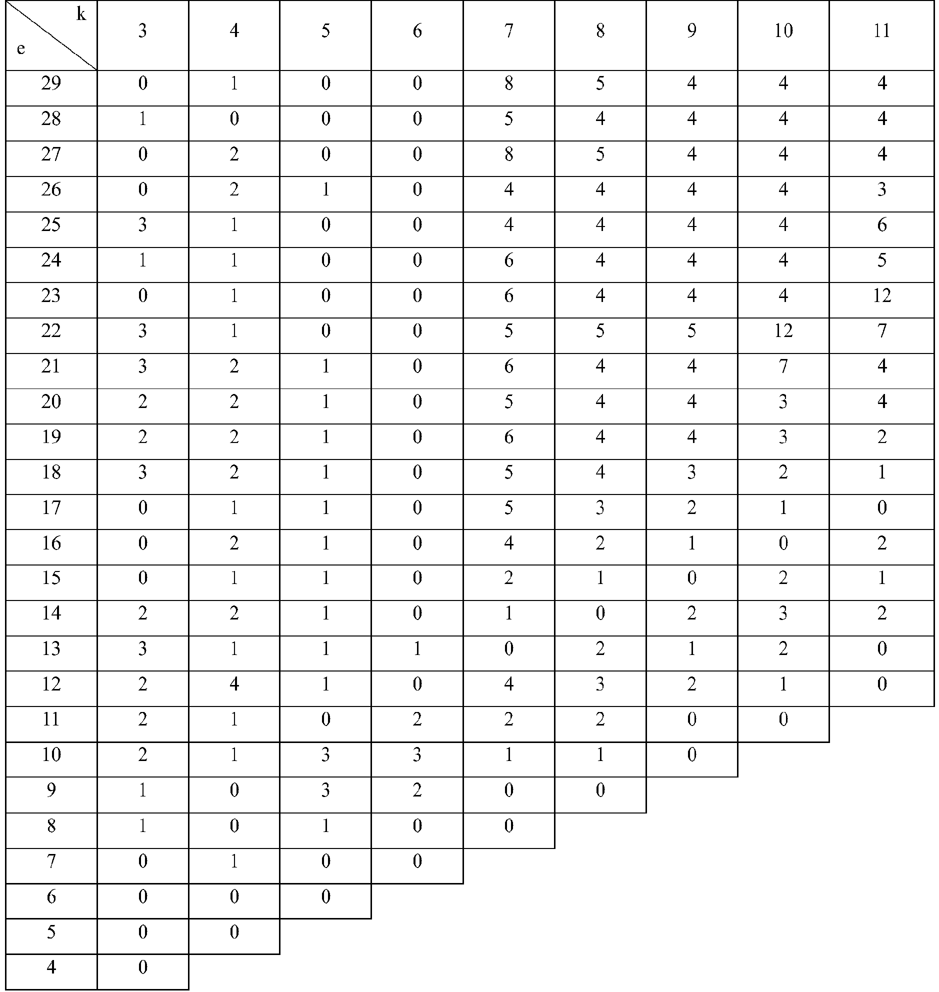 wherein k represents a message length, and e represents a transmission code length.

17. The method according to claim 7 or 16, wherein the second correspondence comprises at least one correspondence in the following table, and each correspondence is a correspondence among one k, one e, and one indication parameter of a PC equation, 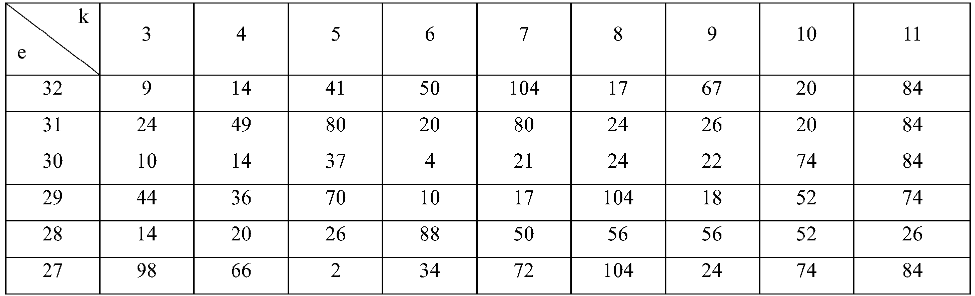 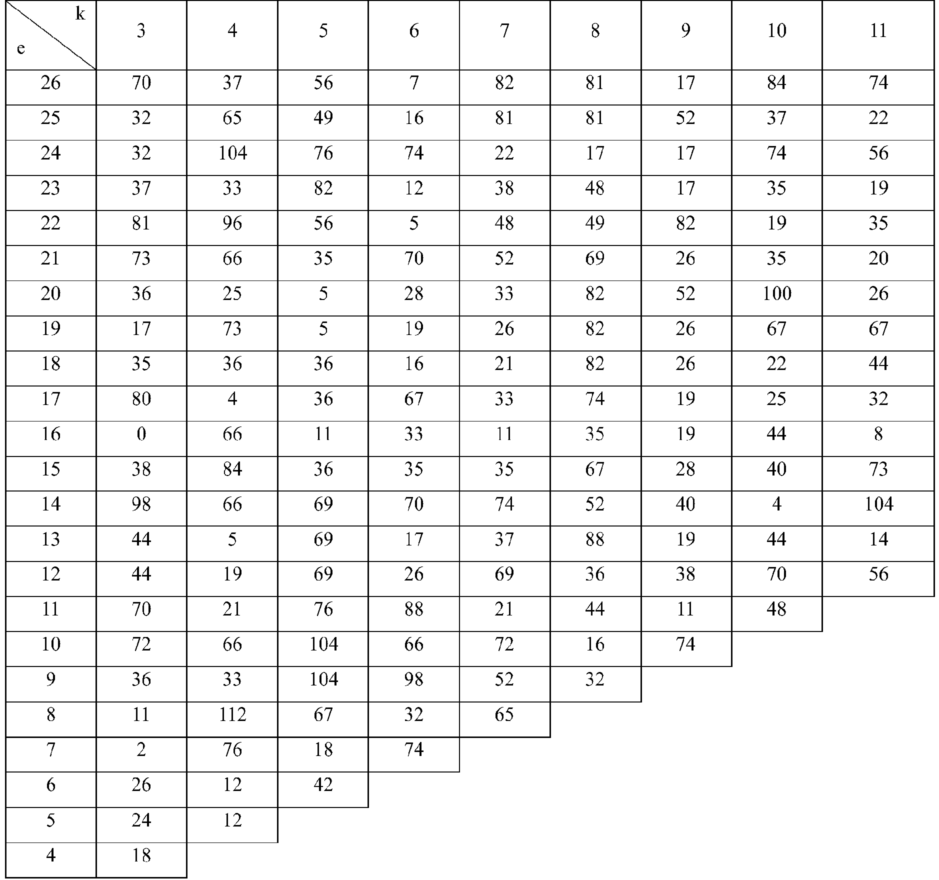 wherein k represents the message length, and e represents the transmission code length.

18. The method according to claim 7, wherein the first correspondence comprises at least one correspondence in the following table, and each correspondence is a correspondence among one k, one e, and one number of first parity check bits, 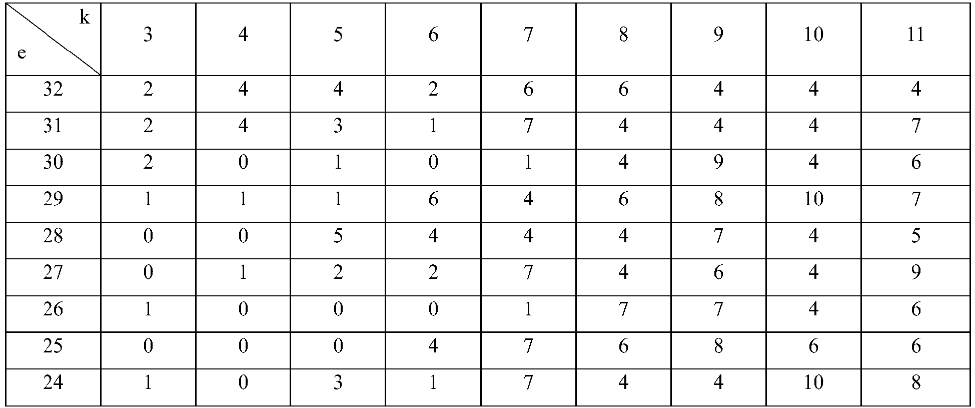 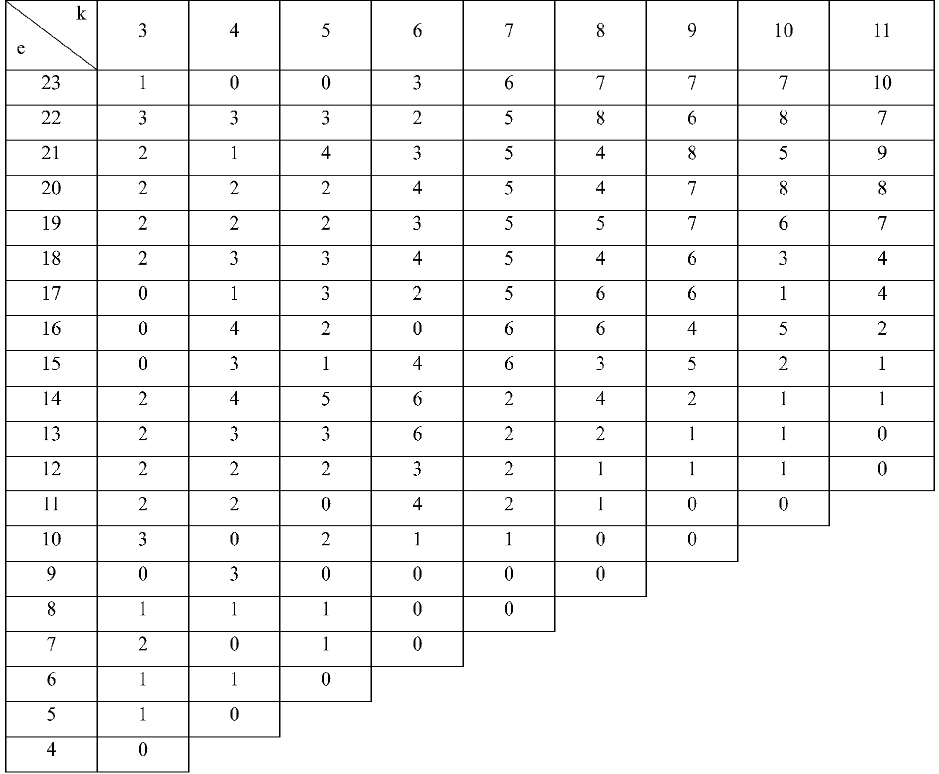 wherein k represents a message length, and e represents a transmission code length.

19. The method according to claim 7 or 18, wherein the second correspondence comprises at least one correspondence in the following table, and each correspondence is a correspondence among one k, one e, and one indication parameter of a PC equation, 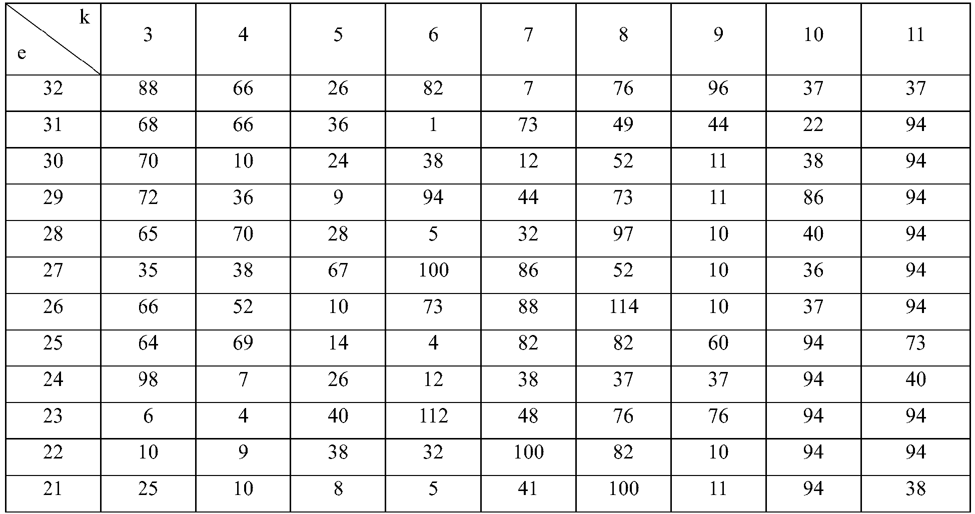 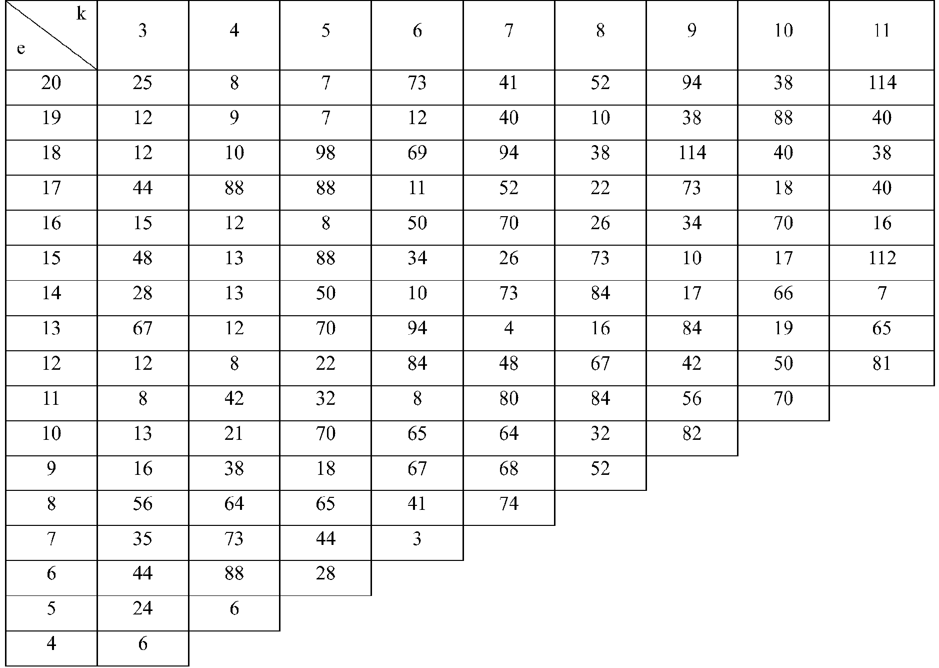 wherein k represents the message length, and e represents the transmission code length.

20. The method according to claim 15, wherein the third correspondence comprises at least one correspondence in the following table, and each correspondence is a correspondence among one k, one e, and one specified threshold corresponding to a number of effective parity check bits, 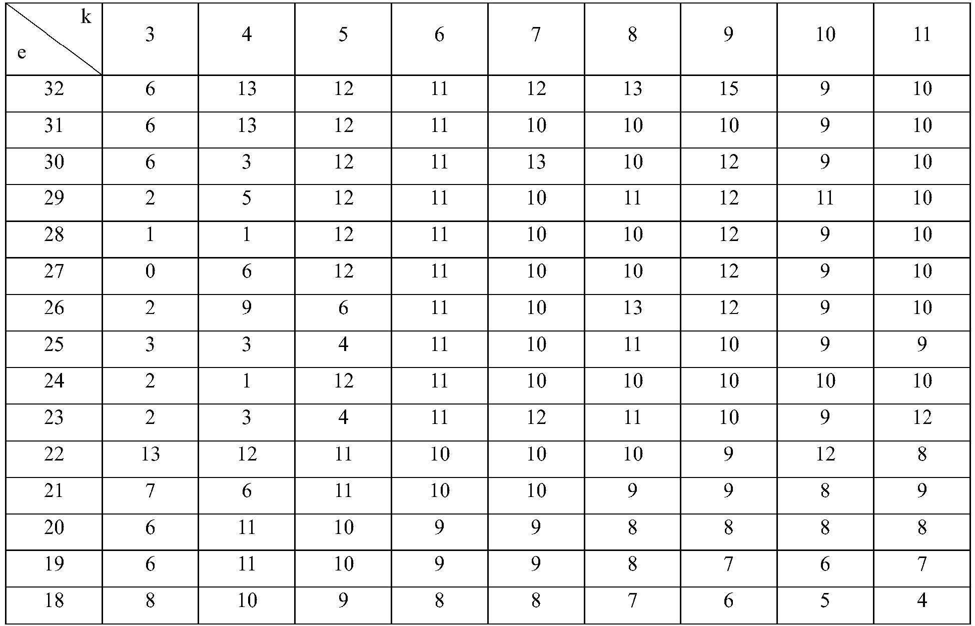 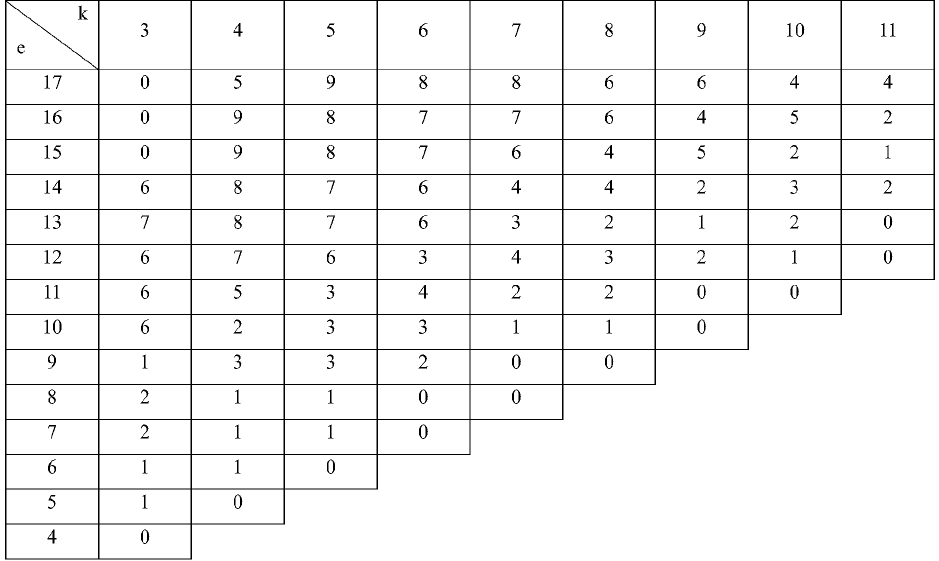 wherein k represents a message length, and e represents a transmission code length.

21. The method according to claim 15, wherein the third correspondence comprises at least one correspondence in the following table, and each correspondence is a correspondence among one k, one e, and one specified threshold corresponding to a number of effective parity check bits, 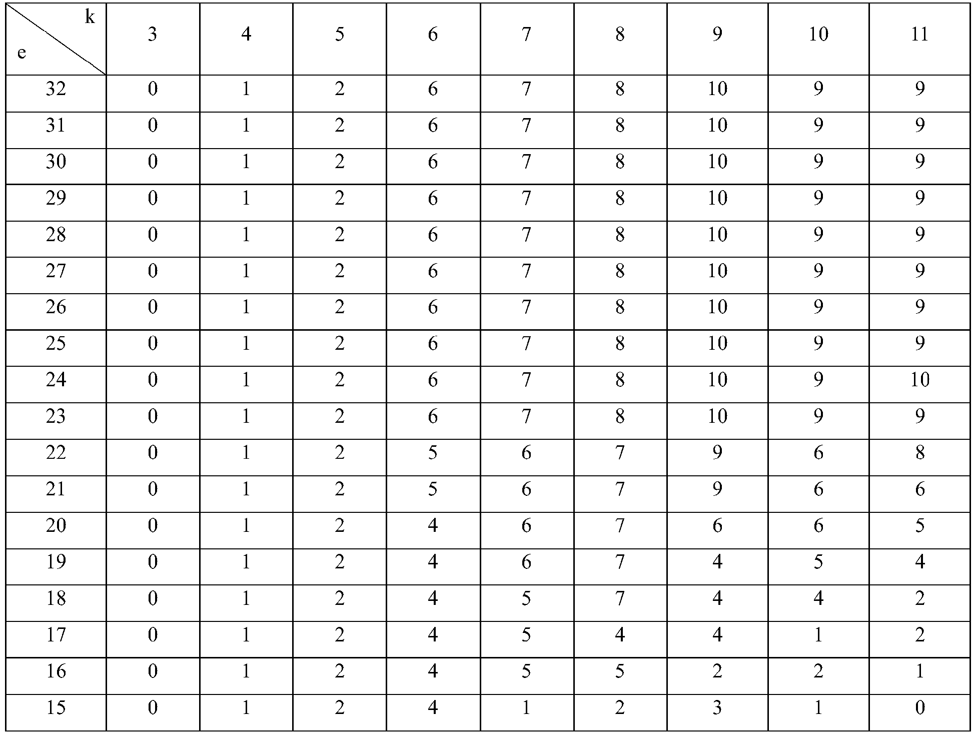 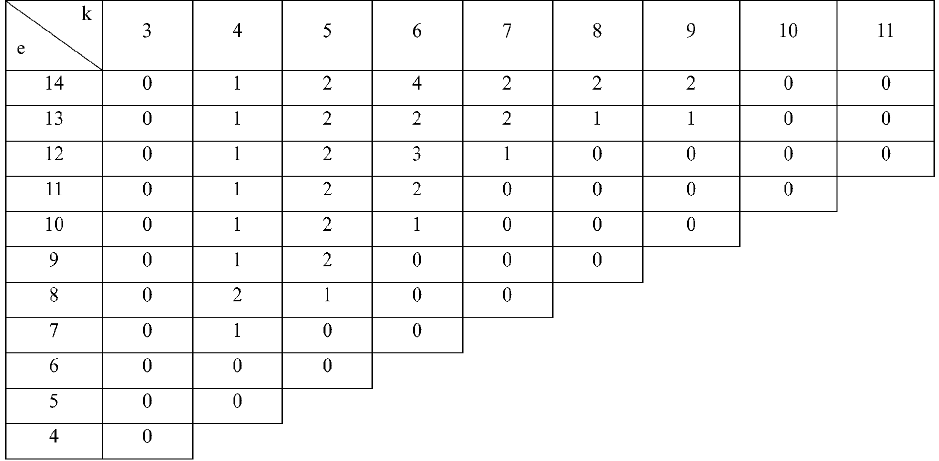 wherein k represents a message length, and e represents a transmission code length.

22. A communication apparatus, comprising a communication unit and a processing unit, wherein
the communication unit is configured to perform sending and receiving operations in the method according to any one of claims 1 or 3 to 21, and the processing unit is configured to perform a processing operation in the method according to any one of claims 1 or 3 to 21.

23. A communication apparatus, wherein the communication apparatus comprises a processor, and the processor is configured to execute a computer program or instructions stored in a memory, to implement the method according to any one of claims 1 or 3 to 21.

24. The communication apparatus according to claim 23, wherein the communication apparatus further comprises the memory configured to store the computer program or instructions.

25. A communication apparatus, comprising a communication unit and a processing unit, wherein
the communication unit is configured to perform sending and receiving operations in the method according to any one of claims 2 to 21, and the processing unit is configured to perform a processing operation in the method according to any one of claims 2 to 21.

26. A communication apparatus, wherein the communication apparatus comprises a processor, and the processor is configured to execute a computer program or instructions stored in a memory, to implement the method according to any one of claims 2 to 21.

27. The communication apparatus according to claim 26, wherein the communication apparatus further comprises the memory configured to store the computer program or instructions.

28. A communication system, comprising the communication apparatus according to any one of claims 22 to 24 and the communication apparatus according to any one of claims 25 to 27.

29. A computer-readable storage medium, storing a computer program or instructions, wherein when the computer program or instructions are run on a computer, the computer-readable storage medium is enabled to implement the method according to any one of claims 1 to 21.

30. A chip system, comprising a processor, wherein the processor is configured to perform the method according to any one of claims 1 to 21.
